(19) Europäisches Patentamt
European Patent Office
Office européen des brevets

(11) **EP 2 504 798 B1**

(12) **FASCICULE DE BREVET EUROPEEN**

(45) Date de publication et mention
de la délivrance du brevet:
**07.01.2015 Bulletin 2015/02**

(21) Numéro de dépôt: **10798622.6**

(22) Date de dépôt: **25.11.2010**

(51) Int Cl.:
***G06Q 10/00*** *(2012.01)*

(86) Numéro de dépôt international:
**PCT/IB2010/055410**

(87) Numéro de publication internationale:
**WO 2011/064730 (03.06.2011 Gazette 2011/22)**

(54) **METHODE DE MESURE DES EMISSIONS HEBDOMADAIRES ET ANNUELLES D'UN GAZ A EFFET DE SERRE SUR UNE SURFACE DONNEE**

VERFAHREN ZUR WÖCHENTLICHEN UND JÄHRLICHEN MESSUNG VON TREIBHAUSGASEMISSIONEN ÜBER EINEN BESTIMMTEN FLÄCHENBEREICH

METHOD FOR MEASURING WEEKLY AND ANNUAL EMISSIONS OF A GREENHOUSE GAS OVER A GIVEN SURFACE AREA

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.11.2009 FR 0958385**

(43) Date de publication de la demande:
**03.10.2012 Bulletin 2012/40**

(73) Titulaire: **Griffon, Tanguy**
**1201 Genève (CH)**

(72) Inventeur: **Griffon, Tanguy**
**1201 Genève (CH)**

(74) Mandataire: **Bugnion Genève**
**Bugnion S.A.**
**Conseils en Propriété Industrielle**
**Route de Florissant 10**
**Case Postale 375**
**1211 Genève 12 (CH)**

(56) Documents cités:
**US-A1- 2008 021 675**

• PETERS W ET AL: "An atmospheric perspective on North American carbon dioxide exchange: CarbonTracker", PROCEEDINGS OF THE NATIONAL ACADEMY OF SCIENCES OF THE UNITED STATES OF AMERICA NATIONAL ACADEMY OF SCIENCES USA, vol. 104, no. 48, 27 novembre 2007 (2007-11-27), pages 18925-18930, XP002592548, ISSN: 0027-8424 -& "SI Appendix S1 Flux Module Descriptions", INTERNET CITATION, 27 novembre 2007 (2007-11-27), pages 1-19, XP007914116, Extrait de l'Internet: URL:http://www.pnas.org/content/suppl/2007 /11/28/104.48.18925.DC1/08986SuppAppendix. pdf [extrait le 2010-07-26]
• PETERS W ET AL: "Seven years of recent European net terrestrial carbon dioxide exchange constrained by atmospheric observations", GLOBAL CHANGE BIOLOGY, WILEY-BLACKWELL LNKD- DOI:10.1111/J. 1365-2486.2009.02078.X, vol. 16, 29 octobre 2009 (2009-10-29), pages 1317-1337, XP007914510, ISSN: 1354-1013 [extrait le 2009-10-29]
• JENSEN ET AL: "Environmental sub models for a macroeconomic model: Agricultural contribution to climate change and acidification in Denmark", JOURNAL OF ENVIRONMENTAL MANAGEMENT, ACADEMIC PRESS, LONDON, GB, vol. 82, no. 1, 1 November 2006 (2006-11-01), pages 133-143, XP005731966, ISSN: 0301-4797, DOI: 10.1016/J.JENVMAN.2005.12.017

**Description**

Domaine technique

L'invention concerne le domaine des méthodes de mesure des émissions de gaz à effet de serre (GES). L'invention porte en particulier sur une méthode de mesure des émissions hebdomadaires et annuelles d'un gaz à effet de serre sur une aire géographique donnée. Elle concerne encore un système de mesure permettant la mise en oeuvre de la méthode de mesure.

Art antérieur

Les GES sont les gaz de l'atmosphère naturels et anthropiques, qui absorbent et émettent des rayonnements à des longueurs d'onde du spectre de rayonnement infrarouge thermique. Ce sont principalement le dioxyde de carbone $CO_2$, le méthane $CH_4$, le protoxyde d'azote N20, Les oxydes d'azote NOx, les hydrofluorocarbures HFC, les hydrochlorofluorocarbures HCFC, les chlorofluorocarbures CFC, les perfluorocarbures PFC, l'hexafluorure de soufre SF6, l'ozone troposphérique 03, la vapeur d'eau $H_2O$, le monoxyde de carbone CO et le dihydrogène H2. Le $CO_2$ est généralement le gaz de référence. Lorsqu'ils absorbent le rayonnement infrarouge thermique émis par la surface de la terre, par l'atmosphère et les nuages, le rayonnement atmosphérique est émis de tous les côtés, jusqu'à la surface de la terre. Les GES diffèrent dans leur forçage radiatif sur le système climatique en raison de leurs différentes propriétés radiatives et de leur durée de vie dans l'atmosphère. Ils retiennent la chaleur au sein de la surface-troposphère, ce qui est communément appelé « effet de serre » et une augmentation de leur concentration peut engendrer un renforcement de cet effet avec un réchauffement.

Les sources naturelles de $CO_2$ sont beaucoup plus importantes que les sources anthropiques, mais sur de longues périodes de temps, les sources naturelles sont équilibrées par les puits naturels. La concentration atmosphérique de $CO_2$ est restée entre 260 et 280 parties par million (ppm) dans l'atmosphère depuis l'holocène, c'est-à-dire les derniers 10'000 ans interglaciaires, mais, depuis l'ère industrielle, l'activité humaine a augmenté sa concentration de l'ordre de 100ppm. La communauté scientifique a récemment reconnu que l'effet de serre issu des GES anthropiques a produit un forçage positif sur la température de la surface d'environ 1°C supérieur à la moyenne depuis le milieu du 20e siècle. Il est donc probable que le réchauffement anthropique dû à une élévation des niveaux de GES ait influencé les systèmes physiques et biologiques naturels. Les changements attendus sur les facteurs climatiques sont notamment d'impacter les ressources en eau douce, l'industrie, l'alimentation et la santé. La stabilisation des concentrations à un niveau qui empêcherait toute perturbation anthropique dangereuse du système climatique est donc devenue une priorité pour la communauté internationale.

Le $CO_2$ est la forme de carbone la plus répandue dans l'atmosphère, et la principale source de carbone dans les matières organiques. Il est issu des échanges entre l'atmosphère et la biosphère, l'atmosphère et les océans, les perturbations de la biosphère et la production anthropique. Le déséquilibre entre l'absorption et le dégagement conduit à une augmentation nette dans l'atmosphère.

Dans la méthode d'évaluation appelée « CarbonTracker », telle que décrite dans Peters et al., "An atmospheric perspective on North American carbon dioxide exchange: CarbonTracker", Proceedings of the National Academy of Sciences of the United States of America, vol. 104(48) (2007) 18925-18930, la loi de conservation de masse est utilisée pour évaluer le flux atmosphérique $F_{CO2}(t)$ en assumant que la masse de carbone dans l'atmosphère est égale à l'effet net de tous les sources et les puits à un moment donné t. Ce flux signifie à la fois l'échange de masse par unité de surface et également l'échange de masse sur une aire intégrée dans le contexte de superficies finies. On a donc :

$$F_{CO2}(t) = F_{oce}(t) + F_{bio}(t) + F_{ff}(t) + F_{feu}(t)$$

- $F_{CO2}(t)$ est le flux accumulé atmosphérique net de $CO_2$
- $F_{oce}(t)$ est le flux net des échanges atmosphère/océan
- $F_{bio}(t)$ est le flux net des échanges atmosphère/biosphère
- $F_{ff}(t)$ est le flux net des sources anthropiques
- $F_{feu}(t)$ est le flux net des sources liées aux incendies

Le flux net d'accumulation atmosphérique de $CO_2$ dans l'atmosphère est généralement exprimé en Petagrammes de Carbone par an (PgC/an) ou GTCO2 par an aux échelles régionales. A l'échelle d'une installation humaine, le flux est exprimé en TCO2/an ou en TCO2 équivalent/an en additionnant aux émissions de $CO_2$, celles des autres GES en fonction de leur potentiel de réchauffement global comparé au $CO_2$. En raison de sa longue espérance de vie, les concentrations atmosphériques de CO2 sont estimées assez uniformes et leur variation contribue à estimer les échanges de flux. Pendant l'holocène, les concentrations indiquées par les analyses de carottes de glace de Vostok et Taylor Dome étaient d'environ 275ppm, très inférieures à celles actuelles. En 2007 et 2008, la moyenne de concentration de CO2 dans l'atmosphère était respectivement d'environ 383.71ppm et 385.57ppm selon les observations du Mauna Loa. Avec une masse molaire de l'air d'environ 28.84g.mol$^{-1}$ et une masse de l'atmosphère d'environ 5.137x10$^{18}$kg, 1ppm de CO2 représente environ 2.137PgC, ce qui permet de calculer un flux global annuel net 2008/2007 d'accumulation atmosphérique provenant des échanges naturels et anthropiques de:

$$F_{CO2_{2008/2007}} = \frac{dC_{CO2}(t_{2008/2007})}{dt_{2008/2007}} \bullet \frac{M_C}{M_{air}} \bullet \frac{m_{atm}}{10^6} \approx 3.97 PgC \ (\approx 15 \ GTCO2)$$

Le Protocole de Kyoto de la CCNUCC (Convention-Cadre des nations Unies sur les Changements Climatiques) est entré en vigueur le 16 février 2005 et cet accord international définit des objectifs astreignant 37 pays industrialisés et la Communauté Européenne à réduire les émissions de CO2, CH4, N20, HFCs, PFCs et SF6 au moins de 5% au-dessous des niveaux de 1990 dans la période d'engagement 2008-2012. Les pays doivent répondre à leurs objectifs principalement par le biais de mesures nationales et ils se concentrent sur la diminution de la demande en biens et services intensifs en émissions, le développement de technologies en faible teneur de carbone, l'accroissement de leur efficacité énergétique et la réduction d'usage de combustibles fossiles. Pour vérifier leurs objectifs, les émissions sont surveillées et un reporting est effectué par les pays en soumettant des inventaires annuels d'émissions. Ces inventaires nationaux sont une liste détaillée des estimations des sources et des puits de GES nationaux par secteur et ils servent à la fois de base à la mise en place de mesures d'atténuation efficaces et à s'assurer que les tendances sont conformes aux engagements.

Le protocole offre également des moyens supplémentaires aux pays pour atteindre ces objectifs tels que les marchés d'échanges de quotas d'émissions (Ex: European Union Emission Trading Scheme). Dans ces mécanismes, une autorité centrale définit un quota pour toutes les sources et les permis d'émission sont ensuite livrés aux installations, qui s'engagent à tenir un nombre équivalent de permis (ou crédits), qui représentent le droit d'émettre un montant précis. Le montant total des émissions ne peut dépasser le quota, limitant ainsi les émissions à ce niveau. Les installations sont autorisées à acheter et vendre leurs permis entre elles, ceci visant à stimuler l'investissement écologique et à réduire leurs niveaux avec le meilleur rapport coût-efficacité.

Afin que ces nouveaux marchés soient efficients, les participants doivent avoir confiance dans l'exactitude des données reportées pour établir les niveaux de référence d'émissions. Parallèlement, les autorités réglementaires ont également pour souci que les méthodes de surveillance, de reporting et de vérification (MRV, Monitoring, Reporting and Verification) des inventaires de GES par installation aient un haut degré de fiabilité afin de pouvoir démontrer leur conformité. Ces méthodes MRV sont essentiellement effectuées par le biais de calculs et d'observations « ascendantes » ou « bottom-up » des émissions de GES par installation. Malgré leurs améliorations continuelles, des incertitudes significatives restent, en particulier sur certaines catégories de sources ou les facteurs d'émissions peuvent être assez variables et les processus de mesure peuvent manquer d'homogénéité d'une installation à l'autre. Un objectif d'incertitude sur les résultats est d'environ 5% selon les standards internationaux et industriels et il est reconnu que les installations peuvent rencontrer certaines difficultés à atteindre ce niveau d'excellence.

Les méthodes de mesure ascendantes des inventaires sont généralement effectuées via des méthodes de calcul et d'observation sur chaque installation. Les méthodes de calcul permettent de déterminer les sources d'émissions en utilisant des données d'activité et sont obtenues en combinant systèmes de mesure et paramètres venant d'analyses de laboratoire ou de coefficients types sous la forme suivante:

$$CO2 \ émissions \ (\frac{TCO2}{an}) = données \ d' activité \bullet facteur \ d'émission \bullet facteur \ d'oxydation$$

Pour les émissions de combustion, les données d'activité sont fondées sur la consommation de carburant. La quantité de carburant utilisée est généralement exprimée en termes de contenu énergétique et de facteur d'émission. Lorsqu'un carburant est consommé, seule une partie du carbone est oxydée en CO2, ce qui est pris en compte dans le facteur d'oxydation.

$$CO2\ émissions\ \left(\frac{TCO2}{an}\right)$$

$$= flux\ de\ carburant\ (T\ ou\ Nm^3) \bullet valeur\ nette\ calorifique\ \left(\frac{TJ}{T}\ ou\ \frac{TJ}{Nm^3}\right)$$

$$\bullet facteur\ d'émission\ \left(\frac{TCO2}{TJ}\right) \bullet facteur\ d'oxydation$$

Pour les émissions de processus, les données d'activité sont fondées sur la consommation de matières, le débit ou la production et le facteur d'émission. Le carbone contenu dans les matières premières, non converti en CO2 est pris en compte dans le facteur de conversion.

$$CO2\ émissions\ (\frac{TCO2}{an})$$

$$= données\ d'activité\ (T\ ou\ Nm^3) \bullet facteur\ d'émission\ \left(\frac{TCO2}{T}\ ou\ \frac{TCO2}{Nm^3}\right)$$

$$\bullet facteur\ de\ conversion$$

Des logiciels de calcul basés sur l'activité d'une installation se développent actuellement sur ce même principe.

D'autres méthodes de mesure ascendantes des émissions par installation déterminent, quant à elles, les émissions à leur source par la mesure en continu, en un point représentatif, des concentrations de GES dans les conduits et la fumée des gaz. Le flux de gaz $Q_e$ est calculé au moyen d'un bilan massique tenant compte des matières entrantes, du débit d'air à l'entrée, de l'efficacité du processus et à la sortie de la production et des concentrations de GES.

$$CO2\ émissions\ (\frac{TCO2}{an}) = \sum_{i=1}^{heures\ opérations\ par\ an} CO2_{concentration_i} \bullet Qe_i$$

Ces calculs et observations ascendants doivent cependant être effectués sur chaque installation et malgré leur amélioration constante, les résultats démontrent une certaine hétérogénéité d'une installation à l'autre en fonction des paramètres et processus utilisés. Ils se focalisent sur des points précis de l'installation et peuvent également omettre des sources adjacentes.

Un deuxième type de méthode de mesure des émissions, appelé descendante, se focalise sur la compréhension du cycle du carbone afin de déterminer les sources et puits de carbone à différentes échelles géographiques et de calculer, en agrégeant les flux, les inventaires locaux. La fraction molaire de CO2 (ppm), définie comme le nombre de moles de CO2 divisée par le nombre total de moles (excepté l'eau) d'une parcelle d'air donnée, est communément utilisée car c'est une quantité conservative, qui ne dépend pas de la pression, de la température, de la vapeur d'eau ou de la teneur en eau condensée, qui sont très variables. Moins variable, elle dépend uniquement des échanges entre sources et puits de CO2, presque tous causés par les processus de surface. Elle reflète la somme des échanges de CO2 et forme le résultat ultime des influences humaines et naturelles combinées.

Dans cette approche, le CarbonTracker est une référence internationale utilisée pour mieux comprendre la variabilité du cycle naturel du carbone-et estimer les contributions naturelles et humaines. Il estime les échanges atmosphériques de CO2 en combinant modélisation et observation et son principe est similaire à d'autres systèmes d'assimilation de données. Il commence par prévoir les fractions molaires atmosphériques de CO2 sur le globe par une combinaison de modèles d'échanges (module océanique, module biosphère, module incendie et module fossile) avec un modèle de transport atmosphérique, piloté par des prévisions météorologiques. La distribution du CO2 en 3D est ensuite échantillonnée en temps et lieu où les observations sont disponibles et la différence entre les observations et les prévisions du modèle sont minimisées avec un ensemble d'assimilation de données. Cette minimisation est obtenue par paramétrage d'une série de facteurs de réduction linéaire qui contrôlent l'ampleur des flux de surface pour obtenir des flux finaux optimisés de résolution 1°x1° sur l'Amérique du Nord et l'Europe.

Une mesure « descendante » ou « top-down », précise, in-situ et indépendante des sources et des puits naturels de GES évaluant de l'échelle planétaire jusque localement les inventaires de GES des installations peut compléter et corréler les méthodes ascendantes actuelles. Elle peut aider à confirmer que les actions actuelles d'atténuation, entreprises par les pays et installations, réduisent efficacement les niveaux et renforcer la confiance et la crédibilité dans les marchés d'émission et dans la valeur des droits à polluer lorsque dans le contexte actuel, le prix du carbone reste relativement volatil et les niveaux de concentrations sont historiquement élevés.

Résumé de l'invention

Un premier but de l'invention est de fournir une méthode de mesure des inventaires nets de GES par aire géographique et/ou installation, corrigés des interférences avec les aires avoisinantes ou lointaines. La présente invention propose une méthode de mesure améliorée par rapport au CarbonTracker pour évaluer avec précision les inventaires de GES par aire géographique, en particulier par aire géographique représentative d'une installation anthropique, notamment les inventaires de $CO_2$, mais aussi $CH_4$, $N_2O$, $NO_x$, HCFC, HFC, CFC, PFC, $SF_6$, $O_3$, $H_2O$, CO et $H_2$. La méthode est initialement présentée sur le $CO_2$ et le même processus est utilisé pour les autres GES.

Un premier avantage de l'invention est de fournir une méthode de mesure des émissions de gaz à effet de serre plus précise que les méthodes de mesure actuelles, notamment plus précise que le Carbontracker. En particulier, une , première caractéristique de l'invention est de résoudre de plus petites échelles spatiales pour obtenir des flux nets anthropiques, notamment de $CO_2$, en $Kg/m^2/s$ mesurés depuis l'échelle mondiale jusqu'au niveau des installations émettrices avec une résolution de $0.1° x 0.1°$ ($\approx 100 km^2$). Avec la mesure des flux des autres GES, un but de la méthode de mesure selon l'invention est donc de déterminer, sur des surfaces pouvant être comprises entre $1 km^2$ et $10000 km^2$, les émissions en (TCO2/an), (TGES/an) et (TCO2eq/an) avec une précision supérieure à 5%. Avec une telle précision, cette mesure descendante, uniforme et globale des inventaires de GES a les avantages de comparer les résultats sur l'ensemble des installations pour vérifier les incohérences, éviter les omissions de sources, réduire l'incertitude par installation et compléter les évaluations ascendantes actuelles. En résumé, un premier but de la méthode de mesure selon l'invention est donc de fournir une méthode de mesure permettant de mesurer, du haut vers le bas, de l'échelle planétaire jusqu'au niveau de l'installation, les inventaires de GES afin de fournir une mesure précise des émissions.

Un deuxième but de l'invention est de fournir un système de mesure des émissions de GES qui puisse être combiné, notamment avec les systèmes de gestion de production des installations, pour permettre le pilotage d'installations afin de limiter les émissions de combustion et/ou de processus et d'automatiser leur réduction. Des moyens matériels et logiciels spécifiques implémentant la méthode de mesure selon l'invention et assurant l'interface avec des systèmes de gestion de production sont installés au sein d'installations émettrices en fonction de leur activité (énergie, procédés industriel, usages de produit...), des processus mis en oeuvres par celles-ci et des GES émis. Le système de mesure selon l'invention permet alors de calibrer et d'optimiser le processus de chaque installation en fonction des niveaux et types d'émissions mesurés (ex : pics de pollution). Ceci permet d'obtenir une réduction d'émission automatisée sur chaque installation, de contrôler au fur et à mesure du temps son efficacité et de rester en conformité avec les normes régulatoires et environnementales.

Un deuxième but de l'invention est donc de fournir un système de mesure qui puisse être interfacé directement au sein d'une installation émettrice afin d'optimiser les processus de production tout en mettant en place divers processus ou techniques de réduction, ceci permettant alors de calibrer les installations en contrôlant et en optimisant les niveaux d'émissions en fonction des mesures effectuées.

Selon l'invention, la méthode de mesure des émissions hebdomadaires et annuelles d'un gaz à effet de serre générées sur une aire géographique déterminée comprend les étapes suivantes :

- effectuer des mesures journalières de concentration dudit gaz à effet de serre en une première pluralité de lieux répartis sur la totalité du globe terrestre et enregistrer lesdites mesures journalières de concentration dans un module d'observation,
- effectuer des mesures journalières des flux dudit gaz à effet de serre en une deuxième pluralité de lieux répartis sur la totalité du globe, et enregistrer lesdites mesures journalières des flux dans ledit module d'observation,
- effectuer des mesures de paramètres satellites, de paramètres météorologiques, de paramètres marins et de paramètres d'écosystèmes en une troisième pluralité de lieux répartis sur le globe terrestre et enregistrer les dites mesures de paramètres dans ledit module d'observation,
- extraire, au moyen d'un module d'extraction, des données de prévisions météorologiques d'au moins une source de données,
- effectuer une modélisation de l'évolution des flux dudit gaz sur le globe au moyen d'un module d'échange modélisant les sources et les puits naturels et anthropiques,
- effectuer une modélisation des émissions anthropiques hebdomadaires dudit gaz à effet de serre au moyen d'un module d'inventaires ascendants, ledit module intégrant des données brutes d'émissions pour une pluralité d'installations,
- effectuer, en utilisant ladite modélisation de l'évolution des flux, ladite modélisation des émissions anthropiques hebdomadaires et les dites données de prévisions météorologiques, une modélisation du transport atmosphérique dudit gaz à effet de serre au moyen d'un module de transport,

- calculer les flux finaux dudit gaz à effet de serre, au moyen d'un module d'inversion et d'assimilation de données utilisant ladite modélisation des flux effectuée par le module d'échange, ladite modélisation des émissions anthropiques hebdomadaires effectuée par le module d'inventaires ascendants, ladite modélisation du transport atmosphérique effectuée par le module de transport et lesdites mesures enregistrées dans ledit module d'observation,
- pondérer, au moyen d'un module de pondération, les dits flux finaux de façon à fournir des flux finaux pondérés,
- calculer, en utilisant les dits flux finaux pondérés et ladite modélisation des émissions anthropiques hebdomadaires effectuée par le module d'inventaires ascendants, les émissions hebdomadaires dudit gaz à effet de serre de ladite aire géographique, au moyen d'un module de géocodage comprenant au moins un système d'information géographique,
- extrapoler, à partir des dites émissions hebdomadaires, les émissions annuelles dudit gaz à effet de serre de ladite aire géographique.

Tout d'abord et avant toute chose, il convient d'établir qu'au sens de la présente invention et dans toute la suite de la présente description, il convient d'interpréter le mot « module » au sens informatique du terme. En effet, tous les modules de la méthode de mesure selon la présente invention, et notamment le module d'observation, sont, de préférence, implémentés sous forme de software, hardware ou d'une combinaison des deux. Chaque module de la méthode peut avantageusement, en fonction de son rôle, être implémenté en utilisant des moyens informatiques, notamment des moyens de calculs (ordinateurs, serveurs dédiés, mainframes, etc), des systèmes de communication (WAN, LAN, INTERNET), mais également des logiciels, notamment des systèmes de gestion de base de données, des logiciels de modélisation, de calcul etc. La méthode de mesure peut également être implémentée sous forme d'un logiciel unique, éventuellement accessible online via Internet.

L'initialisation de la méthode commence donc par la prise de mesures journalières de concentration du gaz à effet de serre considéré en une première pluralité de lieux répartis sur la totalité du globe terrestre et par l'enregistrement de ces mesures dans un module d'observation.

Parallèlement vient une seconde étape durant laquelle on effectue des mesures journalières des flux du gaz à effet de serre considéré en une deuxième pluralité de lieux répartis sur la totalité du globe, mesures qui sont également enregistrée dans le module d'observation. Dans une troisième étape, on effectue des mesures de paramètres satellites, de paramètres météorologiques, de paramètres marins et de paramètres d'écosystèmes en une troisième pluralité de lieux répartis sur le globe terrestre et on enregistre également ces mesures de paramètres dans le module d'observation. La quatrième étape de la méthode consiste ensuite à extraire, au moyen d'un module d'extraction, permettant un transfert automatisé de données, des prévisions météorologiques d'au moins une source de données.

Les mesures effectuées lors des trois premières étapes de la méthode sont effectuées au moyen d'une pluralité de satellites, d'avions, de stations de mesures atmosphériques, de stations de mesures marines, de navires et/ou de stations de mesures d'écosystèmes qui permettent d'effectuer des mesures en des lieux distincts répartis sur la totalité du globe comme cela sera décrit plus en détail dans la suite. De plus, les moyens de mesures peuvent également comprendre des capteurs, capteurs marins, capteurs d'écosystèmes, etc. Les dites première, deuxième et troisième pluralités de lieux peuvent donc se recouvrir dans une large mesure en fonction de l'équipement de mesure local.

L'étape suivante de la méthode de mesure selon l'invention consiste ensuite en l'utilisation d'un module d'échange modélisant l'évolution des flux du gaz considéré sur le globe en modélisant les sources et les puits naturels et anthropiques.

Ensuite, un module d'inventaires ascendants est utilisé afin de modéliser les inventaires d'émissions des pays et installations à l'échelle 1°x1°, avec leur saisonnalité, en Kg/m2/semaine.

L'étape qui suit consiste en une modélisation du transport atmosphérique du gaz à effet de serre considéré, cette modélisation étant effectué au moyen d'un module de transport, sur la base de la modélisation de l'évolution des flux effectuée au moyen du module d'échange, sur la base de la modélisation des dites émissions hebdomadaires effectuée au moyen du module d'inventaires ascendants et sur la base des données de prévisions météorologiques. On obtient alors une distribution atmosphérique actuelle des fractions molaires de $CO_2$ et autres GES sur le globe, à comparer avec les données enregistrées dans le module d'observation comme cela sera décrit plus en détail ci-dessous.

L'étape suivante de la méthode de mesure selon l'invention consiste en l'utilisation d'un module d'inversion et d'assimilation de données, initialisé avec les résultats étalonnés de l'holocène fournis par le module d'échange, les résultats fournis par le module d'inventaires ascendants et le module de transport. Les observations et les inventaires ascendants sont intégrés dans ce module et la distribution atmosphérique du $CO_2$ est échantillonnée en temps et en lieu où les observations de fractions molaires atmosphériques sont disponibles. Les flux naturels et anthropiques modélisés sont redimensionnés avec des facteurs scalaires afin de corriger les flux avec les observations réelles pour obtenir des flux finaux en Kg/m2/semaine sur des mailles de 1°x1°.

Lors de l'étape suivante, un module de pondération permet ensuite de déterminer des flux finaux pondérés, en utilisant une modélisation des activités de production et du marché des émissions, et de valider les résultats fournis par le module d'inversion et d'assimilation de données sur des échelles continentales, régionales et nationales.

L'étape suivante consiste en l'utilisation d'un module de géocodage comprenant un système d'information géographique, permettant de corriger les inventaires ascendants sur la base des dits flux finaux pondérés afin d'obtenir les émissions hebdomadaires sur des mailles de 0.1°x0.1°en Kg/m2/semaine.

Lors de l'étape finale, à partir des émissions hebdomadaires, on peut ensuite extrapoler les émissions annuelles sur des mailles de 0.1°x0.1°en TCO2/an, TGES/an et TCO2eq/an avec une précision supérieure à 5% des émissions en TCO2/an, TGES/an et TCO2eq/an.

La méthode de mesure selon l'invention échantillonne donc les inventaires avec une approche descendante dans l'ordre suivant : planète, continents, régions continentales, états/pays, régions locales, jusqu'aux installations émettrices. Les différentes étapes permettent la vérification à chaque niveau géographique du total des inventaires anthropiques et de réduire les incertitudes venant d'omissions de sources et de puits, de facteurs d'émissions ou de flux latéraux.

Selon l'invention, la surface de ladite aire géographique peut être comprise entre 1km2 et 10000km2, en particulier ladite aire géographique peut inclure au moins une source anthropique donnée.

Selon l'invention, le dit gaz à effet de serre peut être choisi parmi le dioxyde de carbone (CO2), le méthane (CH4), le protoxyde d'azote (N20), les oxydes d'azote (NOx), les hydrofluorocarbures (HFC), les hydrochlorofluorocarbures (HCFC), les chlorofluorocarbures (CFC), les perfluorocarbures (PFC), l'hexafluorure de soufre (SF6), l'ozone (03), la vapeur d'eau (H2O), le monoxyde de carbone (CO) et le dihydrogène (H2).

Selon l'invention, les dites mesures journalières de concentration dudit gaz à effet de serre sur le globe, les dites mesures journalières des flux dudit gaz à effet de serre sur le globe, les dites mesures de paramètres satellites, de paramètres météorologiques, de paramètres marins et de paramètres d'écosystèmes peuvent être effectuées au moyen d'une pluralité de satellites, d'avions, de stations de mesures atmosphériques, de stations de mesures marines, de navires et/ou de stations de mesures d'écosystèmes permettant d'effectuer des mesures sur la totalité du globe.

Selon l'invention, ledit module d'échange peut effectuer ladite modélisation de l'évolution des flux dudit gaz à effet de serre, à partir de l'holocène, en utilisant un module solaire modélisant le rayonnement solaire en utilisant les paramètres orbitaux de la géométrie terrestre avec un calcul de l'excentricité de la terre déterminé proportionnellement à l'excentricité de Mars.

Selon l'invention, ledit module d'échange peut effectuer ladite modélisation de l'évolution des flux dudit gaz à effet de serre, à partir de l'holocène, en utilisant un module énergétique modélisant le rayonnement ondes-courtes, en incluant réflectivité, absorptivité et transmissivité de l'atmosphère, l'absorption par les gaz à effet de serre et les nuages, les variations d'albédo planétaire et l'influence du trou de la couche d'Ozone, ledit module énergétique modélisant également le rayonnement ondes-longues, en utilisant l'équation de Schwartzschild, la méthode des émissivités et en incluant l'absorption et l'émission par les gaz à effet de serre et les nuages de rayonnements ondes-longues, les flux de chaleur latente, les flux de chaleur sensible, les flux de conduction et la température de surface.

Selon l'invention, ledit module d'échange peut effectuer ladite modélisation de l'évolution des flux dudit gaz à effet de serre, à partir de l'holocène, en utilisant un module océan modélisant l'effet net des échanges atmosphère-océan combiné avec lesdites données de prévisions météorologiques et prenant en compte l'effet de tampon, l'absorption par altération chimique suivant le modèle CDIAC DB1012 et le dégagement par évaporation.

Selon l'invention, ledit module d'échange peut effectuer la modélisation de l'évolution des flux dudit gaz à effet de serre, à partir de l'holocène, en utilisant un module biosphère modélisant l'effet net des échanges atmosphère-biosphère et incluant les types de plantes de la biosphère, l'indice foliaire, la lumière, l'albédo, la photosynthèse C3 et C4, l'addition du taux de photosynthèse brute limité, la respiration autotrophique, la respiration hétérotrophique et/ou la modification anthropique de la couverture de végétation depuis au moins le dernier millénaire.

Selon l'invention, ledit module biosphère peut utiliser un module incendie modélisant les perturbations dues aux incendies sur la base de données extraites de la base de données Global Fire Emission Database (GFEDv2).

Selon l'invention, ledit module d'échange peut effectuer ladite modélisation de l'évolution des flux dudit gaz à effet de serre, à partir de l'holocène, en utilisant un module fossile modélisant les émissions anthropiques fossiles à l'échelle globale.

Selon l'invention, ledit module d'inventaires ascendants peut extraire des inventaires d'émissions de la base de données EDGAR 4.0 en incluant un calcul de la variabilité temporelle des émissions.

Selon l'invention, ledit module de transport atmosphérique peut utiliser le modèle de transport combiné avec les dites données de prévisions météorologiques pour calculer le transport atmosphérique des flux dudit gaz à effet de serre sur le globe.

Selon l'invention, ledit module d'inversion et d'assimilation de données peut utiliser, pour calculer les dits flux finaux, une inversion de synthèse avec la fonction de Green pour les grandes régions et le filtre d'ensemble de Kalman.

Selon l'invention, ledit module de pondération peut utiliser, pour pondérer les dits flux finaux, une analyse des activités de production des pays et des régions du monde accompagnée d'une modélisation des marchés des émissions basée sur le modèle de biens publics produits par le privé.

Selon l'invention, ledit module de géocodage peut utiliser des coefficients correcteurs.

Le système de mesure selon l'invention, effectuant la méthode de mesure telle que décrite ci-dessus, comprend :

- des moyens de mesure des concentrations et des flux des gaz à effet de serre,
- des moyens de mesures de paramètres satellites, météorologiques, marins et d'écosystèmes,
- au moins une base de données centralisée comprenant un module d'observation,
- des moyens d'extraction et de transfert de données automatisés,
- des moyens de calcul comprenant au moins un module d'échange, au moins un module d'inventaires ascendants, au moins un module de transport, au moins un module d'inversion et d'assimilation de données, au moins un module de pondération,
- au moins un module de géocodage comprenant un système d'information géographique permettant de géocoder les résultats fournis par les dits moyens de calcul,
- une plateforme internet centralisée permettant de visualiser et d'analyser les émissions de gaz à effet de serre d'une pluralité d'aires géographiques données.

Selon l'invention, le système de mesure peut comprendre des moyens matériels et logiciels d'interface avec un système de gestion de production d'une installation.

L'invention sera mieux comprise par l'homme du métier grâce à la description détaillée de modes d'exécution en relation avec les dessins accompagnants, dans lesquels:

la figure 1 représente un diagramme en bloc illustrant le processus et les composantes de la méthode,
la figure 2 représente un diagramme en bloc illustrant l'échantillonnage des flux anthropiques de CO2,
la figure 3 représente un tableau illustrant l'espérance de vie et les potentiels de réchauffement globaux des GES,
la figure 4 représente un diagramme conceptuel d'échantillonnage du satellite GOSAT,
la figure 5 représente les caractéristiques des observations satellites,
la figure 6 représente les sites d'observations atmosphériques,
la figure 7 représente le réseau océanique de mesure de pCO2 de surface,
la figure 8 représente les sites d'observations d'écosystèmes,
la figure 9 représente un diagramme en bloc illustrant le module d'échange, le module d'inventaires ascendants et le module de transport,
la figure 10 représente un schéma illustrant l'orbite terrestre autour du soleil,
la figure 11 représente un schéma illustrant la radiation solaire sur le haut de l'atmosphère,
la figure 12 représente une figure illustrant le module énergétique,
la figure 13 représente les inventaires EDGAR 4.0 sur des mailles 0.1°x0.1° en TCO2eq,
la figure 14 représente un diagramme en bloc illustrant le module d'observations et le module d'inversion et d'assimilation de données,
la figure 15 représente un diagramme présentant trois cycles d'assimilation de données,
la figure 16 représente un diagramme en bloc illustrant le module de pondération,
la figure 17 représente un diagramme en bloc illustrant le module de géocodage,
la figure 18 représente un diagramme en bloc illustrant un système de mesure selon l'invention.

Description détaillée de l'invention

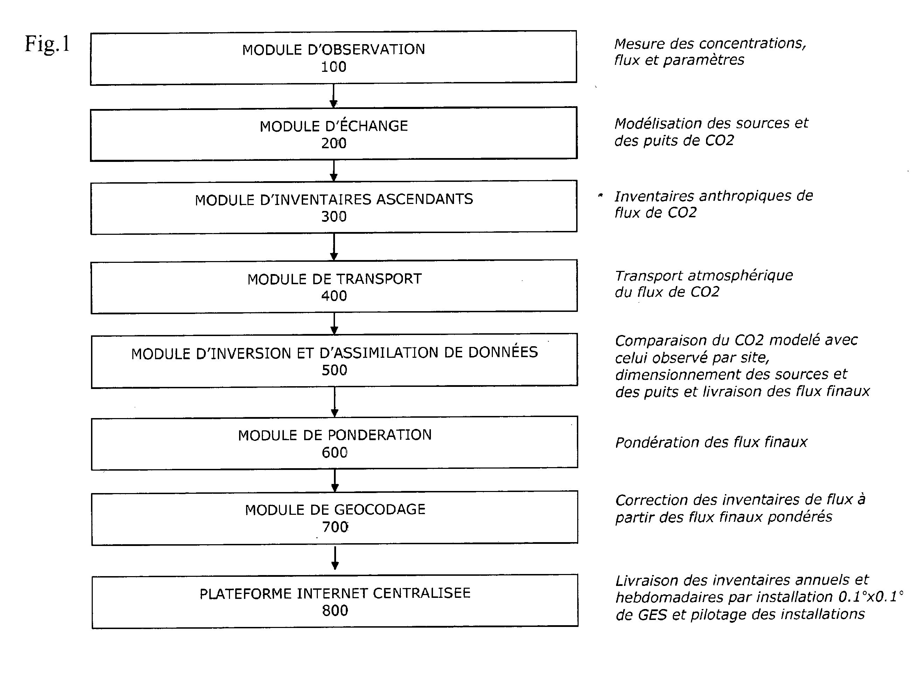

La figure 1 représente, de manière générale, les différentes étapes de la méthode de mesure selon l'invention. L'invention est liée à une méthode de mesure et un système de mesure précis d'inventaires de GES incluant le CO2, CH4, N20, NOx, HFC, HCFC, CFC, PFC, SF6, 03, H2O, CO et H2 à partir de leurs sources et de leurs puits naturels et anthropiques sur une aire géographique déterminée, en particulier sur une aire dont la surface est comprise entre 1km2 et 10000km2. La méthode est initialement présentée sur le CO2 et le même processus est utilisé pour les autres GES.

I. **CO2**

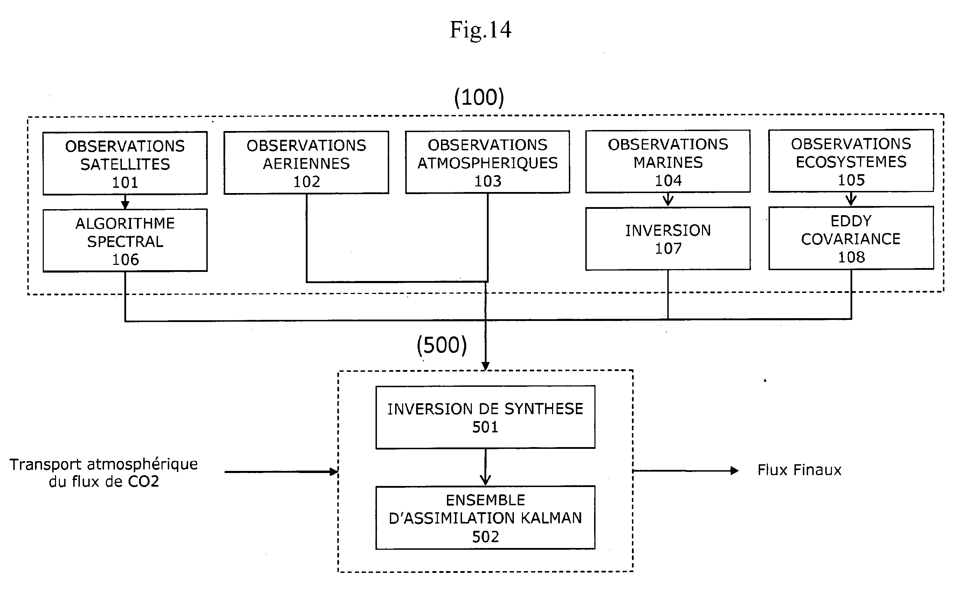

Pour chacun des gaz à effet de serre considérés, et plus particulièrement pour le CO2, la méthode de mesure selon l'invention comprend des mesures in-situ de CO2 effectuées à partir d'une combinaison d'observations Fig.1 Bloc 100) associant des mesures satellites (Fig.14 Bloc 101), des mesures aériennes (Bloc 102), des mesures atmosphériques (Bloc 103), des mesures marines (Bloc 104) et des mesures d'écosystèmes (Bloc 105).

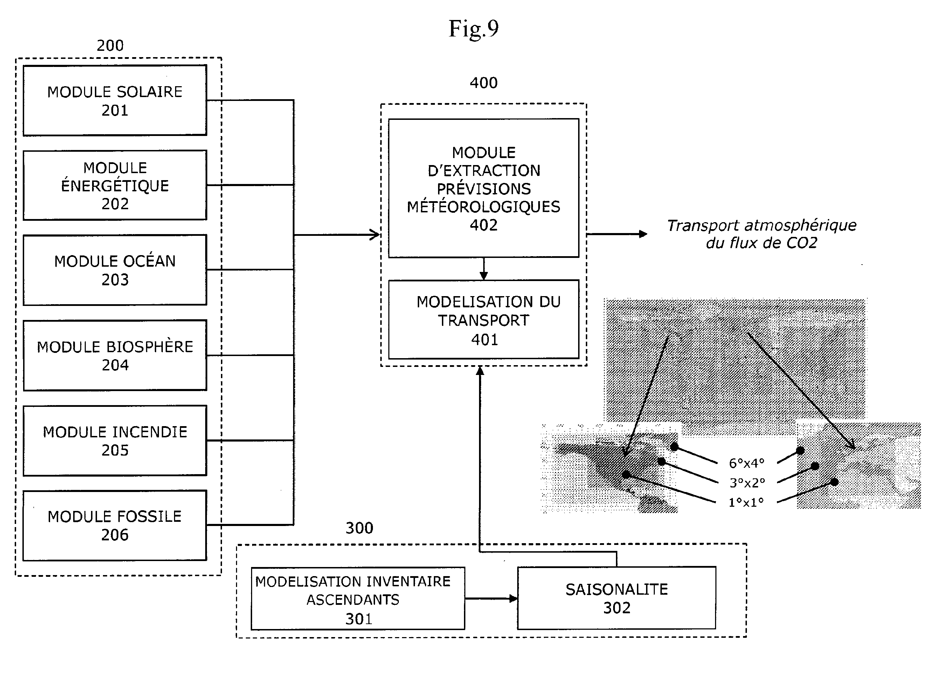

Elle comprend également la modélisation des flux de CO2 sur le globe, initialisé à partir de l'holocène, en utilisant un module d'échange (Fig. 1 Bloc 200). Ce module d'échange utilise un module solaire (Fig. 9 Bloc 201), un module énergétique (Bloc 202), un module océan (Bloc 203), un module biosphère (Bloc 204), un module incendie (Bloc 205) et un module fossile (Bloc 206). Un module d'inventaires ascendants permet d'obtenir une distribution spatiale précise des inventaires maillés d'émissions anthropiques (Bloc 301). Les fractions molaires sont modélisées sur l'atmosphère entière avec un module de transport (Bloc 400). La différence entre les observations et les prévisions du modèle est minimisée par le module d'inversion et d'assimilation de données (Bloc 500) en ajoutant une inversion de synthèse avec la fonction de Green (Bloc 501), suivie par le filtre d'ensemble de Kalman (Bloc 502) pour obtenir des flux finaux comme cela sera décrit plus en détail ci-dessous. La méthode de mesure selon l'invention ajoute une validation et une modulation des flux finaux par un module de pondération (Bloc 600) pour obtenir des flux finaux pondérés, puis utilise enfin un système de coefficients correcteurs permettant d'obtenir, sur la base des flux finaux pondérés (bloc 700), des émissions calculées à l'échelle des installations en TCO2/an, TGES/an et TCO2eq/an. Un aperçu des résultats des différents modules de la méthode est le suivant :

| Blocs | Modules | Résultat | Maillage |
|---|---|---|---|
| 100 | Module d'observation | Concentrations, flux et paramètres | Local |
| 201 | Module Solaire | W/m2/jour | 1°x1° |
| 202 | Module Energétique | W/m2/jour | 1°x1° |
| 203 | Module Océan | PgC/mois | 5°x9° |
| 204 | Module Biosphère | $Kg/m^2/s$ | 1°x1° |
| 205 | Module Incendie | Kg/m2/mois | 1°x1° |
| 206 | Module Fossile | T/an | Global |
| 300 | Module d'inventaires ascendants | Kg/m2/semaine | 1°x1° |
| 401 | Module de Transport | ppm/s | 1°x1° |
| 500 | Module d'inversion et d'assimilation | Kg/m2/semaine | 1°x1° |
| 600 | Module de pondération | T/semaine | Régions et pays |
| 700 | Module de géocodage | GES en $Kg/m^2$/semaine, TCO2/an, TGES/an et TCO2eq/an | 0.1°x0.1° |

La méthode est tout d'abord proposée sur le CO2, puis présente les sources et les puits des autres GES pour lesquels le même processus est appliqué. Elle inclue notamment pour le CH4, le modèle utilisé pour modéliser les émissions du Pergélisol et du fond des océans provenant des hydrates de CH4 comme cela sera décrit plus en détail au point II.

## 1. Module d'observation

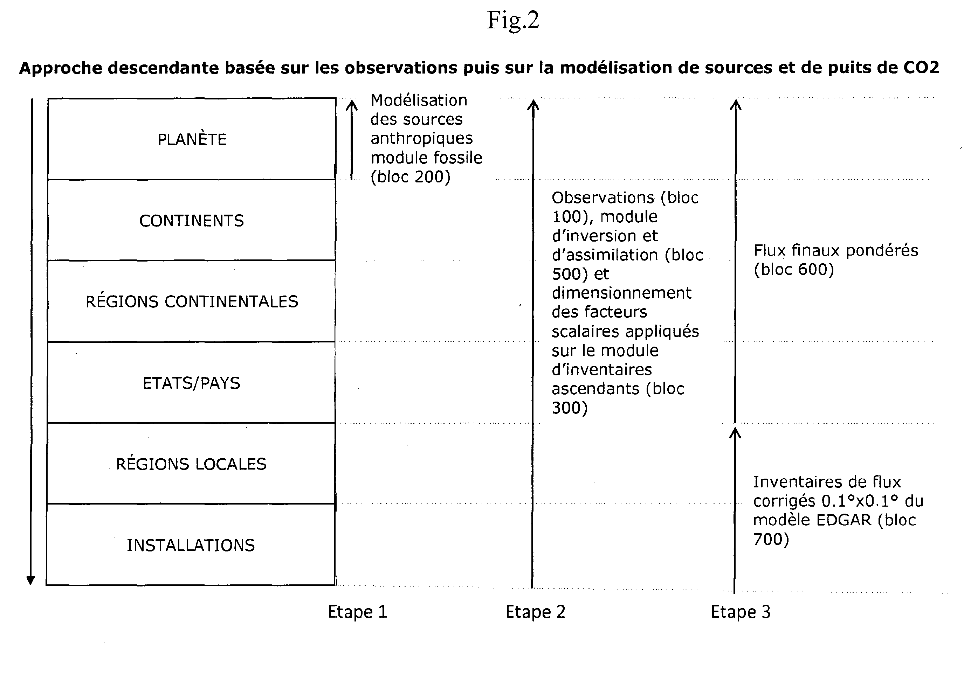

Des observations in-situ en continu, de haute précision et à long terme sont nécessaires afin de comprendre les processus d'échanges du cycle du carbone et de réduire les incertitudes des estimations. La méthode améliore le Carbontracker en effectuant une combinaison de mesures satellites, aériennes, atmosphériques, d'écosystèmes et marines (Bloc 100, Fig. 14) afin d'obtenir une observation globale de la planète avec une couverture des différentes couches de l'atmosphère et des surfaces de la planète. Ceci permet d'obtenir une cartographie complète quasi temps-réel des sources et des puits de GES des échelles mondiales, continentales, étatiques, nationales, locales, jusqu'au niveau des installations pour refléter la réalité des niveaux d'émissions (Fig. 2). De plus, la réunion de ces cinq techniques complémentaires et essentielles d'observation permet l'obtention d'un traitement de concentrations et de flux homogènes sur l'ensemble du globe avec une visibilité locale détaillé pour obtenir des résultats d'inversion et d'assimilation précis à l'échelle 1°x1°. Toutes les mesures acquises sont enregistrées dans le module d'observation.

### • Observations satellites

Les observations satellites (Bloc 101, Fig. 14) peuvent inclure la combinaison du satellite Japonais GOSAT (Maksyutov et al. 2008) et du satellite Européen ENVISAT (Bovensmann et al. 1999) pour obtenir une couverture de mesure globale des différentes couches de l'atmosphère, de l'échelle planétaire jusqu'au niveau des installations. Ces satellites mesurent le rayonnement solaire proche infrarouge réfléchi par la surface de la terre et l'atmosphère, ce qui permet de détecter l'absorption atmosphérique des GES dans ces régions spectrales.

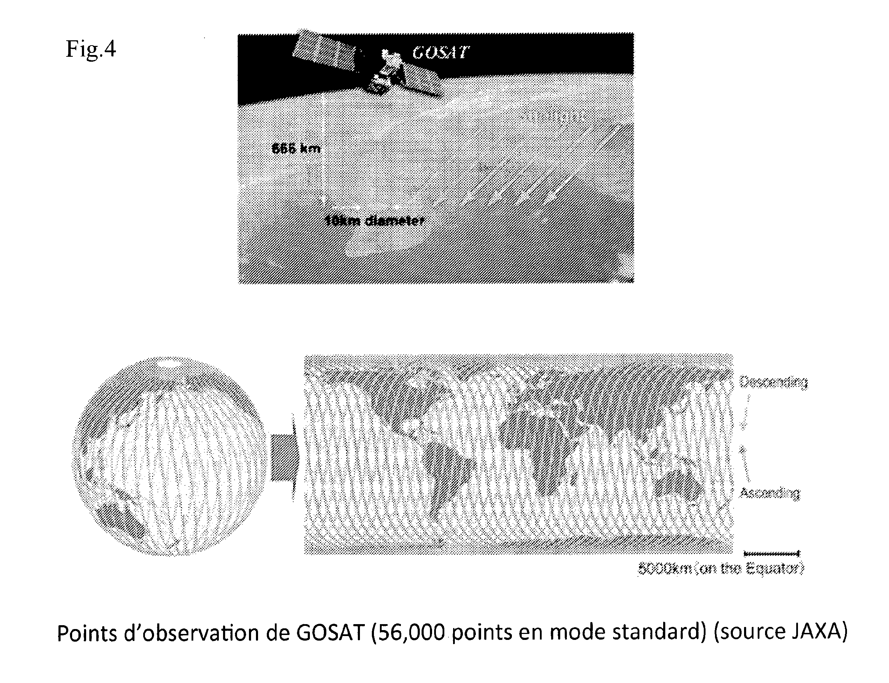

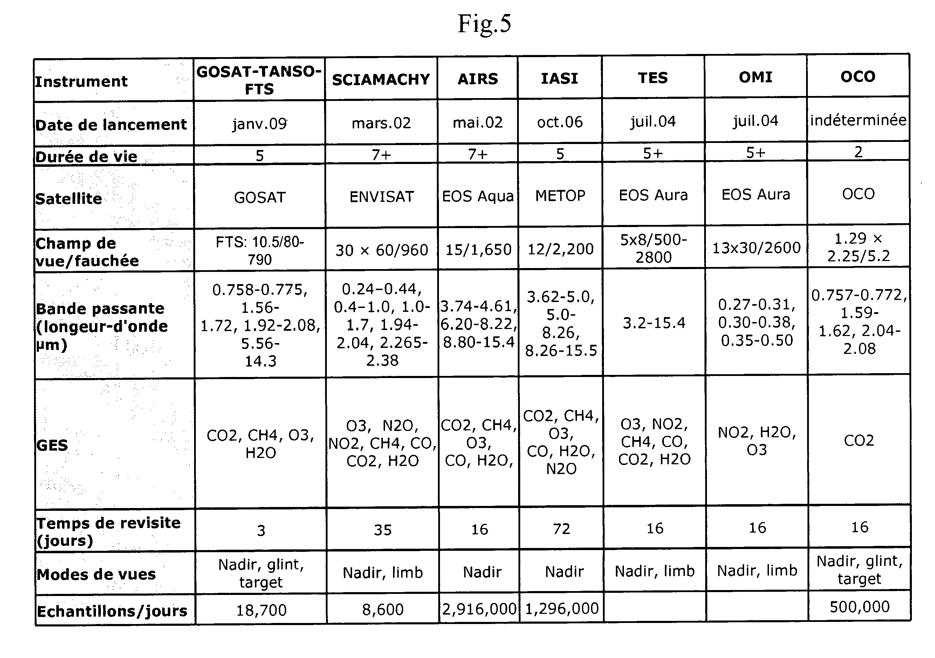

Ceci requiert une forte sensibilité des mesures jusqu'à la surface où les signaux de sources et de puits sont les plus forts et le satellite GOSAT avec ses deux instruments TANSO-FTS et TANSO-CAI actuellement en orbite (Fig. 4) offre cette information avec une précision relative de mesure de l'ordre de 1% (4 ppm) et une empreinte de 10km de diamètre (Fig. 5). Les grandes sources fossiles locales telles que les installations émettrices augmentent les concentrations de $CO_2$ dans l'atmosphère de 1 à 10 ppm sur la source et sont généralement dispersés sur quelques dizaines de kilomètres autour. Le satellite GOSAT démontre ses capacités de surveillance par installation et les échantillonnages fournissent des données indépendantes à comparer avec celles du module d'inventaires ascendants (Bloc 300). Avec de 100 à 500 grandes sources locales dans les pays de forte émission, il est possible d'obtenir un échantillon statistique de mesures des panaches de $CO_2$ émis par ces grandes sources dans ces pays. La méthode utilise la combinaison des deux algorithmes Full Physics (FP) et Apparent Optical Path Différence (AOPD) (Boland et al. 2009) (Bloc 106) afin de récupérer les colonnes de $CO_2$ (XCO2) des rayonnements mesurés par GOSAT. Avec une exactitude de 0.3% à 0.5% (1 à 2 ppm), une zone d'échantillonnage inférieure à 3km2, le satellite américain OCO (Crisp et al. 2004) a également été conçu pour mesurer l'accroissement de concentration au dessus des sources et des puits locaux. La méthode complétera les mesures de $CO_2$ avec le successeur du satellite OCO lorsqu'il sera disponible, OCO ayant manqué son lancement début 2009. La méthode utilise également le spectromètre SCIAMACHY d'ENVISAT actuellement en orbite et la combinaison des deux algorithmes WFM-DOAS et BESD suivant Buchwitz et al. (2008) (Bloc 106) afin de récupérer les colonnes de $CO_2$ (XCO2) à partir des rayonnements mesurés. Le développement de ces algorithmes progresse et atteint actuellement 2-3% de précision selon Schneising et al. (2008) avec une résolution horizontale de 30kmx60km (Fig. 5). Les recherches ont l'objectif d'atteindre 1% de précision relative, ce qui est suffisant car un offset constant est pris en compte dans l'inversion et l'assimilation de données et un haut niveau de précision relative est requis pour valider les modèles. Les produits de données de GOSAT et de SCIAMACHY sont les colonnes moyennes de fractions molaires de $CO_2$ en air sec (XCO2, ppm). Pour la mesure des autres GES et la validation des données de $CO_2$, les satellites GOSAT et ENVISAT (SCIAMACHY) sont complétés par AIRS, IASI, TES et OMI (Fig. 5).

Les observations satellites peuvent provenir également de l'Atmospheric Infrared Sounder (AIRS) (Aumann et al., 2003) qui est un sondeur infrarouge multi spectral de haute résolution sur le satellite AQUA conçu pour apporter des données précises sur l'atmosphère, la surface et les océans et offre des mesures sur la température atmosphérique, les profils d'humidité, de température de surface et de GES tels que 03, CO, $CO_2$, $CH_4$ et $H_2O$.

Les observations satellites peuvent comprendre également des mesures grâce à l'Infrared Atmospheric Sounding Interferometer (IASI) (Crevoisier et al. 2009) qui est un spectromètre à transformée de Fourier sur le satellite METOP et apporte des mesures infrarouges des profils de température dans la troposphère et la stratosphère basse, les profils d'humidité dans la troposphère et de GES tels que $CO_2$, $CH_4$, N20, CO, $H_2O$ et 03.

Les observations satellites peuvent comprendre par ailleurs des mesures grâce au Tropospheric Emission Spectrometer (TES) (Luo et al., 2007) qui est un spectromètre à transformée de Fourier à bord d'EOS AURA offrant une discrimination des espèces moléculaires radiativement active dans le bas de l'atmosphère. TES emploie à la fois les émissions naturelles thermiques de la surface et de l'atmosphère et la lumière du soleil réfléchie apportant une couverture jour-nuit sur le globe avec des mesures de $CO_2$, CO, $CH_4$, 03, $H_2O$ et N02.

En outre, lesdites observations peuvent comprendre également des mesures au moyen de l'Ozone Monitoring Instrument (OMI) (Levelt et al. 2000) qui est un spectromètre à bord d'EOS AURA mesurant le spectre de longueurs d'ondes ultraviolet/visible/proche infrarouge avec une haute résolution spectrale. OMI fournit notamment les colonnes totales de mesures troposphériques et stratosphériques d'03, $H_2O$ et N02 ainsi que les profils stratosphériques d'O3, l'albédo de la surface, les aérosols et les paramètres de nébulosité.

Les observations satellites peuvent inclure les données de l'instrument MODIS des satellites Terra et Aqua qui apporte des données objectives du changement de couverture des terres (ALCC, Anthropogenic Land Cover Change).

Les données satellitaires de GES peuvent également être validées par les réseaux de spectromètres à Transformée de Fourier au sol, Network for the Detection of Atmospheric Composition Change (NDACC) (Kurylo, 1991) et Total Carbon Column Observing Network (TCCON) (Toon, 2009). Ces stations enregistrent les spectres solaires directs dans la région spectrale proche-infrarouge avec pour NDACC la mesure de 03, CO, $CO_2$, N20, $CH_4$ et pour TCCON, celle de $CO_2$, $CH_4$, N20, CO et $H_2O$.

Les paramètres mesurés et leur fréquence lorsqu'ils sont disponibles incluent:

| Mesures | Fréquence |
|---|---|
| GES (dont $CO_2$, $CH_4$, CO, $N_2O$, NOx, $H_2O$, 03) | Continu |
| ALCC | Continu |
| Albédo | Continu |

- **Observations aériennes**

La méthode de mesure selon l'invention complète les mesures satellites par des mesures effectuées grâce à des observations aériennes, mesures qui sont également enregistrées dans le module d'observation. Les observations satellites peuvent être complétées par les observations aériennes disponibles effectuées avec le NOAA ESRL Carbon Cycle Greenhouse Gases group (CCGG) Air sampling, ainsi que par les mesures du programme In-service Aircraft for a Global Observing System - European Research Infrastructure (IAGOS-ERI). Le NOAA ESRL Air sampling permet d'effectuer des mesures de profils verticaux de $CO_2$, $CH_4$, $N_2O$, $CO$, $H_2$ et $SF_6$. IAGOS-ERI a pour origine le programme MOZAIC (Marenco et al. 1998) et inclue le programme CARIBIC (Schuck et al. 2009) et apporte des observations GES in-situ de haute-qualité dans la tropopause incluant $CO_2$, $CH_4$, $CO$, $N_2O$, $H_2O$, $O_3$, CFC, HFC et HCFC.

| Mesures | Fréquence |
|---|---|
| GES (dont $CO_2$, $CH_4$, $CO$, $N_2O$, $H_2O$, $O_3$, CFC, HFC, HCFC, $SF_6$, $H_2$) | Continu et échantillonnage hebdomadaire |

- **Observation atmosphériques**

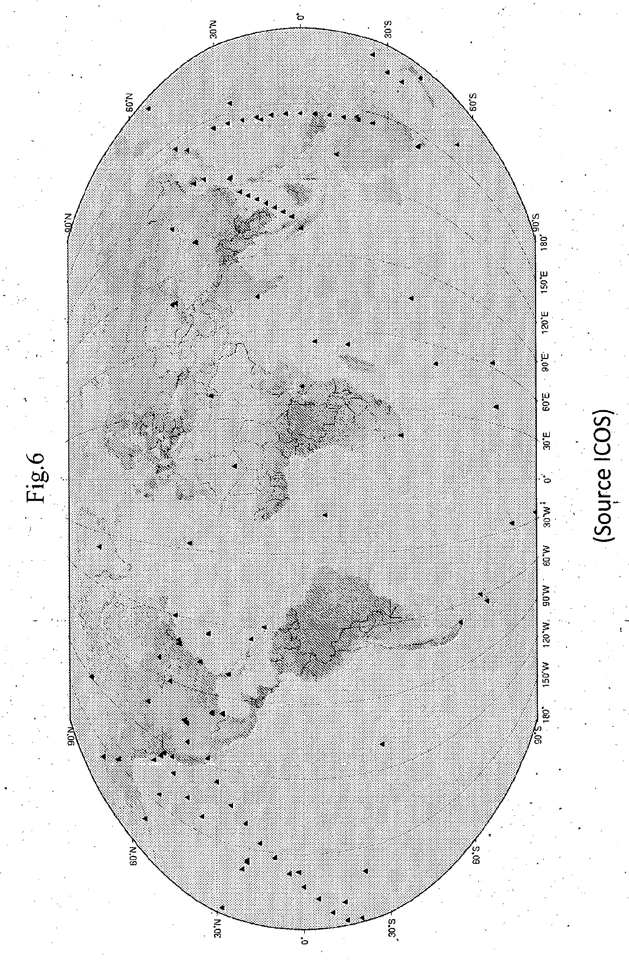

Les observations atmosphériques peuvent aussi comprendre des mesures de concentration atmosphérique et d'échantillons prélevés sur les sites NOAA ESRL Cooperative Global Air Sampling Network et le CSIRO Air Sampling Network pour chaque année. Elle utilise également des séries chronologiques in situ quasi continues des tours et observatoires NOAA ESRL. Ces observations sont étalonnées sur le standard mondial (WMO-2005). La méthode peut compléter ces observations atmosphériques (Bloc 103, Fig. 14) en incluant préférablement celles actuelles et en développement du Global Atmosphere Watch (GAW) incluant les stations WDCGG, de l'International Global Atmospheric Chemistry Observations (IGACO), du GCOS Reference Upper-Air Network (GRUAN), du Network for the Detection of Atmospheric Composition Change (NDACC) dont les stations LIDAR, de l'Integrated Carbon Observation System (ICOS), du System for Observation of Halogenated Greenhouse Gases in Europe (SOGE) et du réseau ALE/GAGE/AGAGE (Fig. 6).

Chaque station est un observatoire qui mesure continuellement la variabilité régionale et mondiale des concentrations de $CO_2$ (ppm), de GES ainsi que les paramètres météorologiques. Elles sont utilisées pour détecter les changements long termes dans les tendances de concentrations et la variabilité interannuelle associée à des émissions anthropiques et anomalies climatiques. Certaines stations sont également équipées des instruments de mesures de flux. Chaque station est représentative d'une superficie généralement de plus de 100 $km^2$. Les mesures de concentration de $CO_2$ sont effectuées idéalement avec une précision inférieure à 1 ppm et des échantillons d'air sont également collectés, de préférence sur une base hebdomadaire puis analysés. Les paramètres mesurés et leur fréquence lorsqu'ils sont disponibles incluent:

| Mesures | Fréquence |
|---|---|
| $CO_2$ | Continu (30 min) |
| Paramètres météorologiques (pression, température, humidité relative, vent) | Continu (30 min) |
| Hauteur de la couche limite | Continu (30 min) |
| Flux $CO_2$ | Continu (30 min) |
| GES (dont $CH_4$, $CO$, $N_2O$, $NO_x$, $H_2O$, $O_3$, CFC, HFC, HCFC, $SF_6$, $H_2$, PFC) | Continu et échantillonnage hebdomadaire |

- **Observations marines**

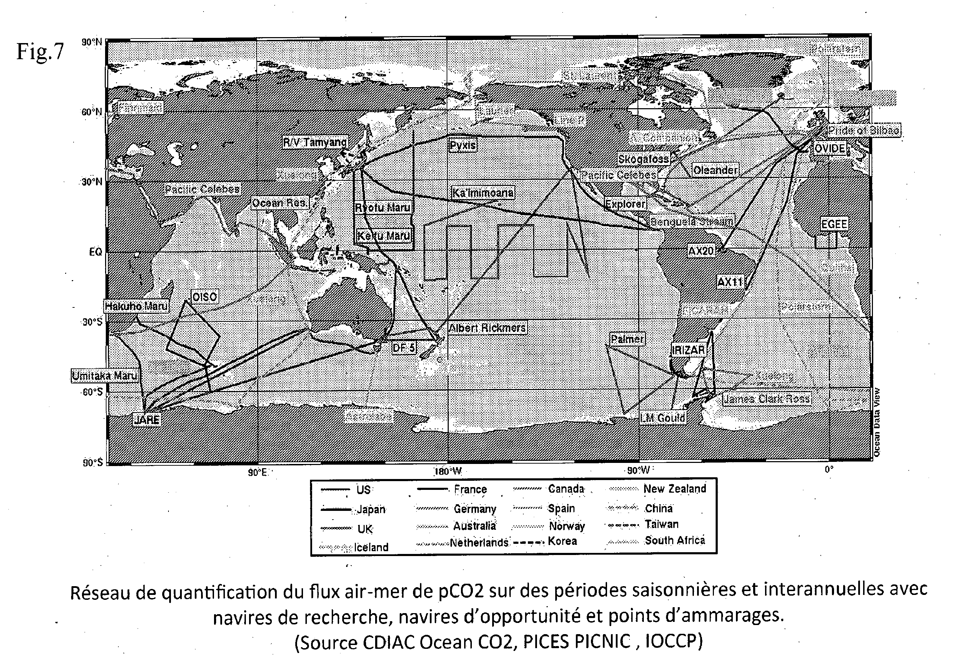

La méthode de mesure selon l'invention effectue également des mesures via des observations marines (Bloc 104, Fig. 14) qui peuvent être effectuées au moyen d'un réseau de navires instrumentés naviguant les océans et de stations fixes (Fig. 7). Les navires sont en général des navires commerciaux, ferrys, porte-conteneurs et bateaux citernes opérant sur des itinéraires répétés. Les stations fixes sont des sites sur l'océan sur lesquels des observations temporelles continues sont enregistrées par le biais d'amarres et de navires de recherche. La couverture doit être suffisante pour quadriller les flux océaniques air-mer des régions océaniques (Pacifique, Atlantique, Indien, Sud, Arctique). La méthode peut inclure les observations des programmes International Océan Carbon Coordination Project (IOCCP), IOCCP underway lines, JCOMM VOS, IOCCP time series (Oceansites), IOCCP Hydrography (GO-SHIP), CarbonOcean-IP, SOLAS-IMBER Carbon group (SIC), Carbon Dioxide Information Analysis Center Ocean CO2 Center (CDIAC), National Oceanic & Atmospheric Administration (NOAA) VOS, Climate Variability and Predictability Research (CLIVAR) et Integrated Carbon Observing System (ICOS).

Les navires et stations fixes sont équipés d'instruments automatisés mesurant la concentration atmosphérique et la pression partielle de CO2 de la surface, la température de surface et la salinité. Certains navires et stations marines sont équipés d'instruments pour la mesure de concentration atmosphérique de GES additionnels répétées à intervalles journalières et mensuelles et des échantillons d'air sont régulièrement recueillis puis analysées. Les flux air-mer sont calculés à partir des mesures de pression partielle de CO2, tel qu'effectué dans le Carbontracker en utilisant le principe d'inversion de Jacobson et al. (2007) (Bloc 107). Les paramètres mesurés et leur fréquence lorsqu'ils sont disponibles incluent:

| Mesures | Fréquence |
| --- | --- |
| CO2 atmosphérique | continu (30 min) |
| pCO2 océan, pression totale atmosphérique | continu (30 min) |
| Salinité et température de surface des océans | continu (30 min) |
| Paramètres Météorologiques | 4-heures |
| GES (dont CO2, CH4, CO, N2O, H2O, HFC, SF6, H2) | Continu et échantillonnage mensuel |

**• Observations d'écosystèmes**

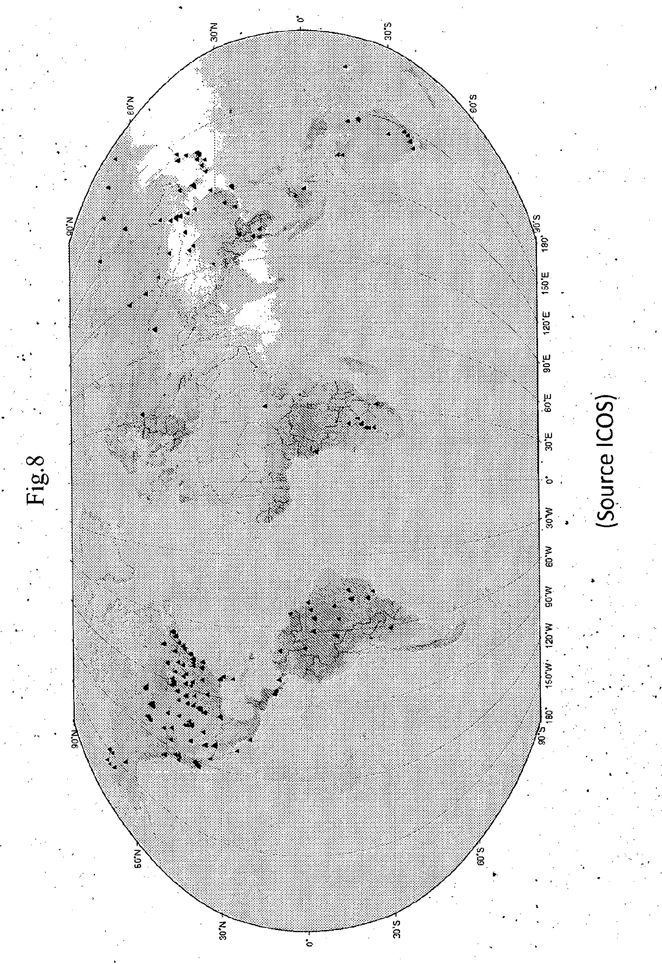

La méthode effectue également des mesures via des observations d'écosystèmes (Bloc 105, Fig. 14) comme celles, par exemple, du programme Fluxnet/iLEAPS (Baldocchi et al. 2001) qui est un réseau de réseaux régionaux et inclue préférablement les stations d'écosystèmes actuelles et en développement de Carboeurope-IP, CarboAfrica, Asiaflux, Afriflux, Ozflux, Large-Scale Biosphere-Atmosphere (LBA), US-China Carbon Consortium (USCCC), Nordic Centre for Studies of Ecosystem Carbon Exchange and its Interactions with the Climate System (NECC), TCOS-Siberia, ChinaFlux, Ameriflux, Fluxnet-Canada, KoFlux ainsi que l'Integrated Carbon Observation System (ICOS) (Fig. 8).

Chaque station mesure en continu les flux de CO2, les flux d'eau et d'énergie entre les écosystèmes terrestres et l'atmosphère ainsi que des variables d'écosystème telles que les variables météorologiques, budgets hydrologiques et de rayonnement et les réservoirs de carbone dans la végétation et les sols. Les stations transfèrent les données collectées des flux d'écosystèmes, de préférence quotidiennement. Certaines stations sont également équipées des instruments de mesures des concentrations des stations atmosphériques. Les données sont utilisées pour paramétrer et valider les modèles de carbone appliqués aux échelles continentales, détecter les changements à long terme dans les puits et sources et identifier l'impact des différences de gestion du budget de carbone. L'empreinte de chaque tour est en moyenne entre 200 et 1000 mètres. Les flux (Kg/m2/s) sont mesurés en utilisant la méthode de covariance des turbulences (Eddy covariance) à partir de mesures directes de la vitesse du vent vertical et des concentrations de CO2 pour déterminer les flux verticaux turbulents au sein des couches atmosphériques limites (Bloc 108). Des échantillons d'air pour la mesure de GES sont régulièrement recueillis puis analysés. Les paramètres mesurés et leur fréquence lorsqu'ils sont disponibles incluent:

| Mesures | Fréquence |
| --- | --- |
| Flux de chaleur sensible, CO2, H2O | Continu (30 min) |
| Profil vertical de CO2 | Continu (30 min) |
| Radiation globale nette réfléchie et diffuse | Continu (30 min) |
| Profil de température de l'air et du sol | Continu (30 min) |
| Profil de vitesse de vent | Continu (30 min) |
| Profil de contenu d'eau du sol | Continu (30 min) |
| Précipitations, chute et hauteur de neige au sol | Continu (30 min) |
| Flux de chaleur du sol | Continu (30 min) |
| Contenu de Carbone du sol | Echantillonnage sur 5 ans |
| Biomasse | Annuel |

(suite)

| Mesures | Fréquence |
|---|---|
| Gestion et perturbations | Annuel |
| Flux de CH4 | Continu (30 min) / Journalier |
| Flux de N20 | Continu (30 min) / Journalier |
| Température de la canopée | Continu (30 min) |
| Réflectance Spectrale | Continu (30 min) |
| Radiation Photosynthétique Active sous la canopée | Continu (30 min) |
| Niveau d'eau du sol | Continu (30 min) |
| Flux de Sève | Continu (30 min / 3 heures) |
| Respiration du Sol | Continu (3 heures) |
| Caméra de phénologie | Journalier |
| Déposition de N | Bihebdomadaire |
| Contenu des feuilles et du sol en N | Bihebdomadaire |
| Déposition de litière | Mensuel |
| Import et export de C et N due à la gestion de la biosphère | Annuel |
| GES (dont CO2, CH4, CO, 03, N2O, NOx, H2O, SF6, H2, HFC, HCFC, PFC) | Continu et échantillonnage hebdomadaire |

**2. Module d'échange**

Parallèlement à la prise de mesures, la méthode selon l'invention effectue une modélisation de l'évolution des flux de GES, notamment CO2, à partir de l'holocène, en utilisant un module d'échange (Fig.9). Le module d'échange comprend un module solaire, un module énergétique, un module océan, un module biosphère, un module incendie et un module fossile.

**a. Module Solaire**

La méthode de mesure selon l'invention améliore le calcul du rayonnement solaire du Carbontracker en utilisant un module solaire (Bloc 201, Fig. 9) qui modélise le rayonnement solaire avec une influence plus précise sur les échanges entre l'atmosphère, les océans et la biosphère.

L'insolation solaire est le montant du rayonnement solaire atteignant la terre par latitude et par saison et se réfère au rayonnement arrivant sur le haut de l'atmosphère (TOA, Top Of Atmosphere). D'après la théorie orbitale des paléoclimats, les variations de l'orbite terrestre dans le temps ont contribuées à changer le montant du rayonnement solaire reçu par la Terre pour chaque saison et ont dirigé les alternances des périodes glaciaires et interglaciaires. Selon les cycles de Milankovitch, trois paramètres de la géométrie terrestre orbitale sont utilisés pour évaluer le forçage orbital: l'obliquité, qui est l'inclinaison de l'écliptique comparativement à l'équateur céleste avec un cycle d'environ 40 milliers d'année (Ka), l'excentricité de l'orbite terrestre autour du soleil avec un cycle d'environ 100Ka et la précession climatique, liée à la distance Terre/Soleil au solstice d'été avec un cycle d'environ 26 Ka. Suivant cette théorie, les périodes interglaciaires ont tendance à se produire pendant les périodes de plus intense rayonnement solaire estival dans l'hémisphère Nord et depuis environ 11'700 ans, la Terre est entrée dans un nouveau cycle interglaciaire appelé l'Holocène.

Comme nouvelle approche, la méthode de mesure selon l'invention débute donc la modélisation des échanges de CO2 à t=0 à partir du début de l'holocène afin d'obtenir une base stable et étalonnée des échanges naturels pour déterminer avec plus de précision l'influence future des émissions anthropiques de l'ère industrielle. Pour le calcul de l'insolation solaire, les paramètres orbitaux de la géométrie terrestre sont obtenus en utilisant la théorie des Variations Séculaires des Orbites Planétaires de Bretagnon (1987).

L'inventeur de la méthode ajoute également une modification du calcul de l'excentricité, car à sa connaissance, aucune influence précise de la lune sur la dissipation de marées solides et océaniques de la terre, n'a été prise en compte pour calculer la perturbation sur l'excentricité de la terre et l'insolation solaire incidente. Phobos, un des satellites de Mars est utilisé pour évaluer cette influence car c'est le meilleur cas connu d'évolution orbitale rapide d'un satellite dans le système solaire avec une période orbitale de seulement 7,65 heures, comparativement à 27,3 jours pour la lune. Son mouvement orbital a été intensivement étudié depuis sa découverte en 1877 où il a exécuté depuis, environ 145'500 orbites, équivalent à une période de 10'880 ans pour la lune. L'instrument Mars Orbiter Laser Altimeter (MOLA) sur le satellite Mars Global Surveyor a observé les transits de l'ombre de Phobos sur la surface de Mars, et a directement mesuré la distance avec Phobos afin de vérifier si les positions observées de Phobos et de son ombre sont en bon accord avec les modèles. Compte-tenu de la longue période et de la précision des observations, l'accélération séculaire de Phobos est utilisée pour déterminer le facteur de qualité (Q) de Mars, qui-exprime le taux relatif de dissipation d'énergie et qui est associé au nombre de Love (k2), décrivant les propriétés élastiques des planètes. La mesure précise de ces paramètres permet de déterminer l'effet de la dissipation d'énergie sur l'excentricité de Mars. Avec sa forte proximité avec Mars, l'orbite de Phobos connaît une accélération séculaire orbitale qui est utilisée pour évaluer celle de la lune avec la terre. Sur la terre, la Lune exerce une attraction gravitationnelle causant des marées solides et océaniques. La terre induit une accélération séculaire, qui a un effet cumulatif sur la position de la lune lorsque extrapolée au fil des siècles. L'effet de cette accélération séculaire de la Lune est assez mal connu car les enregistrements de ses déviations remontent à environ un siècle. Une mesure précise de l'excentricité de Mars permet ainsi de déduire la perturbation de la lune sur l'excentricité de la Terre. La méthode évalue ce facteur comme une proportion de la distance Phobos-Mars, de la distance Lune-Terre et des excentricités respectives:

$$\frac{e_{\text{Terre}}}{D_{Lune-\text{Terre}}} \approx \frac{e_{Mars}}{D_{Phobos-Mars}}$$

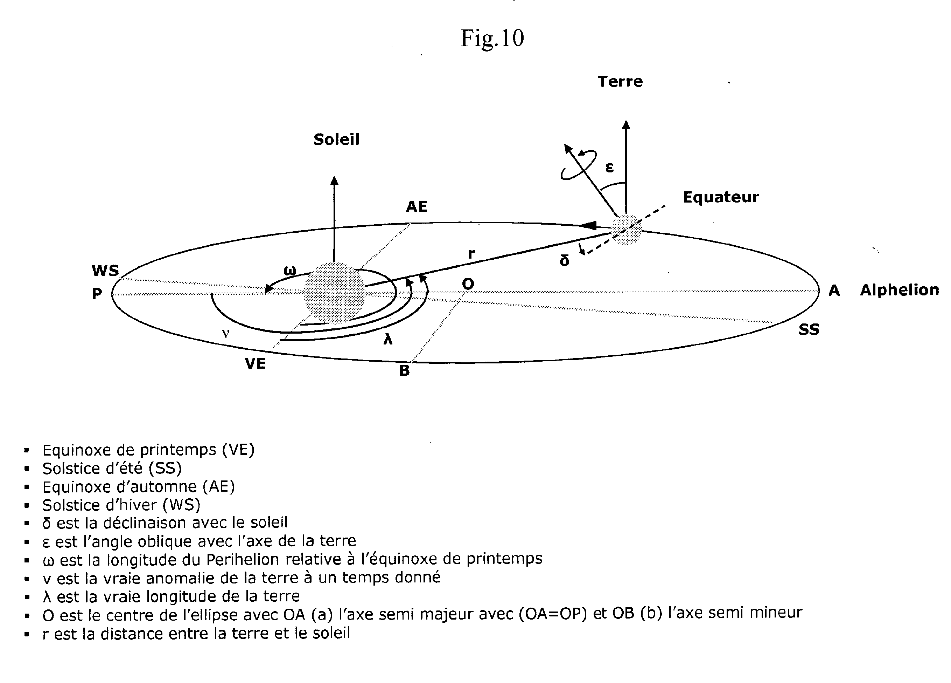

L'insolation instantanée est définie comme l'énergie reçue par unité de temps et de surface sur un plan horizontal à TOA et la méthode suit l'approche de Liou (2002) pour son calcul. La trajectoire de la terre autour du Soleil est une ellipse (Fig. 10). Le point le plus proche de l'orbite terrestre au soleil est appelée le Perihelion, tandis que l'Aphelion est le plus éloigné. La forme en ellipse est caractérisée par son excentricité $e = \sqrt{(a^2-b^2)}/a$. La distance (r) de la Terre au Soleil est calculée comme une fonction de v, la véritable anomalie de l'ellipse selon la première loi de Kepler.

$$r = \frac{a(1-e^2)}{1 + e\cos v}.$$

Le montant de la radiation solaire incidente par unité de surface à TOA est une fonction de r et la distance moyenne soleil-terre ($r_o$) est définie selon la seconde loi de Kepler:

$$r_o{}^2 = a^2\sqrt{(1-e^2)} \approx a^2$$

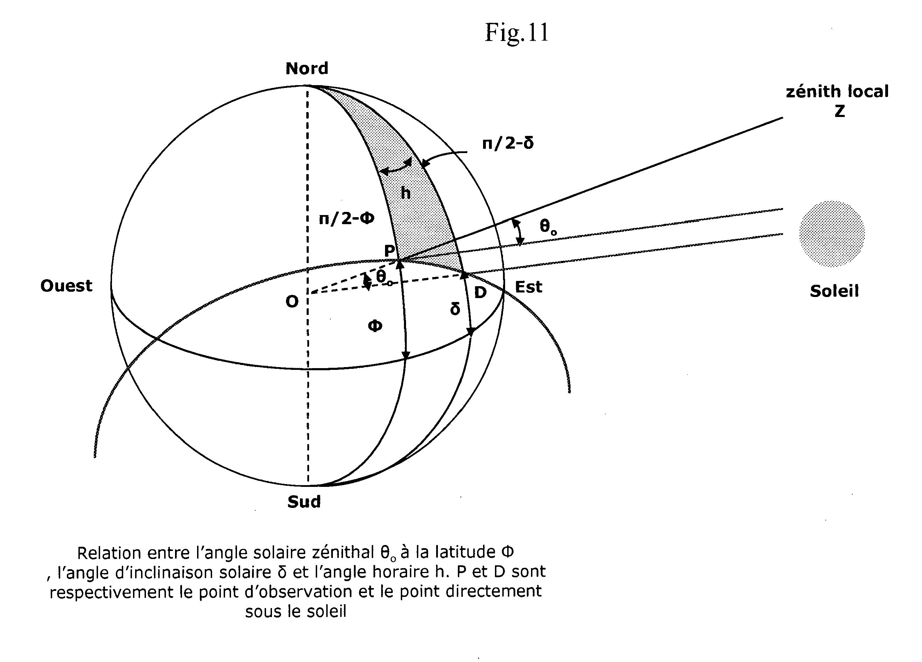

En moyenne, le montant d'énergie solaire incidente en dehors de l'atmosphère terrestre est la multiplication de la constante solaire $S_o$ par la surface qui intercepte les rayons solaires. $S_r$ est le montant du rayonnement solaire par unité de surface mesuré sur la surface extérieure de l'atmosphère dans un plan perpendiculaire aux.rayons à une distance (r) du soleil et est fonction de $S_o$. A TOA, une surface à la distance moyenne Terre-Soleil perpendiculaire aux rayons reçoit $S_r = S_0 r_o^2/r^2$. Le montant d'énergie solaire reçu par unité de temps sur une unité de surface horizontale à TOA est fonction de $\theta o$, l'angle solaire zénithal (Fig. 11). $S_h$ est déduit en fonction de l'orientation des rayons solaires et de la normale à la surface terrestre selon :

$$S_h = S_r \cos\theta_o = S_0 \frac{r_o^2}{r^2}\cos\theta_o$$

L'axe de rotation de la Terre n'est pas perpendiculaire à son plan orbital et est incliné relativement au plan céleste équatorial avec un angle ε. L'équinoxe de printemps est utilisé comme une référence pour définir la véritable longitude λ avec ω, la longitude du Perihelion mesurée de l'équinoxe d'automne (Fig. 11). De la trigonométrie sphérique, l'angle solaire zénithal dépend de la latitude φ du point de la Terre, de la déclinaison solaire δ et de l'angle horaire h, selon:

$$\cos\theta_o = \sin\phi\sin\delta + \cos\phi\cos\delta\cos h$$

où h indique le temps depuis lequel, le soleil était au méridien local, mesuré à partir de l'observateur du méridien vers l'ouest. δ est défini comme l'angle entre une ligne du centre de la terre vers le soleil et l'équateur céleste. H représente une demi-journée et est défini par *cos H* = -tan$\phi$ tan$\delta$. Connaissant la véritable longitude et l'obliquité, δ varie au gré des saisons selon sin$\delta$ = sin$\varepsilon$.sin$\lambda$ et l'énergie solaire reçue par unité de surface par jour est calculée selon:

$$S_{h,\text{day}} \approx \frac{S_0}{\pi}\left(\frac{r_o}{r}\right)^2 (H\sin\phi\sin\delta + \cos\phi\cos\delta\sin H)$$

Au cours de l'holocène, cette énergie solaire est principalement influencée par la précession, puis par l'obliquité. De ce calcul, la précession était à son point culminant au début de l'Holocène contribuant majoritairement à ce stade à la plus haute insolation et a diminué jusqu'à son minimum vers environ 1300AD. Depuis lors, la précession augmente jusqu'à un maximum vers environ 10Ka AD finissant son cycle. Cette insolation augmente donc depuis 1300AD et exerce une influence importante sur les flux de CO2 des océans et de la biosphère. Cette modélisation de la radiation solaire en W/m2/jour sur des mailles 1°x1° est utilisée dans le module énergétique (Bloc 202). Le calcul de la radiation solaire TOA est initialisé au début de l'holocène avec une périodicité de 50 ans et un calcul global sur la planète.

## b. Module énergétique

La méthode de mesure selon l'invention améliore également le Carbontracker en utilisant un module énergétique (Bloc 202, Fig. 9) qui modélise les rayonnements ondes-courtes et ondes-longues avec une influence plus précise sur les échanges entre l'atmosphère, les océans et la biosphère. Il inclut notamment un calcul plus précis de l'absorption du rayonnement solaire par les GES, de l'influence du trou de la couche d'Ozone et de l'effet de serre.

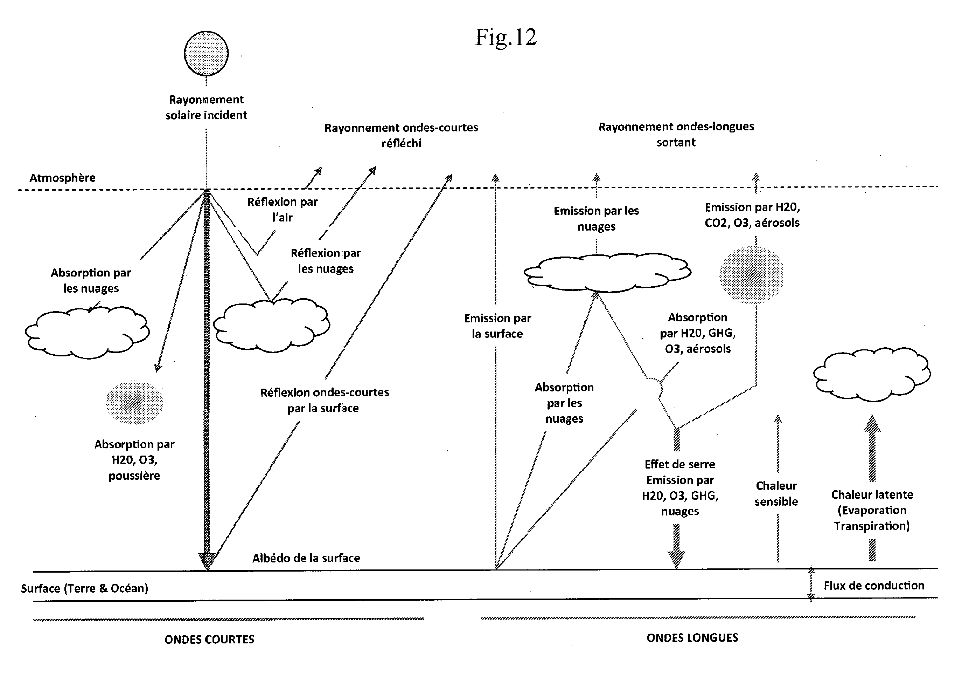

Le calcul du rayonnement ondes-courtes incident est effectué selon la méthode d'Huybers et al. (2007). Ce rayonnement, principalement d'origine solaire, est le résultat de multiples processus de dispersion et d'absorption impliquant essentiellement les molécules H20, 03, les aérosols, les nuages, l'air et la surface sous-jacente (Fig. 12). Ceci est modelé en utilisant l'insolation solaire du module solaire (Bloc 201), la réflectivité (R), l'absorptivité (A), la transmissivité (T) de l'atmosphère et des nuages et l'albédo ($\alpha$). À l'équilibre énergétique, A+R+T=1 avec A, R et T, des paramètres évoluant en fonction du climat. Le dénominateur prend en compte l'absorption et la réflexion du rayonnement par la surface de multiples fois selon:

$$S_s \downarrow = S_{h,\text{day}} \cdot \frac{T(1-\alpha)}{\alpha.\,\text{R}}$$

L'albédo est déterminé à partir du Carbontracker pour les océans et l'atmosphère, à partir du nouveau module biosphère pour la surface terrestre et est validé par les observations satellites. Son calcul est important car il varie principalement en fonction de la nébulosité, de la neige, de la glace, de la surface foliaire et des changements de couverture terrestre.

La méthode de mesure selon l'invention améliore également le calcul du rayonnement ondes-courtes en ajoutant l'influence du trou de la couche d'ozone car l'ozone est un excellent absorbeur de rayons UV. En 1970, on a découvert que l'ozone est détruit par des radicaux dont l'hydrogène, l'azote, le chlore et le brome. Avec l'épuisement de la couche d'ozone, le filtre de protection prévu par l'atmosphère est progressivement réduit. Pendant la période du solstice d'hiver, le trou de la couche d'ozone est principalement situé au-dessus de l'Antarctique et l'augmentation de l'insolation sur ce pôle a fortement contribué à l'augmentation du rayonnement ondes-courtes aggravant le réchauffement. L'ozone est un indicateur clé intégré dans la méthode pour mesurer cette augmentation et est calculé avec sa transmissivité $T_{O3}$ selon Tripathi et al. (2000):

$$\text{T}_{O3} = \text{e}^{-\alpha\mu\Omega}$$

Où $\alpha$ est le coefficient d'absorption de l'ozone, $\mu$ est le ratio des longueurs des chemins actuels et verticaux à travers la couche d'ozone et $\Omega$ est la concentration en ozone.

Pour atteindre l'équilibre climatique, l'énergie solaire incidente absorbée par le système terre/atmosphère est contrebalancé par un montant égal d'énergie IR thermique émis (Fig. 12). La terre a une atmosphère qui absorbe et émet un rayonnement ondes-longues et cet effet de serre sert à maintenir la chaleur près de la surface. L'absorption est dépendante de la longueur d'onde et est déterminé par la composition atmosphérique, les nuages, les aérosols et les concentrations de GES. Le traitement du rayonnement ondes-longues s'appuie sur l'équation de Schwartzschild selon Washington et al. (2005) et prend en compte l'absorption et l'émission avec les lois de Lambert et de Kirchhoff avec le changement d'intensité de radiation exprimé selon:

$$dI = -Ik\rho dz + B(T)k\rho dz$$

où k est le coefficient d'absorption, $\rho$ est la densité du médium et B(T) est la fonction de Planck. L'intégration sur tous les angles de l'hémisphère sur une surface horizontale transforme les intensités en flux ascendants et descendants. La simplification du modèle est effectuée en utilisant la méthode d'émissivité dans laquelle l'intégration sur de relativement larges bandes résulte dans le calcul des flux ascendants $F_s\uparrow$ et descendants $F_s\downarrow$ avec les émissivités s' et $\varepsilon$ qui sont fonctions de la vapeur d'eau, de la pression et de la température sur le chemin que traverse le rayonnement. L'influence des GES tels que l'O3, CH4, N02 et CO2 est également modélisée dans l'absorption (A).

$$F_s\uparrow(z) = \pi B(0) + \int_0^z \varepsilon'(z,z')d(\pi B(z')) \quad ; \quad F_s\downarrow(z) = \pi B(z_o)\varepsilon(z,\infty) + \int_{zo}^z \varepsilon'(z,z')d(\pi B(z'))$$

$$\varepsilon'(z,z') = \sum_i A_i(z,z')\frac{dB_i(z')}{dB(z')} \; ; \; \varepsilon(z,z') = \sum_i A_i(z,z')\frac{B_i(z')}{B(z')}$$

Le sol, la surface et l'atmosphère échangent de la chaleur par contact direct entre la surface et l'air (chaleur sensible $H_s\uparrow$), par l'évaporation et la transpiration (chaleur latente $L_vE\uparrow$) calculés selon la méthode utilisée par Xing et al. (2007) et par absorption dans le sol (conduction $G_s\downarrow$) selon la loi générale de Fick. Sans transfert de chaleur latente et sensible, la surface de la terre aurait une température beaucoup plus élevée. Lorsque l'évaporation prend place à la surface, la chaleur latente nécessaire à la phase de transition est prise hors de la surface résultant d'un refroidissement. Lors de la formation des nuages, la vapeur d'eau condense et la chaleur latente est libérée dans l'atmosphère. Ceci conduit à un transfert net de chaleur de la surface à l'atmosphère, l'un des principaux moteurs de la circulation atmosphérique. Le ratio des chaleurs sensibles et latentes est appelé Bowen ratio ($B_o = H_s/LvE$). Le flux de conduction advient sur des surfaces solides telles que le sol et la glace et pour l'océan, il est lié à la dynamique de mélange des couches océaniques.

$$H_s\uparrow = \rho_a c_p c_h \frac{\partial T}{\partial z} \quad ; \quad LvE\uparrow = \frac{\varepsilon\rho}{P}L_v c_l \frac{\partial e}{\partial z} \quad ; \quad G_s\downarrow = \chi\frac{\partial T}{\partial z}$$

où $c_p$ est la capacité thermique spécifique de l'air, $\rho_a$ la densité de l'air, $c_h$ le coefficient de transfert turbulent de chaleur, T la température, z la hauteur, $L_v$ la chaleur latente de vaporisation, e la pression de la vapeur de l'air, $\varepsilon$ le ratio des poids moléculaires d'air humide et sec, $c_l$ le coefficient de transfert de vapeur d'eau et $\chi$ la conductivité thermique du médium.

L'inclusion des composantes de flux ondes-courtes et ondes-longues avec $C_s$ la capacité thermique de la couche de surface permet de calculer le budget radiatif à la surface du globe.

$$C_s\frac{\partial T_s}{\partial t} = S_s\downarrow + F_s\downarrow - F_s\uparrow - H_s\uparrow - L_vE\uparrow - G_s\downarrow$$

A l'équilibre thermodynamique $C_s\partial T_s/\partial t = 0$, ce qui permet de calculer la température de surface $T_s$ pour déterminer son influence sur les océans et la biosphère. Le budget et ses composantes sont calculés en W/m2/jour sur des mailles 1°x1° et sont utilisés dans les modules océan et biosphère. Les modélisations météorologiques du module de transport atmosphérique (nuages, GES) sont intégrées dans le module énergétique pour la mise à jour des données. La mesure des paramètres in-situ de flux de chaleur, de rayonnement et de GES lors des observations (Bloc 100) permet de valider les données du module avec des mesures réelles. Le calcul du budget énergétique est initialisé au début de l'holocène avec une périodicité de 50 ans et un calcul global sur la planète.

**c. Module Océan**

Afin d'obtenir une absorption océanique plus précise, la méthode de mesure selon l'invention améliore le module actuel du Carbontracker en utilisant un module océan incluant l'addition du dégagement de CO2 par évaporation, l'absorption par altération chimique et l'effet de tampon (Bloc 203, Fig. 9).

Les océans sont les plus grands puits de carbone long-terme de part leur forte capacité de stockage et de redistribution au sein du système. La méthode de mesure selon l'invention modélise l'absorption principalement par la dissolution du CO2 atmosphérique entre l'air et les océans par la différence de pression partielle de CO2 (pCO2), la vitesse du vent et la température des eaux, ceci modifiant son équilibre carbonate vers un état plus acide. Elle modélise également le dégagement selon les températures locales, l'activité biologique, la vitesse du vent, et la circulation océanique. Les échanges de CO2 sont calculés à partir du transfert de masse :

$$F_{oce}(t) = F_{oce}(t) \uparrow - F_{oce}(t) \downarrow$$

Une augmentation de CO2 dans l'atmosphère provoque une augmentation de la pression partielle, ce qui accroît le taux auquel il se dissout dans l'eau. La pression partielle de CO2 obéit à la loi de Henry, où $K_o$ est le coefficient de solubilité du CO2 dans l'eau.

$$[CO2]_{eau\ de\ mer} \approx K_{o(S,T)} \cdot p_{CO2}(t)$$

Selon la loi de Fick, l'absorption océanique J est déterminée en calculant le flux de diffusion de CO2, généralement décrit comme le produit de la vélocité de transfert du gaz $k_w$ avec le gradient de concentration de CO2 de l'eau et de l'air marin. Il est également fonction de la profondeur $z_m$ de l'océan qui tient compte des eaux peu profondes particulièrement près des cotes.

$$J = \frac{k_w}{z_m}([CO2]_{saturé} - [CO2]_{eau\ de\ mer})$$

La variabilité spatiale et temporelle de l'échange air-mer de CO2 dépend ainsi de la distribution de la vitesse du vent, de la température, de la concentration de CO2 dissous et de la solubilité $K_o$. Cette absorption est calculée dans la méthode en utilisant la différence de pression partielle de CO2 entre l'air et l'océan combinée avec une vitesse de transfert du gaz. Les niveaux de pCO2 sont déterminés en utilisant différentes configurations du modèle Princeton/GFDL MOM3, puis en divisant par une vitesse de transfert des gaz calculée selon les prévisions du modèle météorologique ECMWF (European Center for Medium-Range Weather Forecast), ERA40, intégrées dans le module de transport (Bloc 400). La vitesse de transfert du gaz est paramétrée comme une fonction quadratique de la vitesse du vent, en utilisant la formulation des vents instantanés. Le transfert air-mer est entravé par la présence de glace et les flux sont redimensionnés dans chaque grille par la fraction quotidienne de glace fournie par les prévisions de données du ECMWF.

Une augmentation de concentration de CO2 dans l'atmosphère entraîne une augmentation de la quantité de CO2 absorbée par les océans, qui diminue progressivement. La méthode ajoute cette réduction de la capacité tampon du système par la méthode de Wolf-Gladrow (1994). La somme des espèces carbonates dissoutes est définie comme le total de carbone inorganique dissous [DIC]. Le CO2 dans l'océan forme un acide carbonique faible, le H2CO3 qui se dissocie sous la forme dominante de carbone inorganique stocké, l'ion bicarbonate HCO3- puis en ion carbonate CO3$^{2-}$ avec $K_1$ = [HCO3-][H$^+$]/[CO2$_{(aq)}$] et $K_2$ = [CO3$^{2-}$][H$^+$]/[HCO3-], les constantes de dissociation selon :

$$CO2_{(aq)} + H2O_{(l)} \rightarrow H2CO3_{(aq)} \overset{K1}{\rightleftarrows} H^+ + HCO3^- \overset{K2}{\rightleftarrows} 2H^+ + CO3^{2-}$$

La concentration de CO2 dans l'océan est tributaire de la solubilité et de la pression partielle du CO2 dans l'atmosphère et le total [DIC] en solution est déduit à partir des constantes de dissociation et de la concentration en ions hydrogènes.

$$[DIC] = \sum CO2 = [CO2] + [HCO3^-] + [CO3^{2-}] \approx p_{CO2}(t).K_{o(S,T)}\left(1 + \frac{K_1}{[H^+]} + \frac{K_1.K_2}{[H^+]^2}\right)$$

La fraction du flux de CO2 de l'atmosphère vers la couche de mélange qui va réagir est fonction du facteur tampon $\zeta$, qui est la fraction de changement de CO2 atmosphérique divisé par la fraction de changement de [DIC] après établissement de l'équilibre. $\zeta$ dépend de la température, du [DIC], de la salinité et de l'alcalinité ($Alk \approx [HCO3^-] + 2[CO3^-] + [OH^-] + [B(OH)^{4-}]-[H^+]$).

$$\zeta = \left(\frac{\partial[CO2]}{[CO2]}\right)_{atm} / \left(\frac{\partial[DIC]}{[DIC]}\right)_{eau\ de\ mer}$$

Suivant la méthode de Trenbeth (1992), le flux est corrigé selon l'équation suivante :

$$J = \zeta\frac{[CO2]_{eau\ de\ mer}}{[DIC]}.\frac{k_w}{z_m}.([CO2]_{saturé} - [CO2]_{eau\ de\ mer})$$

La méthode ajoute également une absorption induite par l'altération chimique du CO2 où l'altération des roches sur la surface continentale consomme du CO2 atmosphérique pour produire de l'alcalinité. L'alcalinité est ensuite transportée par les fleuves et les rivières et précipitée en carbonate dans les océans, qui sont déposés par sédimentation. Cette altération est intégrée suivant le modèle global CDIAC DB1012 de résolution 1°x1° de Suchet et al. (1995) qui contient des estimations du flux net surface/atmosphère de CO2 (moles/km2/an) ainsi que du transport de bicarbonate (HCO3-) des rivières à l'océan. Le modèle est fondé sur un ensemble de relations empiriques entre le flux de CO2 ($F_{CO2alt}$) et le ruissellement sur les principaux types de roches affleurant les continents. L'absorption océanique est modélisée selon:

$$F_{oce}(t)\downarrow \approx \zeta\frac{[CO2]_{eau\ de\ mer}}{[DIC]}.\frac{k_w}{z_m}.([CO2]_{saturé} - [CO2]_{eau\ de\ mer}) + F_{CO2alt.}$$

La méthode complète également le module océan avec l'évaporation de CO2. Combiné avec le carbonate de calcium insoluble, la réaction de dissolution du CO2 produit une solution de bicarbonate de calcium Ca(HC03)2, qui s'accumule dans les océans.

$$H2CO3_{(acide\ faible)} + CaCO3_{(calcaire)} \rightarrow Ca(HCO3)_{2(solution)}$$

A la surface des océans, le vent et la marée provoquent des vagues et des embruns, accompagnés de fines pulvérisations et de mousse. Le rayonnement solaire incident crée directement un rayonnement IR par chaleur latente, ce qui provoque une hausse des températures océaniques et l'évaporation de ces pulvérisations et de la mousse. La vapeur d'eau est en outre décomposée en précipitations et dégagement de chaleur latente.

$$Chaleur\ latente + Ca(HCO3)2_{(solution)} \rightarrow CaCO3_{(calcaire)} + CO2_{(gaz)} + H20_{(vapeur)}$$

$$H20_{(vapeur)} \rightarrow H20_{(liquide)} + Chaleur\ latente$$

Dans l'océan, la forme dominante de carbone inorganique stocké est l'ion bicarbonate. En solution de Ca(HC03)2, deux molécules HCO3- stockent une molécule de CO2 et le montant $K_c$ de CO2 stocké qui peut être potentiellement libéré par évaporation est $Kc = [HCO3^-]/2 \cdot M_{CO2}$ La concentration de CO2 stockée en Ca(HCO3)2 et libérable par évaporation est également plus élevée que la concentration de CO2 en solution. Il est considéré que le taux moyen d'évaporation sur l'eau est plus important que sur terre ayant moins d'eau exposée. Les observations IR spectrales par satellite indiquent également que presque tous les rayonnements IR émis par les océans proviennent de la vapeur d'eau au dessus de la surface (chaleur latente). A l'équilibre radiatif, il est supposé que presque 100% du rayonnement solaire absorbé par les océans provoque l'évaporation d'eau. Avec une fraction couverte d'environ 70,8%, la fraction d'énergie solaire qui évapore l'eau des océans est considérée équivalente à $F_p \approx 0.7$. La chaleur latente est déterminée à partir de l'équation du module énergétique (Bloc 202) selon:

$$L_v E \uparrow = F_p (S_s \downarrow + F_s \downarrow - F_s \uparrow - H_s \uparrow - G_s \downarrow)$$

Il est également supposé que presque toute l'évaporation de la surface de l'océan est due à celle d'embruns ou de mousse des vagues, soit $F_s \approx 1$. Afin d'évaluer la libération de CO2 avec le taux d'évaporation E à température d'eau constante, E est proportionnelle aux rayonnements et à $L_v$, la chaleur latente de vaporisation. La méthode peut évaluer le dégagement par évaporation selon la proportion suivante:

$$F_{eva}(t) \uparrow \approx E.Kc.Fs \approx (S_s \downarrow + I_s \downarrow - I_s \uparrow - H_s \uparrow - G_s \downarrow).\frac{Fp}{Lv}.Kc.Fs$$

L'absorption des océans est ainsi principalement induite par l'augmentation de concentration atmosphérique de CO2, leur capacité de tampon, l'altération chimique et l'évaporation qui est influencée par l'insolation solaire.

$$F_{oce}(t) \approx (S_s \downarrow + I_s \downarrow - I_s \uparrow - H_s \uparrow - G_s$$
$$\downarrow).\frac{Fp}{Lv}.Kc.Fs - \left( \zeta \frac{[CO2]_{eau\,de\,mer}}{[DIC]}.\frac{k_w}{z_m}.([CO2]_{saturé} - [CO2]_{eau\,de\,mer}) \right.$$
$$\left. + F_{CO2alt} \right)$$

Le résultat du module océan est une cartographie des échanges océaniques 5°x4° en PgC/mois. La mesure des paramètres océaniques in-situ des observations marines (Bloc 104) (pCO2 océan, pression atmosphérique, salinité, température) permet de valider les données du module avec des mesures réelles. Le calcul du flux océanique est initialisé au début de l'holocène avec une périodicité de 50 ans et un calcul global sur la planète.

**d. Module Biosphère**

Les échanges air/biosphère sont traités par le modèle biosphère JSBACH de Raddatz et al. (2007) (Bloc 204, Fig. 9) à la place du modèle CASA utilisé par le Carbontracker. JSBACH a notamment l'avantage de traiter les changements anthropiques de couverture de surface terrestre. L'absorption de CO2 est régie par la photosynthèse et le dégagement par les respirations et les perturbations. Les échanges de CO2 sont modélisés à partir du transfert de masse.
Les plantes absorbent le CO2 lors de la photosynthèse par diffusion au sein des stomates qui sont les pores des feuilles et des tiges par lesquels le CO2 est pris et converti sous l'influence de rayonnement actif visible en hydrates de carbone.

$$6\,CO2 + 12\,H2O \xrightarrow{lumière\,du\,soleil} C6H12O6 + 6\,O2 + 6H2O$$

Les facteurs biotiques affectant la photosynthèse incluent la forme de croissance, le type de feuille, la voie photosynthétique (C3, C4) et la longévité. C3 est la photosynthèse de la plupart des plantes alors que C4 est une adaptation à des conditions arides avec une meilleure utilisation de l'eau. Les types de végétation sont modélisés en utilisant différents types fonctionnels de plantes (PFT, Plant Functional Types) et une représentation des différents biomes (forêts, arbustes, tourbières, prairies C3 et C4, marais, toundra, terres cultivées, glaciers...). La photosynthèse est modelée par les équations décrivant les flux d'émissions de CO2 et de vapeur d'eau au niveau de la feuille et redimensionnée à la canopée. L'indice foliaire est calculé comme le ratio de surface supérieure totale des feuilles de la végétation divisé par la superficie de la surface sur laquelle elle croît.

$$\Lambda = \frac{surface\,folière\,totale}{surface\,du\,sol}$$

La surface foliaire est calculée interactivement avec le climat et les saisons de croissance et de décroissance sont modélisées selon:

$$\frac{d\Lambda}{dt} = k\left(1 - \frac{\Lambda}{\Lambda_{max}}\right)\Lambda - p\Lambda$$

Où k est le taux de croissance avec k=0 pour NPP ≤0 et k≥0 lorsque NPP ≥0 et pΛ est le taux de décroissance (perte des feuilles). La lumière influence la photosynthèse de la canopée et varie en fonction de son architecture lors de son passage. La fraction de surface ombragée $f_{ombre}$ est déduite de la relation Beer-Lambert avec une orientation aléatoire des feuilles.

$$f_{ombre} = 1 - e^{-\frac{\Lambda}{2}}$$

L'albédo est calculé en fonction de l'indice foliaire variant avec les saisons et l'enneigement.

$$a_{canopée} = f_{ombre}a_{veg} + (1 - f_{ombre})a_{surface}$$

La distribution verticale de rayonnement photosynthétiquement actif (PAR) est calculé en utilisant la radiation ondes-courtes du module énergétique (Bloc 202):

$$I = I\uparrow + I\downarrow + S_s\downarrow e^{-K\Lambda_z}$$

Où I↑, I↓, sont les rayonnements diffus ascendants et descendants dans la canopée, $S_{s\downarrow}$ est le rayonnement incident sur le haut de la canopée, K est le chemin optique du rayon direct, fonction de la distribution des feuilles et $\Lambda_z$ est l'indice foliaire mesuré du haut de la canopée. Le taux d'assimilation (A) de CO2 est modélisé comme le minimum du taux de carboxylation (Jc) et de transfert d'électrons (Je). La méthode complète JSBACH avec une limitation par le taux de photosynthèse brute (Js) limité par la capacité à transporter les produits photosynthétiques pour les plantes C3 et la capacité de CO2 limitée pour les plantes C4 selon :

$$A = min\{J_c, J_e, J_s\}$$

$$J_c = V_m\left(\frac{c_i - \Gamma_*}{c_i - K_m}\right) \; ; \; J_e = \frac{1}{4}\left(\frac{c_i - \Gamma_*}{c_i - 2\Gamma_*}\right) \text{ avec } J = \alpha I\frac{J_m}{\sqrt{J_m^2 + \alpha^2 I^2}} \; ; \; J_s = \begin{cases} 0.5V_m \\ 2.10^4 * V_m * \frac{c_i}{p} \end{cases}$$

où $c_i$ est la pression partielle de CO2 dans le chloroplaste, $\Gamma_*$ la pression partielle de compensation photorespiratoire de CO2, $V_m$ le taux maximum photosynthétique d'activité Rubisco, $K_m$ la constante de Michaelis-Menten, J le taux potentiel de transport d'électrons, $J_m$ le potentiel maximum de photosynthèse limité par saturation de lumière et fonction de l'azote de la feuille, I le rayonnement solaire pénétrant la feuille et p est la pression de l'air de surface. La Production Primaire Brute (GPP), soit la quantité de carbone fixé par photosynthèse est calculée selon:

$$GPP = A \bullet \Lambda$$

Les plantes relâchent du carbone, sous forme de respiration autotrophique, soit une oxydation des composés organiques en CO2 et H2O.

$$6CH2O + 6O2 \rightarrow 6CO2 + 6H2O + énergie$$

Le montant de carbone absorbé par les plantes et incorporé dans de nouveaux tissus végétaux est appelé Production Primaire Nette (NPP) et comprend les augmentations de la biomasse dans les feuilles, tiges, branches, racines, et organes de reproduction. La partie restante est perdue par respiration autotrophique ($R_a$) incluant respiration de maintenance ($R_m$) et de croissance ($R_g$). $R_m$ sert à garder les tissus en vie et est une fonction de l'indice foliaire et de la respiration sombre. $R_g$ sert à synthétiser de nouveaux matériaux et est corrélée avec la croissance totale des plantes.

$$R_m = f_{feuille}^{-1} R_{respiration\ sombre} \cdot \Lambda$$

$$CC_{coûts\ de\ construction} = \frac{NPP + R_g}{NPP}$$

$$NPP = GPP - R_a = GPP - R_m - R_g$$

La plupart du carbone fixé par NPP retourne à l'atmosphère par respiration hétérotrophique du sol ($R_h$) qui est la décomposition des matières organiques par des bactéries et des champignons. Elle est fortement dépendante de la température du sol lorsque l'humidité est disponible et est calculée en utilisant le coefficient thermique Q10 du sol, en intégrant la taille du réservoir de carbone avec l'humidité $\alpha$ et le temps de renouvellement $\tau$ à 10°c.

$$\frac{dC}{dt} = -\alpha . Q_{10}^{T_{sol}/10°c} \frac{C}{\tau}$$

Les données écologiques suggèrent que la respiration du sol et la NPP sont corrélées positivement l'une avec l'autre. Une forte productivité primaire nette produit plus de litière, ce qui encourage plus de décomposition et de respiration, favorise la minéralisation et produit plus d'azote pour la croissance des plantes. Ce carbone du sol est partitionné en réservoir vert, réservoir de bois et réservoir de réserve avec différentes teneur en carbone, compositions chimiques et compositions en bactéries et champignons selon:

$$\frac{dC_G}{dt} = NPP_{\triangleright G} - F_{Litière}\ (Réservoir\ vert)$$

$$\frac{dC_W}{dt} = NPP_{\triangleright W} - \frac{C_W}{\tau_W}\ (Réservoir\ de\ bois)$$

$$\frac{dC_R}{dt} = NPP_{\triangleright R} - \frac{C_R}{\tau_R}\ (Réservoir\ de\ réserve)$$

Ces réservoirs libèrent le CO2 dans un réservoir avec un court (1 an) et un long (100 ans) temps de renouvellement, ceci conduisant au calcul de la productivité nette des écosystèmes (NEP) qui représente la quantité de carbone annuellement stockée dans la biosphère terrestre.

$$\frac{dC_F}{dt} = \frac{C_R}{\tau_R} + F_{Litière} - R_F \ \text{où} \ R_F = \alpha^k . Q_{10}^{T_{sol}/10°c} \frac{C_F}{\tau_F}\ (Réservoir\ rapide)$$

$$\frac{dC_S}{dt} = \frac{C_W}{\tau_W} + (1 - f_{F \triangleright A})R_F - R_S \ \text{où} \ R_S = \alpha^k . Q_{10}^{T_{sol}/10°c} \frac{C_S}{\tau_S}\ (Réservoir\ lent)$$

$$NEP = NPP- Rh = A \bullet \Lambda - R_m - R_g - R_F - R_S$$

La production nette de la biosphère (NBP) est formalisée en intégrant les perturbations telles que les incendies et les changements dus à l'utilisation des sols. Le module incendie (Bloc 205) prend en compte les incendies et est intégré à JSBACH. Les perturbations liées à l'utilisation anthropique des sols (ALCC, Anthropogenic Land Cover Change) sont calculées selon la méthode de Pongratz (2009) depuis le dernier millénaire. Les manipulations de la surface des terres sont essentiellement causées par l'expansion ou l'abandon de la superficie agricole, incluant terres cultivées et pâturages qui modifient la couverture des sols et altère l'absorption de la biosphère. L'urbanisation influence également le climat via une demande alimentaire et en énergies de substitution (biocarburants) croissante de la population, augmentant la demande en zones agricoles. Les forêts, herbes naturelles et zones arborées sont aussi touchées par cette expansion agricole. Le montant de carbone de ces perturbations émis directement dans l'atmosphère par les trois réservoirs de végétation est traité comme suit:

$$F_{\triangleright A} = \sum_{i \in a-} (c_i^{ancien} - c_i^{nouveau}) \left( f_{G \triangleright A}.C_{G,i} + f_{W \triangleright A}.C_{G,i} + f_{R \triangleright A}.C_{R,i} \right)$$

Où $f_{G \triangleright A}$, $f_{W \triangleright A}$, et $f_{R \triangleright A}$ sont les fractions de carbone ALCC relâchées dans l'atmosphère en fonction des trois réservoirs de carbone (vert, bois et réserve), $c_i^{ancien} - c_i^{nouveau}$ est la variation quotidienne de changement de la fraction de couverture pour chaque type fonctionnel de plante qui perd la surface (a-) due au changement anthropique de couverture des terres et $C_{G,i}$, $C_{W,i}$ et $C_{R,i}$ sont les densités de carbone des trois réservoirs. Pour la réallocation du carbone dans les réservoirs rapides et lents, le carbone des réservoirs vert et de réserve est transféré dans le réservoir rapide, tandis que le réservoir de carbone du bois est transféré au réservoir lent selon :

$$F_{\triangleright F} = \sum_{i \in a-}(c_i^{ancien} - c_i^{nouveau}) \left( (1 - f_{G \triangleright A}).C_{G,i} + (1 - f_{R \triangleright A}).C_{R,i} \right) \quad (R\acute{e}servoir \; rapide)$$

$$F_{\triangleright S} = \sum_{i \in a-}(c_i^{ancien} - c_i^{nouveau})(1 - f_{W \triangleright A}).C_{W,i} \quad (R\acute{e}servoir \; lent)$$

Le carbone de la végétation est perdu d'un PFT en raison de la diminution de sa surface, alors que les densités de carbone ne sont pas affectées. Le carbone perdu est ensuite transféré aux réservoirs de carbone respectifs du sol des PFT en expansion, distribuées proportionnellement à leurs nouvelles fractions de couverture et les densités de carbone de PFT sont ajustées en conséquence. La surface foliaire, la respiration autotrophique et l'albédo sont également modifiés en fonction de la modification des types de couverture des terres et de la végétation. La NBP représente le montant net d'absorption sur de longues périodes de temps en incluant les perturbations.

$$F_{bio}(t) = -NBP = -(GPP - R_a - R_h - perturbations)$$

Le résultat du module JSBACH est une cartographie des flux de la biosphère en Kg/m2/s avec un maillage 1°x1°. La mesure des paramètres in-situ des observations d'écosystèmes (Bloc 104) permet de valider les données du module avec des mesures réelles. Les mesures d'ALCC par les observations satellites (Bloc 101) sont intégrées afin de valider le changement de couverture des surfaces. Le flux de la biosphère est remonté pour l'initialisation depuis le début de l'holocène avec une périodicité de 50 ans et un calcul global sur la planète.

**e. Module Incendie**

Avant que l'homme n'ait utilisé les incendies pour défricher les terres et fertiliser les sols, la plupart des écosystèmes ont été soumis à des incendies naturels qui permettent de rajeunir les forêts anciennes et d'apporter des minéraux. Le module incendie est intégré à JSBACH pour estimer le flux des perturbations $F_{feu}(t)$ liées aux incendies (Bloc 205, Fig. 9). Les résultats sont calculés à partir de la base de données Global Fire Emission Database GFEDv2 de Randerson et al. (2007) et les données se composent de mesures 1°x1° des superficies brûlées maillées, des charges de carburant, de l'efficacité de combustion, et des émissions de GES incluant le CO2 (Kg/m2/mois). Après avoir estimé globalement les zones brûlées, la végétation évoluant saisonnièrement, les stocks de biomasse des sols de JSBACH sont brûlés en fonction de l'estimation de la superficie brûlée et convertis en émissions atmosphériques de GES en utilisant les estimations d'efficacité de combustion, de complétude et de charges de carburant. Les données du GFEDv2 sont calculées depuis 1997.

**f. Module Fossile**

Un nouveau module fossile (Bloc 206, Fig. 9) est intégré à la place du module fossile du Carbontracker pour mesurer les émissions globales venant de la production de combustibles fossiles afin de s'assurer que l'ensemble de la production soit prise en compte. Au cours des deux derniers siècles, suivant la révolution industrielle et l'augmentation de la population mondiale, la combustion d'énergie fossile est devenue la plus grande source anthropique de CO2 pour notamment la production d'électricité, le transport, le chauffage et les procédés industriels. Le taux de rejet du CO2 fossile est calculé en additionnant les contributions du charbon et du pétrole à partir des inventaires de production de l'Energy Information Administration (EIA) depuis 1990 :

$$F_{ff}(t) = F_{charbon}(t) + F_{pétrole}(t)$$

Le charbon est composé de près de 100% de carbone et en considérant que presque toute cette masse de carbone entre dans l'atmosphère, les émissions mondiales de charbon en CO2 sont obtenues en additionnant les productions des principaux producteurs:

$$F_{charbon}(t) \approx \text{Production de Charbon (millions tonnes/année)} \times \frac{M_{CO2}}{M_C}$$

Le pétrole se compose de chaînes carbonées avec pour chaque atome de carbone environ 2 atomes d'hydrogène joints, soit environ 86% de carbone. La production annuelle mondiale de pétrole est obtenue en additionnant la production journalière en barils. Il est à noter que tout le carbone n'est pas rejeté dans l'atmosphère et qu'une partie est utilisée pour produire de l'asphalte et des résines. Toutefois, cette partie non-atmosphérique est très probablement compensée par la production de combustibles fossiles non déclarée, en particulier celle du charbon.

$$F_{pétrole}(t) \approx \text{Production de pétrôle (millions tonnes/année)} \times 86\% \times \frac{M_{CO2}}{M_C}$$

Le calcul des données du module fossile est remonté depuis le début de l'ère industrielle jusqu'à 1800 selon les estimations de productions de Etemad et al. (1991) afin d'obtenir une mesure de flux anthropiques fossiles à l'échelle planétaire sur l'ère industrielle en T/an.

**3. Module d'inventaires ascendants**

Suite à la modélisation de l'évolution des flux effectuée par le module d'échange, la méthode de mesure selon l'invention effectue ensuite une modélisation des émissions anthropiques hebdomadaires (Fig. 9, bloc 301), ou inventaires ascendants, au moyen d'un module d'inventaires ascendants.

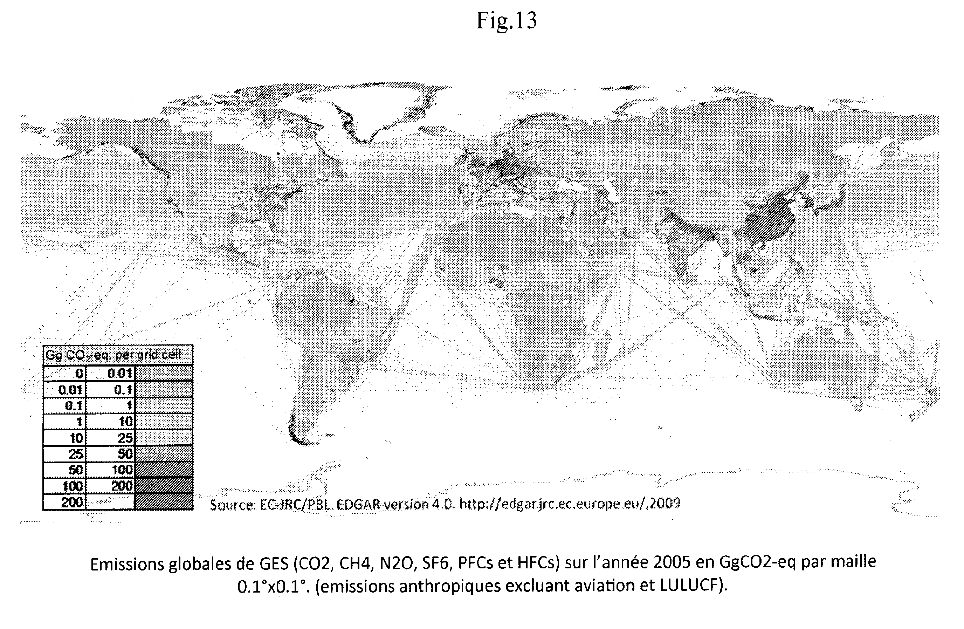

Ces inventaires ascendants sont utilisés comme des estimations à priori des flux anthropiques et proviennent du modèle EDGAR 4.0 http://edgar.jrc.ec.europa.eu/ de la Commission Européenne, Joint Research Centre (JRC) et du Netherlands Environmental Assessment Agency (PBL) (Bloc 300, Fig. 9). La répartition spatiale actuelle et en développement des émissions dans la série de données est effectuée en fonction des émissions annuelles déclarées pour la période 1970-2005 et incluent GES, gaz acidifiants et particules (CO2, CH4, N20, HFCs, PFCs, SF6, CO, NMVOC, S02, NOX, NH3, PM2.5, PM10, OC, BC, HCFC, CFC) (Fig. 13). Les inventaires ascendants sont déterminées en utilisant les données spécifiques de chaque pays qui sont organisés en régions du monde et les catégories principales de sources incluent: énergie, procédés industriels et usage de produit, agriculture, utilisation des terres, leur changement et la forêt, les déchets et autres sources anthropiques. Les inventaires ascendants d'émissions sont calculés pour chaque secteur et pays avec un facteur d'émission basé sur la technologie. Les données des paramètres de l'équation suivante sont inclues pour chaque combinaison pays/secteur considérée:

$$Emission_{x,c}(an)$$

$$= \sum \{AD_{c,s}(an) * TECH_{AD,c,s}(an) * EOP_{AD,c,s,TECH}(an)\} * EF_{AD,c,s,TECH} * (1 - RED_{EOP})$$

où (x) est le composé,(c) le pays, (s) le secteur, (an) l'année, (AD) la donnée d'activité en TJ/an (ex : charbon utilisé dans un pays pour la production de chaleur), (TECH) la technologie, (EOP) le pourcentage des technologies qui sont contrôlées par des mesures de réduction, (EF) le facteur d'émission incontrôlé par secteur et technologie en KT/TJ et (RED) la réduction en pourcentage du facteur d'émission incontrôlé par la mesure de réduction. Ces données sont en partie fondées sur les rapports d'inventaires, les rapports industriels, les directives d'inventaires et la littérature scientifique. Les inventaires ascendants d'émissions par pays sont allouées sur une grille spatiale de haute résolution 0.1°x0.1° ($\approx$100km$^2$) qui peut être agrandie à de plus faibles résolutions de 0.5°x0.5° à 1°x1° et sont intégrées aux différentes résolutions en utilisant les techniques de GIS (Geographic Information System) pour la conversion, le ré-échantillonnage et l'agrégation. Chaque grille spatiale est liée avec la grille du pays de référence construite sur la base de données des «populations maillées du monde» (GPWv3). La répartition des émissions par secteur pour chaque cellule d'un pays est effectuée selon:

$$F_{ff}(x,y,t) = Emission(x_i,y_i)_{AD,C,an} = Emission(C)_{AD,an} \times \frac{Indicateur(x_i,y_i)_{AD,c,an}}{\sum Indicateur(x,y)_{AD,c,an}}$$

Le couple ($x_i$, $y_i$) représente le coin inférieur gauche de chaque maille 0.1, (AD) la donnée d'activité (ex: gaz naturel d'une centrale électrique), (C) le pays, (an) l'année et l'indicateur de grille spatiale. La méthode modélise en outre la variabilité temporelle de ces inventaires (Bloc 302) selon le modèle de Gurney (2009) pour les Etats-Unis qui est étendu sur le reste du monde avec l'équation de Gurney (2005) avant que les saisonnalités de Gurney (2009) ne soient disponibles à l'échelle mondiale:

$$F_{i,j,m}^n = F_{i,j,m}^o + A_k F_{i,j,m}^o \sin \theta_j \cos\left(\frac{2\pi(m-1)}{12}\right)$$

où $F_{i,j,m}^n$, est le nouveau flux sur chaque cellule de la grille en utilisant, (i) l'index de longitude, (j) l'index de latitude et (m) l'index du mois. $F_{i,j,m}^o$ est le flux original et ($A_k$) est le facteur d'amplitude qui représente le pourcentage d'accroissement des émissions fossiles d'origine. Ces saisonnalités permettent une décomposition temporelle des inventaires effectuée sur une base hebdomadaire. La méthode utilise ces inventaires dans le module de transport avec une résolution 1°x1° en Kg/m2/semaine et ces résultats sont redimensionnés sur l'année en cours proportionnellement aux totaux du module fossile pour obtenir la même base étalonnée.

**4. Module de transport**

Suite à la modélisation des émissions anthropiques, la méthode de mesure selon l'invention effectue ensuite une modélisation du transport atmosphérique (fig.9, bloc 401) au moyen d'un module de transport.

La méthode peut utiliser pour simuler les vents et le climat, le modèle de transport TM5 décrit par Krol et al. (2005) piloté par le modèle de prévisions météorologiques du European Center for Medium range Weather Forecast (ECMWF). Le transport du CO2 dans l'atmosphère (Bloc 400, Fig. 9) permet de lier les observations de CO2 des différentes couches de l'atmosphère (Bloc 100) aux flux de CO2 à la surface terrestre (Bloc 200, Bloc 300). Les tempêtes, complexes nuageux et conditions météorologiques sont à l'origine de vents qui transportent le CO2 et l'influence de dégagements, d'absorptions et d'événements locaux peuvent avoir des impacts à des endroits éloignés. Ce modèle complexe en 3D simule les concentrations de CO2 dans l'atmosphère à partir des flux en utilisant les champs de prévisions météorologiques de l'ECMWF. C'est un modèle de zoom atmosphérique à grilles imbriquées dont les régions pour lesquelles les simulations de haute résolution sont souhaitées peuvent être imbriquées dans une grille couvrant le domaine global. Il a l'avantage d'effectuer des simulations de transport avec un focus régional sans la nécessité de mettre en place des conditions limites telles que dans d'autres modèles. Ceci permet aux mesures en dehors du domaine zoomé de contraindre les flux régionaux dans l'inversion et l'assimilation des données, et de s'assurer que les estimations régionales sont cohérentes avec les contraintes globales.

TM5 fonctionne à une résolution horizontale de 6°x4° et le zoom descend jusqu'à une résolution 1°x1° (Europe, Amérique du Nord, Amérique du Sud, Asie, Australie), zones qui sont imbriquées dans des régions 3°x2° pour assurer une transition en douceur entre les différents domaines. Le TM5 simule séparément l'advection, la convection et la diffusion verticale dans la couche limite planétaire et la troposphère. TM5 s'exécute sur un pas de temps de trois heures et les processus à plus fine échelle sont répétés toutes les 10 minutes (découpage et résolution raffinée dans les grilles imbriquées). La résolution verticale est de 25 niveaux hybrides de pression sigma, inégalement espacés avec plus de niveaux près de la surface. Le TM5 modélise les concentrations en ppm/s jusqu'à l'échelle 1°x1°. La mesure in-situ des paramètres météorologiques par les observations atmosphériques, marines et d'écosystème (Bloc 300) permet de valider la modélisation du TM5 et d'affiner sa paramétrisation.

## 5. Module d'inversion et d'assimilation de données

A la suite de ces modélisations, la méthode de mesure selon l'invention calcule ensuite des flux finaux au moyen d'un module d'inversion et d'assimilation de données (fig.14). Ce module (Bloc 500, Fig. 14) utilise les observations pour déduire la distribution spatiale 1°x1° des flux terrestres, océaniques et anthropiques. L'atmosphère est représentée par un vecteur d'état représentant le flux net surface-atmosphère à déterminer où $\lambda_r$ et $\lambda_{ff}$ représentent un ensemble de facteurs scalaires linéaires appliqués aux flux et estimés chaque semaine.

$$F_{CO2}(x,y,t) = \lambda_r.F_{bio}(x,y,t) + \lambda_r.F_{oce}(x,y,t) + \lambda_{ff}.F_{ff}(x,y,t) + F_{feu}(x,y,t)$$

Ce module combine une nouvelle inversion de synthèse (fonction de Green) (Bloc 501) simple et robuste pour l'analyse aux échelles régionales (planète, continents, régions continentales et pays), suivie par l'ensemble d'assimilation de données (Bloc 502) pour estimer les flux avec un niveau de détail plus précis sur les pays industrialisés ou les mesures 1°x1° sont souhaitées (ex : Europe, Amérique, Asie).

Une répartition géographique des surfaces du globe basée sur le modèle de décomposition DB1016 de Li (1990) est ajoutée pour agréger les émissions des mailles 1°x1° par régions et pays. Les champs de concentration et de flux sont amorcés avec une moyenne d'estimation dans le vecteur initial d'état à partir des équations du module d'échange et leur lancement depuis l'holocène permet d'obtenir une base étalonnée au temps des premières observations. Dans l'inversion et l'assimilation, le terme « à priori » ou « p » est réservé aux flux créés initialement et sont fixés, « a » se réfère aux quantités analysées des étapes précédentes, « b » ou « d'arrière-plan » sont les flux résultants et contiennent des informations tirées au fur et à mesure des analyses de cycles antérieurs et les flux « à posteriori » sont les flux finaux. Les flux à priori sont donc redimensionnés par ce module dans lequel les observations sont utilisées pour déduire les flux à posteriori. La méthode définit un critère d'optimalité avec une fonction de coût qui est minimisée afin que le processus de modélisation soit comparable à celui de l'atmosphère sur une échelle moyenne de temps et d'espace. Les estimations sont affinées au fur et à mesure des observations et les valeurs uniques de $\lambda_r$ et de $\lambda_{ff}$ résultent de la plus petite différence aux moindres carrés entre observations et modélisations.

Pour la classification des surfaces, chaque facteur $\lambda_r$ est associé à une région (r) particulière du domaine global. L'océan est divisé en 30 grands bassins océaniques englobant les caractéristiques de circulation et la biosphère est divisée en fonction des types d'écosystème ainsi que de leur situation géographique. Chacune des 11 régions TransCom de la terre contient un maximum de 19 types d'écosystèmes et l'approche conduit à un nombre total de r=11x19+30=239 facteurs d'échelle $\lambda_r$ optimisables chaque semaine sur le globe. Même avec un seul paramètre $\lambda_r$ disponible à l'échelle, chaque grille 1°x1° a un flux F(x,y,t) différent selon la moyenne des flux modelés par les modules océan et biosphère. Les flux liés aux incendies ne sont pas redimensionnés.

La méthode peut ajouter le paramètre $\lambda_{ff}$ au Carbontracker afin de redimensionner les résultats du module d'inventaires ascendants (Bloc 300). Chaque $\lambda_{ff}$ est apposé sur les émissions à priori et est optimisable sur chaque grille 1°x1° en fonction de la corrélation entre les observations effectuées et les flux anthropiques d'origine. Ceci est motivé par le fait que la distribution géographique des émissions à priori est bien connue dans le module d'inventaires ascendants. La qualité du module d'échange et la densité des observations avec notamment la couverture, la résolution et la précision des observations satellites, permettent de contraindre spatialement les flux naturels et de distinguer la composante anthropique. De plus, l'analyse de la variabilité spatiale et temporelle entre les estimations individuelles des sources de flux permet de déduire la composante anthropique qui est obtenue des différences modélisées entre les océans, la biosphère et les incendies. Les flux naturels ont une variabilité plus forte et corrélée, alors que les flux anthropiques ont des variations plus faibles et ne sont pas corrélés. De larges fluctuations interannuelles reflètent les échanges naturels des écosystèmes terrestres induits par les évolutions météorologiques et climatiques à grande échelle et ne sont pas expliquées par la variabilité des émissions fossiles. Ces corrélations permettent d'évaluer lorsque les émissions sont liées à des sources anthropiques ou naturelles et l'échantillonnage géographique affine cette distinction en réduisant les échelles progressivement.

Dans le module, le principe de comparaison entre les observations, le module d'échange et le module d'inventaires ascendants est le même pour les observations aériennes, atmosphériques, d'écosystèmes et marines que dans le Carbontracker. Pour comparer les observations de concentrations aux flux, le TM5 prend une distribution initiale de concentrations de CO2 et la propage vers l'avant dans le temps en utilisant les prévisions météorologiques tout en altérant les concentrations à la surface par les flux à optimiser. Cette distribution est ensuite, comparée aux temps et lieux des observations. La comparaison des observations de flux aux flux modélisés est effectuée tel que pour Ameriflux dans le Carbontracker. Les modélisations de flux sont intégrées aux temps et lieux des observations de flux et l'inversion et l'assimilation permet de minimiser les différences entre les flux modélisés et ceux observés.

La méthode peut ajouter toutefois une modification pour les données satellites XCO2 de GOSAT suivant la méthode de Feng et al. (2009). Les champs de concentration en 3D sont modelés par le TM5 à partir du module d'échange et des inventaires ascendants puis intégrés aux temps et lieux des observations pour chaque mesure en utilisant leurs orbites. Des fonctions de probabilité de densité (PDFs) des nuages et des profondeurs optiques des aérosols (AODs) sont dérivées pour récupérer les données à ciel-clair et la comparaison des flux de surface avec les données XCO2 est effectuée ensuite en appliquant des noyaux moyennant (Column Averaging Kernels) pour prendre en compte la sensibilité verticale de chaque satellite et cartographier les profils de concentration 1-D CO2 aux colonnes moyennes observées. Pour la comparaison avec les observations de XCO2 de SCIAMACHY, la méthode peut s'appuyer sur Buchwitz et al. (2005a) qui permet sur le même principe, l'obtention des colonnes moyennes par l'utilisation de noyaux moyennant.

**• Inversion de synthèse (Fonction de Green)**

L'inversion de synthèse est effectuée suivant la méthode d'Enting (2002) pour optimiser les émissions des grandes régions. Seuls les totaux régionaux sont calculés par la somme des flux des mailles 1°x1° et la fraction atmosphérique de CO2 est représentée comme une combinaison linéaire de lancements de modèle pour les émissions des différentes régions et des différentes semaines. La liste des symboles utilisés est la suivante :

| Symbole | Nom | Unité | Dimension |
|---|---|---|---|
| s | Vecteur d'état | kg/m2/s | [s] |
| z | Vecteur d'estimations à priori de s | kg/m2/s | [s] |
| m | Vecteur contenant les fractions molaires modelées | ppm | [m] |
| c | Vecteur contenant les observations | ppm | [m] |
| R | Matrice de covariance inverse des données d'observation | (ppm) 2 | [m] x [m] |
| P | Matrice de covariance inverse des paramètres à priori | (kg/m2/s)2 | [s] x [s] |
| $\mathcal{H}$ | Opérateur d'observation (TM5) | ppm → ppm | [m x m] |
| G | Matrice de Green | kg/m2/s → ppm | [m x s] |

La forme générale d'équation de transport du CO2 décrit le taux de changement avec le temps m(r, t), de la concentration atmosphérique modelée de CO2 à un point r et au temps t en fonction de la source locale s(r,t) à chaque point et de l'opérateur de transport $\mathcal{H}$ modélisant la contribution due au transport du gaz d'autres endroits et est sujette à des conditions limites spécifiques.

$$\frac{\partial}{\partial t}m(r, t) = s(r, t) + \mathcal{H}[m(r, t)]$$

Elle définit une relation linéaire entre les concentrations m(r,t) et les sources s(r,t) afin de résoudre l'équation des concentrations observées (c). La solution de cette équation par la fonction de Green avec des conditions limites spécifiques (t, t') et (r, r') est exprimée selon:

$$m(r,t) = m_o(r,t) + \int d^3r' \int G(r,t,r',t')s(r',t')dt'$$

Où $m_o(r,t)$ décrit l'état initial, $m(r,t_0)$, et la solution est calculée pour être équivalente à la solution d'intégration de $\partial m(r,t)/\partial t$. L'inversion de synthèse discrétise les sources en terme de processus $\mu$ comme des facteurs de dimensionnement $s_\mu$ inconnus, multipliés par la distribution de sources spécifiée $\sigma_\mu(r,t)$, appelées « fonctions de base »:

$$s_\mu(r,t) = s_\mu \sigma_\mu(r,t)$$

Ceci permet de relier les sources au module d'échange et au module d'inventaires ascendants pour chaque processus:

$$s(r,t) = \sum_\mu s_\mu(r,t) = \sum_\mu s_\mu \sigma_\mu(r,t)$$

$$= \lambda_r.F_{bio}(x,y,t) + \lambda_r.F_{oce}(x,y,t) + \lambda_{ff}.F_{ff}(x,y,t) + F_{fire}(x,y,t)$$

Puis à la fonction de Green tel que:

$$m(r,t) = \sum_\mu s_\mu G_\mu(r,t) \quad \text{avec} \quad G_\mu(r,t) = \int d^3r' \int dt' G(r,t,r',t')\sigma_\mu(r',t')$$

L'analyse formelle de la fonction de Green est exprimée de la relation générique discrétisée:

$$c_j = \sum_\mu G_{j\mu}s_\mu + \varepsilon_j = m_j + \varepsilon_j$$

où $c_j$ est un élément de concentration observée, $s_\mu$ est la source, $m_j$ est le modèle de prédiction de concentration pour cet élément, $\varepsilon_j$ est l'erreur dans $c_j$ et $G_{j\mu}$ est une discrétisation de $G(r,t,r',t')$ reliant les concentrations aux sources. Pour chaque fonction de base $\sigma_\mu(r,t)$, l'intégration du modèle de transport numérique produira une réponse $G_\mu(r,t)$. $G_{j\mu}$ sont les réponses pour l'observation j d'une source définie par la distribution $\sigma_\mu(r,t)$ et les sources sont estimées en utilisant cette équation pour ajuster les coefficients $s_\mu$ soit $\lambda_r$ et $\lambda_{ff}$. Cette fonction qui utilise des composantes prédéfinies $\sigma_\mu(r,t)$ est appelée calcul de synthèse car l'estimation de la source est synthétisée à partir des composantes prédéfinies. De ces intégrations, les valeurs spatiales et temporelles spécifiques qui correspondent à chaque observation j peuvent êtres extraites pour produire la matrice $G_{j\mu}$. Pour l'inversion, l'approche de Bayes est utilisée, incluant la connaissance des inventaires à priori avec la fonction de coût J. La solution optimale de vraisemblance de variable inconnues de flux de CO2 du vecteur d'état s est trouvée en minimisant :

$$\hat{s} = [G^T RG + P]^{-1}[G^T Rc + Pz]$$

La matrice de covariance de $\hat{s}$ est $[G^T RG+P]^{-1}$ et les résultats de chaque fonction de base sont comparés avec les observations moyennées aux valeurs journalières. La solution du modèle final est calculée comme une superposition linéaire des modèles lancés sur les différentes régions et les différentes semaines. Une fois finalisée, les valeurs uniques de $\lambda_r$ et de $\lambda_{ff}$ dans le vecteur d'état sont utilisées dans l'ensemble d'assimilation de Kalman.

• **Ensemble d'assimilation de Kalman (EnKF)**

L'assimilation est effectuée selon la méthode de Peters (2005) et progresse avec deux étapes distinctes par cycle, celle d'analyse et celle de prévisions. La première sert à trouver l'état du système qui est optimalement cohérent avec les observations et la deuxième décrit l'évolution dans le temps de cet état optimal lorsque de nouvelles observations sont disponibles. A partir de ce moment, l'état de prévisions sert de première approximation, ou « d'arrière plan » pour la prochaine étape d'analyse. Ces étapes sont ensuite combinées dans un cycle complet d'assimilation suivi par de nouvelles observations. La liste des symboles utilisés est la suivante :

| Symbole | Nom | Unité | Dimension |
|---|---|---|---|
| x | Vecteur d'état | kg/m2/s | [s] |
| $x_i$ | Déviations du vecteur d'état | kg/m2/s | [s] |
| P | Matrice de covariance d'état | (kg/m2/s)2 | [s x s] |
| X | Matrice de déviation d'état | kg/m2/s | [s x N] |
| y° | Vecteur d'observation | ppm | [m] |
| R | Matrice de covariance d'erreur d'observation | ppm2 | [m x m] |
| $\mathcal{H}$ | Opérateur d'observation (TM5) | kg/m2/s → ppm | [s] → [m] |
| H | Opérateur linéaire d'observation (matrice) | kg/m2/s → ppm | [s x m] |
| $\mathcal{M}$ | Modèle dynamique | kg/m2/s → kg/m2/s | [s] → [s] |
| CO2i(x, y, z, t) | Concentrations de CO2 d'arrière plan | ppm | grille TM5 x N |

Pour la première étape, la solution optimale de vraisemblance de variables inconnues de flux du vecteur d'état x est trouvée comme équilibre de la fonction de coût (J) suivante:

$$J(x) = \overbrace{(y^o - \mathcal{H}(x))^T R^{-1}(y^o - \mathcal{H}(x))}^{Observations} + \overbrace{(x - x^b)^T P^{-1}(x - x^b)}^{Paramètres\ arrière-plan}$$

L'opérateur $\mathcal{H}$ qui convertit l'état du modèle à l'espace d'observations échantillonne le vecteur d'état x et retourne un vecteur $\mathcal{H}(x)$ à comparer aux observations. Le vecteur d'observation y° contient les fractions molaires de CO2 observées moins celles d'arrière plan CO2(x,y,z,t) afin de comptabiliser les variations. Le vecteur d'état x qui minimise J est décrit par:

$$x_t^a = x_t^b + K\left(y_t^o - \mathcal{H}(x_t^b)\right) \quad \text{avec} \quad P_t^a = (1 - KH)P_t^b$$

Où H est la forme linéaire de $\mathcal{H}$, t est le temps et K, la matrice de gain Kalman, définie par:

$$K = (P_t^b H^T)(HP_t^b H^T + R)^{-1}$$

En créant un ensemble de N champs de flux de CO2 qui ont une moyenne $\bar{x}$ et qui couvre la structure de covariance P, les flux optimisés sont trouvés en utilisant une série d'observations de CO2 avec la covariance R en lançant le modèle de transport atmosphérique *H*, N fois vers l'avant et en l'échantillonnant en cohérence avec les observations. Pour créer les statistiques d'ensemble, la méthode étend le nombre de membres d'ensemble du Carbontracker à préférablement N=300. La structure de covariance P décrit l'ampleur de l'incertitude sur chaque paramètre, ainsi que leur corrélation dans l'espace et l'information dans P, d'arrière plan et analysée, est représentée dans les dimensions N d'un ensemble de vecteurs d'états $x_i$ composé d'un état moyen $(\bar{x})$ et de ses déviations $(x'_i)$ tel que $x_i = \bar{x} + x'_i$ où $x_i$ est fonction des paramètres $\lambda$ et $\lambda_{ff}$ à optimiser. Les déviations $x'_i$ sont créées telles que l'ensemble normalisé de déviations définis les colonnes de la matrice X qui est la racine carrée de la matrice de covariance $P = XX^T$ suivant:

$$X = \frac{1}{\sqrt{N-1}}(x_1 - \bar{x}, x_2 - \bar{x}, \dots, x_n - \bar{x})$$

L'ensemble des vecteurs d'état défini la Fonction de Densité de Probabilité Gaussienne (PDF) de x avec la covariance P. Le filtre de racine carré d'ensemble (EnSRF) du Carbontracker selon Whitaker et al. (2002) sert à calculer l'ensemble analysé et les paquets d'observation appartenant à une étape de temps du filtre sont traités un à un. K est calculé selon les approximations suivantes:

$$HPH^T \approx \frac{1}{N-1}\left(\mathcal{H}(x'_1), \mathcal{H}(x'_2), ..., \mathcal{H}(x'_n)\right).\left(\mathcal{H}(x'_1), \mathcal{H}(x'_2), ..., \mathcal{H}(x'_n)\right)^T$$

$$PH^T \approx \frac{1}{N-1}(x'_1, x'_2, ..., x'_n).\left(\mathcal{H}(x'_1), \mathcal{H}(x'_2), ..., \mathcal{H}(x'_n)\right)^T$$

Chaque entrée N définie une colonne de vecteurs d'états d'ensemble ou d'ensemble de valeurs de CO2 modelées. K cartographie linéairement les quantités observées aux éléments de vecteurs d'état comme une moyenne sur l'ensemble des membres. Le vecteur moyen d'état et ses déviations sont mis à jour selon:

$$x_t^a = x_t^b + K\left(y_t^o - H(x_t^b)\right) \quad ; \quad x'^a_i = x'^b_i - \tilde{k}\mathcal{H}(x'^b_i)$$

avec

$$\tilde{k} = K.\alpha = K\left(1 + \sqrt{R/(HP^bH^T + R)}\right)^{-1}$$

La moyenne analysée et l'état d'ensemble d'une observation sert d'état d'arrière-plan de la prochaine. Elles iront également dans le calcul des prochaines observations de la matrice K. Le vecteur des concentrations échantillonnées est mis à jour de façon similaire au vecteur d'état en utilisant l'information moyennée d'ensemble de K. Chaque concentration modelée d'une observation m a assimiler $\mathcal{H}(x_t)_m$ et ses déviations $\mathcal{H}(x'_i)_m$ sont mises à jour selon :

$$\mathcal{H}(x_t^a)_m = \mathcal{H}(x_t^b)_m + H_mK\left(y_t^o - \mathcal{H}(x_t^b)_m\right) ; \mathcal{H}(x'^a_i)_m = \mathcal{H}(x'^b_i)_m - H_m\tilde{k}\mathcal{H}(x'^b_i)$$

Après la mise à jour de l'ensemble de valeurs de CO2 modelées, cet algorithme se poursuit sur la prochaine observation jusqu'à ce que l'ensemble des observations soit traité pour aboutir à l'ensemble final analysé. Dans la deuxième étape, le modèle dynamique décrit l'évolution du vecteur d'état dans le temps. Il apporte une première estimation avant que de nouvelles observations soient introduites et est appliqué à la moyenne des valeurs de $\lambda_r$ et $\lambda_{ff}$ selon:

$$\lambda_{r,t}^b = \frac{\lambda_{r,t-2}^a + \lambda_{r,t-1}^b + \lambda_r^p}{3} \quad et \quad \lambda_{ff,t}^b = \frac{\lambda_{ff,t-2}^a + \lambda_{ff,t-1}^b + \lambda_{ff}^p}{3}$$

Les valeurs de $\lambda_r$ et $\lambda_{ff}$ pour un nouveau pas de temps sont choisies comme une combinaison entre les valeurs optimisées à partir des deux pas de temps précédents et une valeur fixe précédente. Ce lissage sur trois étapes réduit les variations de prévision de $\lambda_r$ et $\lambda_{ff}$ sur le temps. L'inclusion de $\lambda_r^p$ et $\lambda_{ff}^p$ à priori agit comme une régularisation afin que les paramètres reviennent à la valeur prédéterminée sans observations. $\lambda_r^p$ et $\lambda_{ff}^p$ sont initialisés à 1.

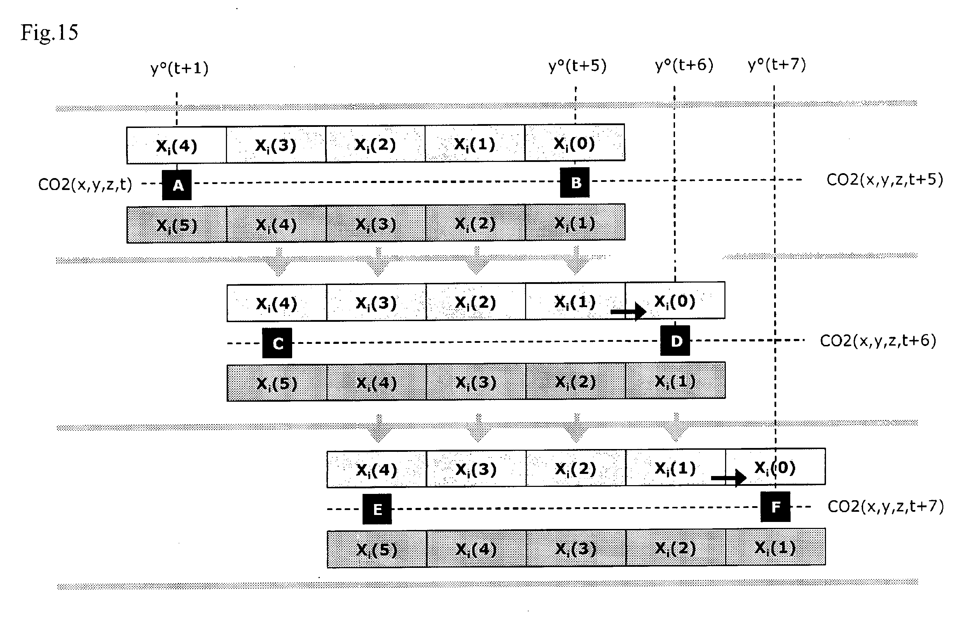

Pour les cycles d'assimilation, le vecteur d'état contient les estimations de flux de plusieurs étapes de temps, chacune correspondant à la moyenne d'une semaine. La figure 15 présente 3 cycles d'assimilation avec 5 semaines de flux composant le vecteur d'état indiquées par $x_i$ (0,..,4), où (0,..,4), défini le nombre de fois ou une semaine particulière de flux a été estimée sur la base des observations des cycles précédents. i se réfère à chaque membre d'ensemble individuel et chaque case ombrée représente un ensemble [i=1, .., N] de flux de surface du globe. Les cases claires montrent les flux d'arrière plan et les foncées, les flux postérieurs et le cycle s'exécute selon:

(1) Le TM5 est lancé en avant à partir des champs de concentration initiaux d'arrière plan, de CO2(x,y,z,t) à CO2(x,y,z,t+5) forcés par les flux d'arrière plan $x_i$ (0,..,4). Il extrait les fractions molaires de CO2 aux temps et lieux des observations afin de construire un ensemble de concentrations modelées sur chaque site.

(2) Les équations de mise à jour du vecteur moyen d'état et de ses déviations sont résolues pour donner un ensemble analysé de flux pour chaque élément du vecteur d'état et chaque semaine.

(3) L'ensemble des flux finaux dans $x_i^a(5)$ ne sera plus estimé dans le prochain cycle. Il sera incorporé dans CO2i(x,y,z,t+1) en lançant le modèle TM5 une semaine en avant en débutant de CO2i(x,y,z,t) forcé avec l'ensemble final des flux $x_i(5)$.

(4) Chaque vecteur d'état analysé devient celui d'arrière-plan pour le prochain cycle (flèches verticales claires). Un nouveau flux moyen d'arrière-plan est créé pour aller dans $\bar{x}(0)$ par propagation avec le modèle $\mathcal{M}$ (flèches horizontales sombres).

(5) Un nouvel ensemble de N déviations de flux $x_i'(0)$ est obtenu de la structure de covariance d'arrière plan pour représenter le PDF Gaussien autour de la nouvelle moyenne de flux $\bar{x}(0)$.

(6) De nouvelles observations y° sont lues et un nouveau cycle commence.

Une fois finalisé sur une année d'observation, les résultats finaux, autrement dit les flux finaux, sont les valeurs optimisées des paramètres $\lambda_r$ et $\lambda_{ff}$ du vecteur d'état avec une cartographie des flux naturels et anthropiques en Kg/semaine de résolution 1°x1°.

## 6. Module de pondération

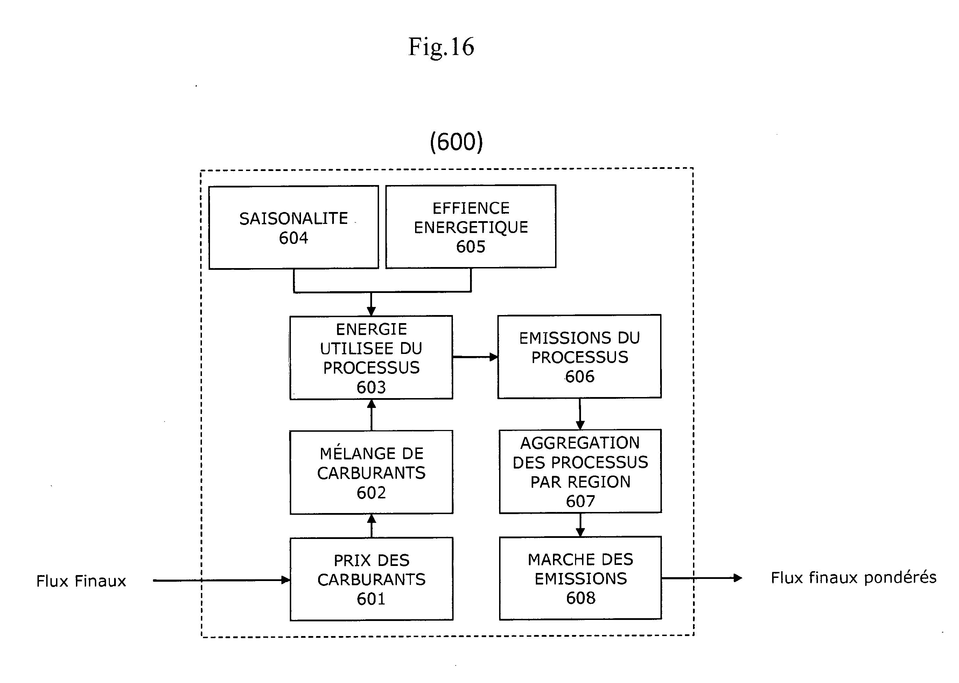

La méthode de mesure selon l'invention améliore ensuite le Carbontracker en ajoutant un nouveau module de pondération, qui apporte la validation que les résultats agrégés de flux anthropiques reproduisent fidèlement ceux de la planète, des continents, des régions continentales, des états et pays et fournit une vérification indépendante de la fiabilité des données scientifiques. Le module (Bloc 600, Fig. 16) est fondé sur la théorie des jeux dans les relations internationales (Luterbacher et al. 2001) et consiste en une modélisation macro-économique des activités de production des secteurs économiques (énergie, procédés industriels, usage de produits, agriculture, utilisation des terres, leurs changements et la forêt, déchets et autres sources) de chaque pays et de son utilisation en énergie fossile.

Dans le principe, la majeure partie de l'énergie mondiale est produite par la combustion d'énergie fossile et lorsque la consommation augmente les émissions de CO2 suivent, et ce, même dans les pays produisant de l'électricité sans carbone ou les énergies fossiles jouent un rôle important dans les activités de production. Pour calculer les émissions, les fonctions de production représentent la valeur ajoutée de sortie de chaque secteur économique par zone et incluent énergie et mélanges de carburants utilisés (charbon, pétrole, gaz naturel, électricité). Le prix relatif de chaque carburant modifie le mélange de combustibles utilisé et suit le principe qu'un carburant plus cher est habituellement substitué par un carburant moins cher (Bloc 601) mais ce qui ne diminue pas nécessairement les émissions si la demande devient plus forte dans une énergie avec une proportion plus importante de carbone. Les niveaux d'émissions sont ainsi définis à partir des prix relatifs des mélanges de combustibles utilisés (Bloc 602) et de la demande énergétique d'un processus de production donné (Bloc 603). Un facteur de saisonnalité module la consommation d'énergie afin d'obtenir des émissions calculées selon la saisonnalité du module d'inventaires ascendants (Bloc 604). Les corrections liées à l'efficience énergétique sont ajoutées car l'utilisation d'énergie diminue proportionnellement aux intrants d'un processus de production dans le temps (Bloc 605). La demande énergétique totale d'un processus de production avec les prix relatifs des carburants définit le mélange de combustibles, l'énergie utilisée et in fine les émissions totales du processus (Bloc 606). L'agrégation de l'ensemble des processus d'un pays et des régions donne les émissions totales de ces zones (Bloc 607).

Une représentation du marché des émissions sur les zones réglementées telles que l'Europe permet de tenir compte des effets de changements technologiques et de la réduction des niveaux d'émission. Ces marchés sont différents des marchés d'échanges classiques car les actifs environnementaux tel que le contenu de carbone de l'atmosphère est le même pour tous. Ils ont des propriétés physiques indépendantes des institutions économiques car ce sont des biens publics qui ne sont pas rivaux en consommation mais produits de manière privée. La méthode effectue cette représentation suivant le modèle de marché des biens publics produits par le privé selon Chichilnisky et al. (2000). L'analyse est fondée sur les liens d'équité et d'efficience de ces marchés et deux facteurs importants sont pris en compte, les quotas d'émission de chaque pays et les prix du carbone. L'offre ou la demande en certificats de carbone est générée en fonction du niveau des quotas, ce qui établit les prix et induit les changements technologiques réduisant le CO2 (Bloc 608). Les résultats du module de pondération, les flux finaux pondérés, sont les totaux d'émissions en TCO2/semaine. Les résultats du module d'inversion et d'assimilation de données sont ensuite corrigés en modulant les facteurs scalaires $\lambda_{ff}$ pour obtenir une justesse économique à chaque sous-échelle géographique jusqu'aux niveaux nationaux, fournissant ainsi des flux finaux pondérés.

**7. Module de géocodage**

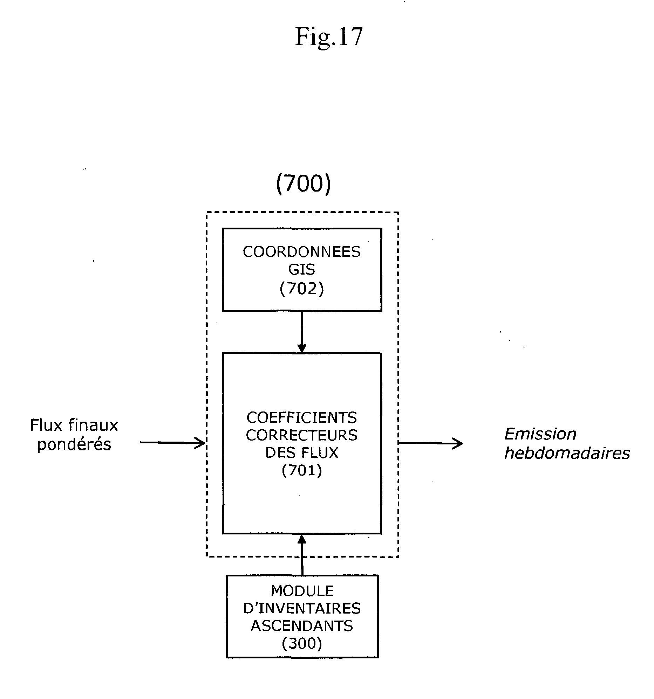

La méthode de mesure selon l'invention améliore enfin la précision des mesures par rapport au Carbontracker en ajoutant également un nouveau module de géocodage (bloc 700, Fig. 17). Une fois validés, les flux de CO2 des mailles 1°x1° (kg/m2/semaine) et résultats de la méthode sont transmis vers le module de géocodage comprenant un système de coordonnées GIS (Geographic Information System)(bloc 702) permettant de géocoder les résultats et notamment, les données du module d'inventaires ascendants provenant d'EDGAR 4.0 (bloc 300) telles que l'emplacement géographique des installations énergétiques et manufacturières, des réseaux routiers, des routes commerciales, des densités de population humaines et animales et l'utilisation des terres agricoles. La répartition géographique des surfaces du globe par pays et régions est également effectuée selon le modèle de décomposition de Li (1990).

Afin de modéliser les flux jusqu'à l'échelle de l'installation, les inventaires d'émissions anthropiques de CO2 déclarés dans le modèle EDGAR 4.0 du module d'inventaires ascendants sont distribués spatialement par maille 0.1°x0.1°. Puis, la méthode peut appliquer des coefficients correcteurs proportionnels (bloc 704) sur chacune des mailles 0.1°x0.1°. Ces coefficients correcteurs $k_{i,j}$ sont calculés proportionnellement au total de chaque maille 1°x1° obtenu à partir des flux finaux pondérés par le module de pondération. Les coefficients $k_{i,j}$, sont déterminés linéairement sur chacune des mailles 0.1°x0.1° en fonction des inventaires de CO2 déclarés par installation et ce calcul de proportionnalité est effectué selon l'équation suivante :

$$F_{ff}(x,y)_{1°x1°} = \sum_{i=1}^{10}\sum_{j=1}^{10} k_{i,j} \times Emission(C)_{AD,an} \times \frac{Indicateur(x_i,y_i)_{AD,c,an}}{\sum Indicateur(x,y)_{AD,c,an}}$$

En d'autres termes, la somme des inventaires corrigés par les coefficients de chaque maille 0.1°x0.1° est égale au total de la maille 1°x1° obtenu à partir des flux finaux pondérés. Au final, la méthode de mesure selon l'invention permet de corriger les résultats par installation en fonction des observations scientifiques et d'obtenir les émissions en Kg/m2/semaine sur des mailles 0.1°x0.1° ($\approx$100km2) avec une précision supérieure à 5% et une réduction des sources d'incertitudes liées aux biais venant de la consommation en énergie, des statistiques de production d'énergie, des facteurs d'émission, des ratios de consommation énergétique et des omissions de sources adjacentes.

En addition, lorsque plusieurs installations sont présentes sur une maille 0.1°x0.1°, la méthode peut calculer les émissions de processus ou de combustion de ces installations en fonction de leurs activités respectives (énergie, procédés industriels...) à partir des données publiées (rapports d'activité, rapports annuels...) tel qu'effectué actuellement dans les méthodes ascendantes. Le calcul est effectué de sorte que le total des émissions de ces installations corresponde au montant total corrigé de la maille 0.1°x0.1° pour la période considérée, ce qui permet de déduire le montant pour chacune des installations.

**II. Autres Gaz à Effet de Serre**

A l'instar des autres méthodes de mesure, dont le Carbontracker, la méthode complète les mesures de CO2 par celles de CH4, N20, NOx, HCFC, HFC, CFC, PFC, SF6, 03 et H2O. Le module d'échange des autres GES inclue une modélisation spécifique des sources et des puits pour chacun d'entre eux avec le calcul du flux suivant le bilan massique. Ces modules d'échanges sont différents du CO2 et sont fonction des sources et des puits modélisés mathématiquement pour chaque GES. Les mesures de ces GES sont issues des observations satellites, aériennes, atmosphériques, d'écosystèmes et marines telles que présentées dans la méthode. La méthode de mesure selon l'invention s'applique sur ces GES aussi bien que sur le CO2 pour l'obtention des inventaires corrigés qui sont calculés sur une base hebdomadaire en Kg/m2 sur des mailles 0.1°x0.1° extrapolées annuellement. Les modélisations de l'évolution des flux effectuées par les modules d'échange pour chacun des autres GES considérés sont présentées ci-dessous.

**• Méthane CH4**

Le méthane (CH4) est essentiellement produit par des processus anaérobiques de sources naturelles incluant les zones humides, les forêts, les termites, les océans et de sources anthropiques par la production et la combustion d'énergies fossiles, la culture du riz, l'élevage, les décharges, la combustion de biomasse, le traitement des déchets et le fumier.

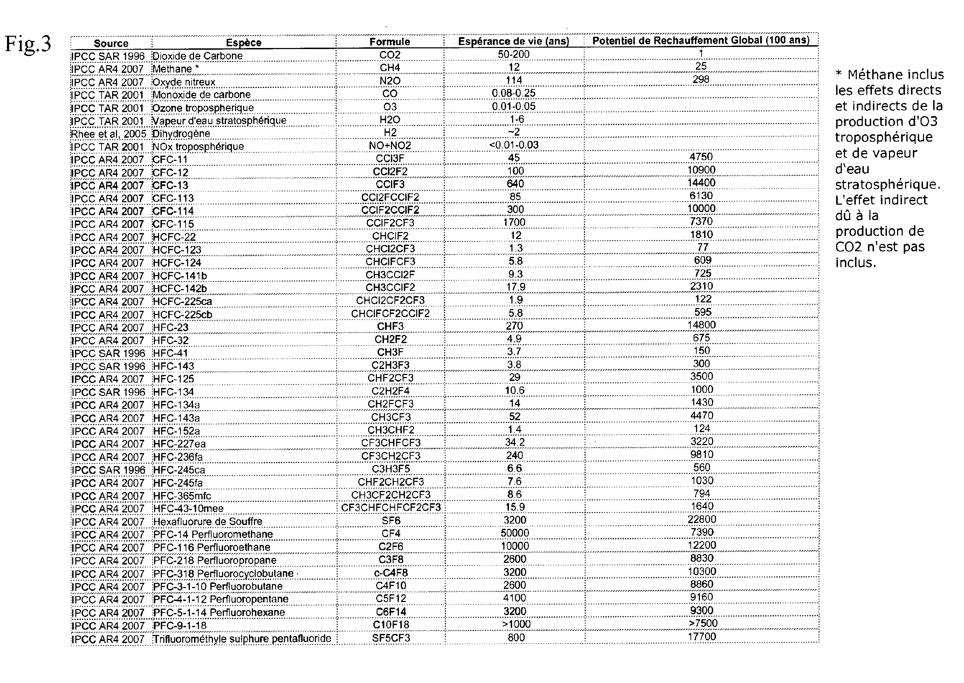

La méthode peut prendre en compte une source additionnelle naturelle considérable de CH4 car d'énormes volumes de CH4 sont stockés sous les océans et dans des couches profondes du pergélisol sous forme d'hydrates où le gaz est enfermé dans des cages cristallines de glace, stables à des pressions élevées et de basses températures. Ces hydrates représentent une ressource énergétique potentielle importante et sont généralement situés dans une couche de roche souterraine ou de sédiments océaniques appelée zone de stabilité d'hydrates (HSZ, Hydrate Stability Zone). Sous la HSZ, le CH4 est trouvé en phase gazeuse mélangé avec de l'eau et des sédiments. Lorsque les températures atmosphériques augmentent, notamment par le réchauffement climatique, la HSZ se déplace vers le haut, laissant à sa place une couche de gaz libérée par déstabilisation des hydrates. La pression dans cette nouvelle couche s'accroît, forçant le gaz à passer à travers la HSZ vers la surface par le biais de veines et de fractures. Si le CH4 s'avère être libéré en quantités massives par ce biais, ce dernier accélèrera le réchauffement en piégeant le rayonnement thermique environ 25 fois plus efficacement que le CO2 (Fig. 3) et deviendra très certainement, bientôt, la préoccupation majeure à laquelle la société devra faire face. La méthode peut utiliser le modèle essentiel de Jain et al. (2009) qui modélise, à l'échelle du grain, comment le CH4 souterrain du fond des océans s'échappe par des évents dans le sol marin à un rythme beaucoup plus rapide qu'attendu. Il utilise un modèle discret d'élement (DEM, Discrete Element Model) qui permet d'investiguer la migration ascendante du CH4 dans sa phase de gaz libre et identifie que les facteurs principaux contrôlant le mode de transport du gaz dans les sédiments sont la taille des grains et le stress effectif de confinement. Combiné avec des données sismiques et des échantillons, le modèle fournit une explication physique de la récente découverte par le NOAA d'un panache de 1'400 mètres venant du plancher océanique de CH4 et d'hydrates au large de la marge continentale de la Californie du Nord (Gardner, 2009). Les conditions sédimentaires dans lesquelles le mécanisme de migration du gaz CH4 domine, sont perméables dans la majeure partie de l'océan, ainsi que dans certaines régions de pergélisol et ce modèle est utilisé dans la méthode pour reproduire le dégagement de CH4 du fond des océans et du pergélisol.

Le puits atmosphérique principal de CH4 est sa destruction troposphérique par les radicaux hydroxyles (OH) et en second lieu, il est principalement supprimé par absorption dans le sol avec oxydation par les bactéries et le transport vers la stratosphère où il réagit avec OH, Cl et O($^1$D). Son espérance de vie $\tau_{CH4}$, est calculée par sa réaction avec les radicaux hydroxyles OH avec $\tau_{OH}$ = 1/(k$_1 \infty$[$OH$]) ou k1 est le coefficient de la réaction, [OH] la concentration et $\tau_{additionel}$ défini son espérance de vie en fonction des autres puits additionnels mineurs selon:

$$1/\tau_{CH4} = 1/\tau_{OH} + 1/\tau_{additionel}$$

Le flux est exprimé selon l'équation suivante :

$$F_{CH4}(t) = F_A(t) + F_{bio}(t) + F_{oce}(t) + F_{per}(t) + F_{feu}(t) - C_{CH4}(t).\mathrm{L(t)}$$

- $F_{CH4}(t)$ est le flux accumulé atmosphérique net
- $F_A(t)$ est le flux net des sources anthropiques
- $F_{bio}(t)$ est le flux net des échanges atmosphère-biosphère
- $F_{oce}(t)$ est le flux net des hydrates de CH4 des océans
- $F_{per}(t)$ est le flux net des hydrates de CH4 du pergélisol
- $F_{feu}(t)$ est le flux net des sources liées aux incendies
- $C_{CH4}(t)$ est la concentration atmosphérique
- L(t) est le taux moyen de perte dans l'atmosphère fonction de l'espérance de vie $1/\tau_{CH4}$.

**• Protoxyde d'azote (N2O)**

Le protoxyde d'azote (N20) est essentiellement produit par des sources anthropiques (engrais azotés, procédés industriels, transports, combustion de biomasse, combustion d'énergie fossile, aliments pour le bétail) et des mécanismes biologiques naturels dans les océans et les sols. Le principal puits de N20 est sa destruction par des réactions photochimiques dans la stratosphère impliquant la production d'oxydes d'azote et en second plan, la dénitrification par des bactéries du sol.

$$F_{N2O}(t) = F_A(t) + F_{bio}(t) + F_{oce}(t) + F_{feu}(t) - C_{N2O}(t).\mathrm{L(t)}$$

- $F_{N2O}(t)$ est le flux accumulé atmosphérique net
- $F_A(t)$ est le flux net des sources anthropiques
- $F_{bio}(t)$ est le flux net des échanges atmosphère-biosphère
- $F_{oce}(t)$ est le flux net des échanges atmosphère-océan
- $F_{feu}(t)$ est le flux net des sources liées aux incendies
- $C_{N2O}(t)$ est la concentration atmosphérique
- L(t) est le taux moyen de perte dans l'atmosphère fonction de l'espérance de vie $1/\tau_{N2O}$.

**• Oxydes d'azote (NOx=NO+NO2)**

Les oxydes d'azote(NOx=NO+NO2) sont essentiellement produits par la combustion d'énergie fossile, la combustion de biomasse, les émissions des sols, la foudre, l'oxydation de l'ammoniaque et le trafic aérien. Le puits principal de NOx est son oxydation dans l'atmosphère et d'importants montants venant des sols sont utilisés par la canopée avant de s'échapper dans la troposphère. Les NOx sont aussi absorbés par déposition sèche sur les sols, dépôts pouvant ensuite conduire à des émissions de N20. Ils agissent comme GES indirects en produisant de l'O3 troposphérique par réactions photochimiques dans l'atmosphère. Ils ont aussi un effet sur l'abondance de radicaux OH car leur destruction donne lieu à une augmentation des OH, réduisant la durée de vie de certains GES tels que le CH4.

$$F_{NOx}(t) = F_A(t) + F_{bio}(t) + F_{feu}(t) - C_{NOx}(t).\mathrm{L}(t)$$

- $F_{NOx}(t)$ est le flux accumulé atmosphérique net
- $F_A(t)$ est le flux net des sources anthropiques
- $F_{bio}(t)$ est le flux net des échanges atmosphère-biosphère
- $F_{feu}(t)$ est le flux net des sources liées aux incendies
- $C_{NOx}(t)$ est la concentration atmosphérique
- L(t) est le taux moyen de perte dans l'atmosphère fonction de l'espérance de vie $1/\tau_{NOx}$.

**• Chlorofluorocarbures CFC**

Les chlorofluorocarbures CFC sont produits de manière anthropique (propulseurs d'aérosols, réfrigérants, nettoyants, climatiseurs, systèmes anti-incendie, procédés de fabrication). Ces molécules monte lentement dans la stratosphère et se dirigent vers les pôles ou ils sont décomposés par des processus photochimiques et ils détruisent l'ozone stratosphérique.

$$F_{CFC}(t) = F_A(t) - C_{CFC}(t).\mathrm{L}(t)$$

- $F_{CFC}(t)$ est le flux accumulé atmosphérique net
- $F_A(t)$ est le flux net des sources anthropiques
- $C_{CFC}(t)$ est la concentration atmosphérique
- L(t) est le taux moyen de perte dans l'atmosphère fonction de l'espérance de vie $1/\tau_{CFC}$.

**• Les hydrofluorocarbures HFC et les hydrochlorofluorocarbures HCFC**

Les hydrofluorocarbures HFC, et hydrochlorofluorocarbures HCFC sont produits de manière anthropique (propulseurs d'aérosols, réfrigérants, nettoyants, climatiseurs, systèmes anti-incendie, procédés de fabrication, insolation, packaging) avec généralement une durée de vie de quelques années et d'importants effets de serre. Ils réagissent avec OH dans la troposphère.

$$F_{HFC}(t) = F_A(t) - C_{HFC}(t).\mathrm{L}(t)$$

$$F_{HCFC}(t) = F_A(t) - C_{HCFC}(t).\mathrm{L}(t)$$

- $F_{HFC}(t)$, $F_{HCFC}(t)$ est le flux accumulé atmosphérique net

- $F_A(t)$ est le flux net des sources anthropiques respectives  ▪  $C_{CFC}(t), C_{HCFC}(t)$ est la concentration atmosphérique
- L(t) est le taux moyen de perte dans l'atmosphère fonction de leur espérance de vie respective $1/\tau_{HFC}$, $1/\tau_{HCFC}$.

### • Les perfluorocarbures PFC

Les perfluorocarbures PFC sont des GES presque entièrement anthropiques (production d'aluminium, production trifluoroacétique ou TFA, fabrication de semi-conducteurs) et sont aussi issus de sources naturelles (fluorites). Un puits important est la destruction légère (photolyse) ou réactions ioniques dans la mésosphère.

$$F_{PFC}(t) = F_A(t) + F_{bio}(t) - C_{PFC}(t).\,\mathrm{L}(t)$$

- $F_{PFC}(t)$ *est* le flux accumulé atmosphérique net
- $F_A(t)$ est le flux net des sources anthropiques
- $F_{bio}(t)$ est le flux net des échanges atmosphère-biosphère
- $C_{PFC}(t)$ est la concentration atmosphérique
- L(t) est le taux moyen de perte dans l'atmosphère fonction de l'espérance de vie *$1/\tau_{PFC}$*.

### • L'hexafluorure de soufre (SF6)

L'hexafluorure de soufre (SF6) est un GES presque entièrement anthropiques (production de magnésium, fabrication de disjoncteurs et d'interrupteurs haute tension, de semi-conducteurs, de solvants, utilisation dans les pneumatiques) et sont aussi issus de sources naturelles (fluorites). Le seul puits connu est la destruction légère (photolyse) ou réactions ioniques dans la mésosphère. Le SF6 est un GES puissant et en raison de sa forte densité par rapport à l'air, il reste sur le bas de l'atmosphère, ceci limitant sa capacité de réchauffement. Un puits important est la destruction légère (photolyse) ou réactions ioniques dans la mésosphère.

$$F_{SF6}(t) = F_A(t) + F_{bio}(t) - C_{SF6}(t).\,\mathrm{L}(t)$$

- $F_{SF6}(t)$ est le flux accumulé atmosphérique net
- $F_A(t)$ est le flux net des sources anthropiques
- $F_{bio}(t)$ est le flux net des échanges atmosphère-biosphère
- $C_{SF6}(t)$ est la concentration atmosphérique
- L(t) est le taux moyen de perte dans l'atmosphère fonction de l'espérance de vie $1/\tau_{SF6}$.

### • L'ozone troposphérique (03)

L'ozone troposphérique (03) est essentiellement issue de la stratosphère et est également produite dans la troposphère par réactions photochimiques ou ses concentrations augmentent en relation avec des niveaux élevés de polluants atmosphériques provenant de sources anthropiques (combustion de biomasse, industrie, transport). Les puits photochimiques dominants de l'ozone troposphérique sont le cycle catalytique de destruction incluant la réaction H02+03 et la destruction photolytique impliquant la réaction de O($^1$D), un produit de la photodissociation de l'ozone. Un autre puits important est l'absorption par les plantes. Il agit aussi comme un GES indirect car sa décomposition par la lumière du soleil produit des radicaux OH.

$$F_{O3}(t) = F_A(t) + F_{bio}(t) - C_{O3}(t).\,\mathrm{L}(t)$$

- $F_{O3}(t)$ est le flux accumulé atmosphérique net
- $F_A(t)$ est le flux net des sources anthropiques
- $F_{bio}(t)$ est le flux net des échanges atmosphère-biosphère
- $C_{O3}(t)$ est la concentration atmosphérique
- L(t) est le taux moyen de perte dans l'atmosphère fonction de l'espérance de vie $1/\tau_{O3}$.

**• La vapeur d'eau (H2O)**

La vapeur d'eau (H2O) est fonction de la température, influencée par le climat. Dans la stratosphère, elle est essentiellement issue de l'oxydation du CH4, de l'augmentation du trafic aérien, des résidus de vapeur d'eau troposphérique et dans la troposphère, elle provient essentiellement de l'évaporation et de la transpiration de la végétation et des océans et est perdue par condensation et précipitation. Elle est également issue de sources anthropiques de l'industrie, des habitations et des transports. La vapeur d'eau, surtout stratosphérique, agit comme un GES puissant car une concentration plus élevée de vapeur d'eau absorbe davantage d'énergie IR thermique rayonnée par la terre et réchauffe l'atmosphère. La vapeur d'eau troposphérique est exprimée par :

$$F_{H2O}(t) = F_A(t) + F_{bio}(t) + F_{oce}(t) - C_{H2O}(t).\mathrm{L}(t)$$

- $F_{H2O}(t)$ est le flux accumulé atmosphérique net
- $F_A(t)$ est le flux net des sources anthropiques
- $F_{bio}(t)$ est le flux net des échanges atmosphère-biosphère
- $F_{oce}(t)$ est le flux net des échanges atmosphère-océan
- $C_{H2O}(t)$ est la concentration atmosphérique
- L(t) est le taux moyen de perte dans l'atmosphère fonction de l'espérance de vie $1/\tau_{H2O}$.

La vapeur d'eau stratosphérique est exprimée par :

$$F_{H2O}(t) = F_A(t) + F_T(t) - C_{H2O}(t).\mathrm{L}(t)$$

- $F_{H2O}(t)$ est le flux accumulé atmosphérique net
- $F_A(t)$ est le flux net des sources anthropiques
- $F_T(t)$ est le flux net issu des résidus de vapeur d'eau troposphérique
- $C_{H2O}(t)$ est la concentration atmosphérique
- L(t) est le taux moyen de perte dans l'atmosphère fonction de l'espérance de vie $1/\tau_{H2O}$.

**• Le monoxyde de carbone (CO)**

Le monoxyde de carbone (CO) provient de l'oxydation chimique de CH4 et d'autres hydrocarbures dans l'atmosphère, des transports, de la combustion d'énergie fossile, de la combustion de biomasse et de sources naturelles de la végétation et des océans. Les puits de CO sont essentiellement sa réaction avec OH, ainsi que sa déposition sur le sol. Il a des effets de GES indirect importants en réagissant avec les radicaux OH dans l'atmosphère et conduit également à la formation d'ozone troposphérique.

$$F_{CO}(t) = F_A(t) + F_{bio}(t) + F_{oce}(t) + F_{feu}(t) - C_{CO}(t).\mathrm{L}(t)$$

- $F_{co}(t)$ est le flux accumulé atmosphérique net
- $F_A(t)$ est le flux net des sources anthropiques
- $F_{bio}(t)$ est le flux net des échanges atmosphère-biosphère
- $F_{oce}(t)$ est le flux net des échanges atmosphère-océan
- $F_{feu}(t)$ est le flux net des sources liées aux incendies
- $C_{co}(t)$ est la concentration atmosphérique
- L(t) est le taux moyen de perte dans l'atmosphère fonction de l'espérance de vie $1/\tau_{co}$.

**• Le dihydrogène (H2)**

Le dihydrogène (H2) est produit par l'oxydation de CH4 et principalement par la combustion d'énergie fossile. L'évolution future de génération d'électricité par hydrogène conduira potentiellement à une forte augmentation de ses émissions. Les puits de H2 sont essentiellement sa suppression par la réaction avec OH et l'absorption par les microorganismes du sol. C'est aussi un GES indirect en réagissant avec les radicaux (OH).

$$F_{H2}(t) = F_A(t) + F_{bio}(t) + F_{feu}(t) - C_{H2}(t).\,L(t)$$

- $F_{H2}(t)$ est le flux accumulé atmosphérique net
- $F_A(t)$ est le flux net des sources anthropiques
- $F_{bio}(t)$ est le flux net des échanges atmosphère-biosphère
- $F_{feu}(t)$ est le flux net des sources liées aux incendies
- $C_{H2}(t)$ est la concentration atmosphérique
- L(t) est le taux moyen de perte dans l'atmosphère fonction de l'espérance de vie $1/\tau_{H2}$.

## III. Système de mesure

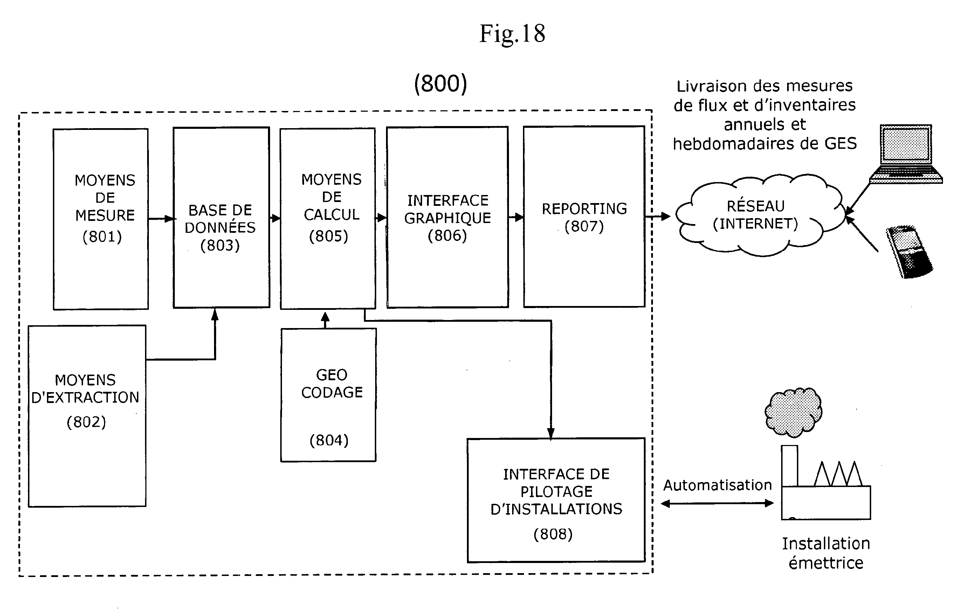

Selon l'invention, la méthode de mesure est mise en oeuvre au moyen d'un système de traitement de données (Fig. 18, bloc 800) comprenant des moyens de mesure des concentrations et des flux des gaz à effet de serre tels que décrits ci-dessus (satellites, avions, stations de mesures atmosphériques, stations de mesures marines, navires et/ou stations de mesures d'écosystèmes, capteurs, capteurs d'écosystèmes, capteurs marins), au moins une base de données centralisée comprenant le module d'observation, des moyens d'extraction, comprenant des moyens de transfert de données automatisés, et assurant également l'interface nécessaire avec des réseaux de communication. Le système de mesure selon l'invention comprend également des moyens de calcul tels qu'une pluralité de serveurs d'information dédiés, des ordinateurs, mainframes, etc. Le système de mesure peut comprendre en outre des moyens de reporting, une ou plusieurs interfaces graphiques et une ou plusieurs interface de pilotage d'installations. Comme il a été dit plus haut, chacun des modules de la méthode peut avantageusement être implémenté sous forme de software, hardware ou une combinaison des deux. De plus, compte tenu de la relative complexité de la méthode de mesure selon l'invention, il est clair que le système de mesure qui l'implémente nécessite une forte puissance de calcul, des capacités de stockage de données importantes ainsi que des moyens de communication fiables et rapides.

Comme il a été dit plus haut, l'invention a donc pour but de fournir des mesures affinées des émissions de GES par aire géographique donnée, et ce en effectuant la méthode de mesure selon l'invention. Ces mesures affinées peuvent ensuite, soit constituer le résultat final destiné à être pris en considération par des utilisateurs individuels ou institutionnels, soit être utilisés directement pour le pilotage technique d'installations industrielles.

Dans le premier cas, une plateforme internet centralisée permet alors de visualiser et d'analyser les émissions de gaz à effet de serre d'une pluralité d'aires géographiques données couvrant la totalité du globe. Les mesures effectuées et les résultats sont transmis en continu, préférablement en temps réel, vers cette plateforme Internet. Les utilisateurs du système peuvent avantageusement mettre en place plusieurs axes d'analyse y compris, mais ne se limitant pas aux types de GES, coordonnées (latitude, longitude), valeurs de flux, temps, incertitude ainsi que les champs de résultats du module d'observation, du module d'échange, du module d'inventaires ascendants, du module de transport, du module d'inversion et d'assimilation, du module de pondération et du module de géocodage pour effectuer des analyses détaillées.

La plateforme est accessible par Internet aux utilisateurs munis d'un ordinateur personnel ou d'un équipement similaire connecté, et ce, de préférence avec un accès sécurisé via une interface graphique. Cette interface permet aux utilisateurs de naviguer sur la carte à travers ces mailles en les redimensionnant tel « GoogleEarth » et de visualiser l'évolution des flux en temps réel. Les droits d'accès aux données sont attribués en fonction des profils des utilisateurs et peuvent être limités géographiquement afin de préserver la confidentialité des inventaires (Bloc 802).

Un reporting peut être effectué en fonction de la zone géographique souhaitée (monde, continents, états, pays, régions et installations), de la période de temps souhaitée (année, mois, semaine) et des types de GES. L'utilisateur sélectionne ensuite les sources ou groupes de sources anthropiques désirés qui sont géocodées sur la carte et le système agrège la somme des flux sur la zone et la période de temps considérée. Des rapports d'inventaires de GES, destiné aux exploitants des installations, peuvent être générés à tout instant. Ils incluent préférablement les inventaires des différents types de GES, le détail des mesures réalisées avec le type d'observation, la précision, la résolution et la continuité ainsi que des statistiques actualisées sur les niveaux historiques, actuels et les tendances. Les résultats sont en TCO2/an, puis TCO2eq/an après avoir appliqué la méthode sur les autres GES et obtenu les TGES/an (Bloc 803).

Le système fournit des observations in situ avec une cartographie quasi temps-réel des sources et des puits de GES aux échelles mondiales, continentales, étatiques, nationales, locales, jusqu'au niveau des installations pour refléter la réalité des niveaux d'émissions.

Une utilisation prévue est de fournir cet accès aux données aux exploitants des installations, qui souhaitent de leur plein gré, ou si elles sont réglementées, mesurer et gérer leurs inventaires de GES. La précision, la continuité et l'uniformité des mesures, leur permet de compléter les processus actuels de surveillance, de reporting et de vérification (MRV) effectués par les vérificateurs privés notamment ceux accréditées par la Commission Européenne sur le marché EU-ETS des émissions. Les exploitants peuvent au moyen du système, accéder, visualiser et obtenir des rapports détaillés sur les sources et les puits locaux de GES relatifs à leurs installations afin de vérifier continuellement l'évolution des niveaux et vérifier l'efficacité des technologies d'atténuation mises en place. Le système permet également à celles réglementées sur les marchés des émissions, de planifier leur budget de GES en fonction de leurs inventaires actuels, de l'évolution des prix des permis de GES échangés sur les marchés et d'évaluer les crédits d'émissions dont elles auront besoin chaque année pour rester en conformité avec les autorités.

Dans l'autre cas, le système de mesure selon l'invention peut également être interfacé directement au sein d'une installation émettrice, notamment avec un système de gestion de production, pour permettre le pilotage de l'installation afin de limiter les émissions de combustion et/ou de processus et d'automatiser leur réduction.

Un logiciel spécifique est installé par installation en fonction de son activité (énergie, procédés industriel, usages de produit...), de ses processus et des GES émis. Le système de mesure selon l'invention permet alors de calibrer et d'optimiser directement le processus de chaque installation en fonction des niveaux et types d'émissions mesurés (ex : pics de pollution). Ceci permet d'obtenir une réduction d'émission automatisée sur chaque installation, de contrôler au fur et à mesure du temps son efficacité et de rester en conformité avec les normes régulatoires et environnementales.

A titre d'exemple, dans l'énergie, les installations sont à la recherche de moyens permettant de préserver la qualité de l'air en opérant des unités plus productives. Dans une centrale à charbon, plus la combustion et la production d'électricité augmente, plus les émissions de $CO_2$, de $NOx$ et de $CO$ sont dégagées. En interfaçant alors le système de mesure selon l'invention avec des logiciels permettant d'automatiser les processus de production d'électricité, on peut alors optimiser le rapport entre réduction d'émissions et efficacité des brûleurs. Des logiciels transmettent des paramètres d'exploitation de différents points de la centrale dans un ordinateur de contrôle principal et d'autres, interfacés au système de mesure selon l'invention, optimisent la combustion en ajustant les flux d'air et de combustible dans les brûleurs, stabilisant ainsi les niveaux de GES. Interfacé avec le système de gestion de production d'une centrale à charbon, le système identifie et quantifie précisément les types de gaz émis ($CO_2$, $CH_4$, $N_20$, $NOx$, HFC, HCFC, CFC, PFC, $SF_6$, $0_3$, $H_20$, $CO$, $H_2$) puis contrôle et optimise au moyen de logiciels ad-hoc les processus de production d'électricité en influant, par exemple, sur le rapport entre réduction d'émissions et efficacité des brûleurs.

L'homme du métier sait adapter les interfaces nécessaires entre le système de mesure selon la présente invention et le/les systèmes de pilotage d'installations de production.

## Revendications

1. Méthode de mesure des émissions hebdomadaires et annuelles d'un gaz à effet de serre générées sur une aire géographique déterminée, **caractérisée en ce qu'**elle comprend les étapes suivantes :

- effectuer des mesures journalières de concentration dudit gaz à effet de serre en une première pluralité de lieux répartis sur la totalité du globe terrestre et enregistrer lesdites mesures journalières de concentration dans un module d'observation,
- effectuer des mesures journalières des flux dudit gaz à effet de serre en une deuxième pluralité de lieux répartis sur la totalité du globe, et enregistrer lesdites mesures journalières des flux dans ledit module d'observation,
- effectuer des mesures de paramètres satellites, de paramètres météorologiques, de paramètres marins et de paramètres d'écosystèmes en une troisième pluralité de lieux répartis sur le globe terrestre et enregistrer les dites mesures de paramètres dans ledit module d'observation,
- extraire, au moyen d'un module d'extraction, des données de prévisions météorologiques d'au moins une source de données,
- effectuer une modélisation de l'évolution des flux dudit gaz sur le globe au moyen d'un module d'échange modélisant les sources et les puits naturels et anthropiques,
- effectuer une modélisation des émissions anthropiques hebdomadaires dudit gaz à effet de serre au moyen d'un module d'inventaires ascendants, ledit module intégrant des données brutes d'émissions pour une pluralité d'installations,
- effectuer, en utilisant ladite modélisation de l'évolution des flux, ladite modélisation des émissions anthropiques hebdomadaires et les dites données de prévisions météorologiques, une modélisation du transport atmosphérique dudit gaz à effet de serre au moyen d'un module de transport,
- calculer les flux finaux dudit gaz à effet de serre, au moyen d'un module d'inversion et d'assimilation de données utilisant ladite modélisation des flux effectuée par le module d'échange, ladite modélisation des émissions anthropiques hebdomadaires effectuée par le module d'inventaires ascendants, ladite modélisation du transport atmosphérique effectuée par le module de transport et lesdites mesures enregistrées dans ledit module d'observation,

- pondérer, au moyen d'un module de pondération, les dits flux finaux de façon à fournir des flux finaux pondérés,
- calculer, en utilisant les dits flux finaux pondérés et ladite modélisation des émissions anthropiques hebdomadaires effectuée par le module d'inventaires ascendants, les émissions hebdomadaires dudit gaz à effet de serre de ladite aire géographique, au moyen d'un module de géocodage comprenant au moins un système d'information géographique,
- extrapoler, à partir des dites émissions hebdomadaires, les émissions annuelles dudit gaz à effet de serre de ladite aire géographique.

2. Méthode de mesure selon la revendication 1, **caractérisée en ce que** la surface de ladite aire géographique est comprise entre 1km2 et 10000km2, en particulier que ladite aire géographique inclue au moins une source anthropique donnée.

3. Méthode de mesure selon l'une des revendications précédentes, **caractérisée en ce que** le dit gaz à effet de serre est choisi parmi le dioxyde de carbone (CO2), le méthane (CH4), le protoxyde d'azote (N20), les oxydes d'azote (NOx), les hydrofluorocarbures (HFC), les hydrochlorofluorocarbures (HCFC), les chlorofluorocarbures (CFC), les perfluorocarbures (PFC), l'hexafluorure de soufre (SF6), l'ozone (03), la vapeur d'eau (H2O), le monoxyde de carbone (CO) et le dihydrogène (H2).

4. Méthode de mesure selon l'une des revendications précédentes, **caractérisée en ce que** les dites mesures journalières de concentration dudit gaz à effet de serre sur le globe, les dites mesures journalières des flux dudit gaz à effet de serre sur le globe, les dites mesures de paramètres satellites, de paramètres météorologiques, de paramètres marins et de paramètres d'écosystèmes sont effectuées au moyen d'une pluralité de satellites, d'avions, de stations de mesures atmosphériques, de stations de mesures marines, de navires et/ou de stations de mesures d'écosystèmes permettant d'effectuer des mesures sur la totalité du globe.

5. Méthode de mesure selon l'une des revendications précédentes, **caractérisée en ce que** ledit module d'échange effectue ladite modélisation de l'évolution des flux dudit gaz à effet de serre, à partir de l'holocène, en utilisant un module solaire modélisant le rayonnement solaire en utilisant les paramètres orbitaux de la géométrie terrestre avec un calcul de l'excentricité de la terre déterminé proportionnellement à l'excentricité de Mars.

6. Méthode de mesure selon l'une des revendications précédentes, **caractérisée en ce que** ledit module d'échange effectue ladite modélisation de l'évolution des flux dudit gaz à effet de serre, à partir de l'holocène, en utilisant un module énergétique modélisant le rayonnement ondes-courtes, en incluant réflectivité, absorptivité et transmissivité de l'atmosphère, l'absorption par les gaz à effet de serre et les nuages, les variations d'albédo planétaire et l'influence du trou de la couche d'ozone, ledit module énergétique modélisant également le rayonnement ondes-longues, en utilisant l'équation de Schwartzschild, la méthode des émissivités et en incluant l'absorption et l'émission par les gaz à effet de serre et les nuages de rayonnements ondes-longues, les flux de chaleur latente, les flux de chaleur sensible, les flux de conduction et la température de surface.

7. Méthode de mesure selon l'une des revendications précédentes, **caractérisée en ce que** ledit module d'échange effectue ladite modélisation de l'évolution des flux dudit gaz à effet de serre, à partir de l'holocène, en utilisant un module océan modélisant l'effet net des échanges atmosphère-océan combiné avec lesdites données de prévisions météorologiques et prenant en compte l'effet de tampon, l'absorption par altération chimique et le dégagement par évaporation.

8. Méthode de mesure selon l'une des revendications précédentes, **caractérisée en ce que** ledit module d'échange effectue la modélisation de l'évolution des flux dudit gaz à effet de serre, à partir de l'holocène, en utilisant un module biosphère modélisant l'effet net des échanges atmosphère-biosphère et incluant les types de plantes de la biosphère, l'indice foliaire, la lumière, l'albédo, la photosynthèse C3 et C4, l'addition du taux de photosynthèse brute limité, la respiration autotrophique, la respiration hétérotrophique et/ou la modification anthropique de la couverture de végétation depuis au moins le dernier millénaire.

9. Méthode de mesure selon la revendication précédente, **caractérisée en ce que** ledit module biosphère utilise un module incendie modélisant les perturbations dues aux incendies sur la base de données extraites de la base de données Global Fire Emission Database (GFEDv2).

10. Méthode de mesure selon l'une des revendications précédentes, **caractérisée en ce que** ledit module d'échange effectue ladite modélisation de l'évolution des flux dudit gaz à effet de serre, à partir de l'holocène, en utilisant un module fossile modélisant les émissions anthropiques fossiles à l'échelle globale.

**11.** Méthode de mesure selon l'une des revendications précédentes, **caractérisée en ce que** ledit module d'inventaires ascendants extrait des inventaires d'émissions de la base de données EDGAR 4.0 en incluant un calcul de la variabilité temporelle des émissions.

**12.** Méthode de mesure selon l'une des revendications précédentes, **caractérisée en ce que** ledit module de transport atmosphérique utilise un modèle de transport combiné avec les dites données de prévisions météorologiques pour calculer le transport des flux dudit gaz à effet de serre sur le globe.

**13.** Méthode de mesure selon l'une des revendications précédentes, **caractérisée en ce que** ledit module d'inversion et d'assimilation de données utilise, pour calculer les dits flux finaux, une inversion de synthèse avec la fonction de Green pour les grandes régions et le filtre d'ensemble de Kalman.

**14.** Méthode de mesure selon l'une des revendications précédentes, **caractérisée en ce que** ledit module de pondération utilise, pour pondérer les dits flux finaux, une analyse des activités de production des pays et des régions du monde accompagnée d'une modélisation des marchés des émissions basée sur le modèle de biens publics produits par le privé.

**15.** Méthode de mesure selon l'une des revendications précédentes, **caractérisée en ce que** ledit module de géocodage utilise des coefficients correcteurs.

**16.** Système de mesure configuré afin de mettre en oeuvre la méthode selon l'une des revendications 1 à 15 comprenant :

- des moyens de mesure (801) des concentrations et des flux des gaz à effet de serre,
- des moyens de mesures (801) de paramètres satellites, météorologiques, marins et d'écosystèmes,
- au moins une base de données centralisée (803) comprenant un module d'observation,
- des moyens d'extraction (802) et de transfert de données automatisés,
- des moyens de calcul (805) comprenant au moins un module d'échange, au moins un module d'inventaires ascendants, au moins un module de transport, au moins un module d'inversion et d'assimilation de données, au moins un module de pondération,
- au moins un module de géocodage (804) comprenant un système d'information géographique permettant de géocoder les résultats fournis par les dits moyens de calcul,
- une plateforme internet centralisée permettant de visualiser et d'analyser les émissions de gaz à effet de serre d'une pluralité d'aires géographiques données.

**17.** Système de mesure selon la revendication précédente, **caractérisé en ce qu'**il comprend des moyens d'interface (808) avec un système de gestion de production d'une installation.

**Patentansprüche**

**1.** Messmethode der wöchentlichen und jährlichen Emissionen eines Treibhausgases, die in einem bestimmten geografischen Gebiet erzeugt werden, **dadurch gekennzeichnet, dass** sie die folgenden Schritte umfasst:

- Durchführen täglicher Konzentrationsmessungen des Treibhausgases an einer ersten Vielzahl von Orten, die über die Gesamtheit des Erdglobus verteilt sind, und Speichern der täglichen Konzentrationsmessungen in einem Beobachtungsmodul,
- Durchführen täglicher Messungen der Ströme des Treibhausgases an einer zweiten Vielzahl von Orten, die über die Gesamtheit des Globus verteilt sind, und Speichern der täglichen Strommessungen in dem Beobachtungsmodul,
- Durchführen von Messungen von Satellitenparametern, meteorologischen Parametern, Meeresparametern und Ökosystemparametern an einer dritten Vielzahl von Orten, die über den Erdglobus verteilt sind, und Speichern der Parametermessungen in dem Beobachtungsmodul,
- Extrahieren mit Hilfe eines Extraktionsmoduls der meteorologischen Vorhersagedaten aus mindestens einer Datenquelle,
- Durchführen einer Modellierung der Entwicklung der Ströme des Gases über den Globus mit Hilfe eines Austauschmoduls, das die natürlichen und anthropogenen Quellen und Senken modelliert,

- Durchführen einer Modellierung der wöchentlichen anthropogenen Emissionen des Treibhausgases mit Hilfe eines Moduls aufsteigender Inventare, wobei das Modul Rohemissionsdaten für eine Vielzahl von Anlagen integriert,

- Durchführen, bei Nutzung der Modellierung der Stromentwicklung, der Modellierung der wöchentlichen anthropogenen Emissionen und der meteorologischen Vorhersagedaten, einer Modellierung des atmosphärischen Transports des Treibhausgases mit Hilfe eines Transportmoduls,

- Berechnen der endgültigen Ströme des Treibhausgases mit Hilfe eines Dateninversions- und Assimilationsmoduls, das die von dem Austauschmodul durchgeführte Strommodellierung, die von dem Modul der aufsteigenden Inventare durchgeführte Modellierung der wöchentlichen anthropogenen Emissionen, die von dem Transportmodul durchgeführte Modellierung des atmosphärischen Transports und die in dem Beobachtungsmodul gespeicherten Messwerte nutzt,

- Wichten mit Hilfe eines Wichtungsmoduls der endgültigen Ströme, um gewichtete endgültige Ströme bereitzustellen,

- Berechnen, bei Nutzung der gewichteten endgültigen Ströme und der von dem Modul aufsteigender Inventare durchgeführten Modellierung der wöchentlichen anthropogenen Emissionen, der wöchentlichen Treibhausgasemissionen des geografischen Gebiets mit Hilfe eines Geocodierungsmoduls, das mindestens ein geografisches Informationssystem umfasst,

- Extrapolieren, ausgehend von den wöchentlichen Emissionen, der jährlichen Treibhausgasemissionen des geografischen Gebiets.

2. Messmethode nach Anspruch 1, **dadurch gekennzeichnet, dass** die Fläche des geografischen Gebiets zwischen 1 km$^2$ und 10.000 km$^2$ inklusive ist, wobei das geografische Gebiet insbesondere eine bestimmte anthropogene Quelle einschließt.

3. Messmethode nach einem der vorangehenden Ansprüche, **dadurch gekennzeichnet, dass** das Treibhausgases aus dem Kohlendioxid (CO2), dem Methan (CH4), dem Stickstoffmonoxid (N20), den Stickoxiden (Ox), den Fluorkohlenwasserstoffen (FKW), den Fluorchlorkohlenwasserstoffen (FCKW), den Chlorfluorkohlenwasserstoffen (CFKW), den Perfluorkohlenwasserstoffen (PFC), dem Schwefelhexafluorid (SF6), dem Ozon (03), dem Wasserdampf (H20), dem Kohlenmonoxid (CO) und dem Dihydrogen (H2) ausgewählt ist.

4. Messmethode nach einem der vorangehenden Ansprüche, **dadurch gekennzeichnet, dass** die täglichen Konzentrationsmessungen des Treibhausgases auf dem Globus, die täglichen Strommessungen des Treibhausgases auf dem Globus, die Messungen von Satellitenparametern, meteorologischen Parametern, Meeresparametern und Ökosystemparametern mit Hilfe einer Vielzahl von Satelliten, Flugzeugen, atmosphärischen Messstationen, Meeresmessstationen, Schiffen und/oder Ökosystemmessstationen durchgeführt werden, die die Durchführung von Messungen auf dem gesamten Globus erlauben.

5. Messmethode nach einem der vorangehenden Ansprüche, **dadurch gekennzeichnet, dass** das Austauschmodul die Modellierung der Stromentwicklung des Treibhausgases ab dem Holozän bei Nutzung eines Solarmoduls durchführt, das die Sonnenstrahlung bei Nutzung der orbitalen Parameter der Erdgeometrie mit einer Berechnung der Exzentrizität der Erde modelliert, die proportional zur Exzentrizität des Mars bestimmt wird.

6. Messmethode nach einem der vorangehenden Ansprüche, **dadurch gekennzeichnet, dass** das Austauschmodul die Modellierung der Stromentwicklung des Treibhausgases ab dem Holozän bei Nutzung eines energetischen Moduls durchführt, das die kurzwellige Strahlung bei Einschluss der Reflektivität, Absorptivität und Transmissivität der Atmosphäre, der Absorption durch die Treibhausgase und die Wolken, der Schwankungen des Planetenalbedos und des Einflusses des Lochs in der Ozonschicht modelliert, wobei das energetische Modul ebenfalls die langwellige Strahlung bei Nutzung der Schwartzschild-Gleichung, der Emissivitätsmethode und unter Einschluss der Absorption und der Emission durch die Treibhausgase und die Wolken von langwelliger Strahlung, der latenten Wärmeströmungen, der fühlbaren Wärmeströmungen, der Konduktionsströme und der Oberflächentemperatur modelliert.

7. Messmethode nach einem der vorangehenden Ansprüche, **dadurch gekennzeichnet, dass** das Austauschmodul die Modellierung der Stromentwicklung des Treibhausgases ab dem Holozän bei Nutzung eines Ozeanmoduls durchführt, das die Nettowirkung des Austauschs zwischen Atmosphäre und Ozean, kombiniert mit den meteorologischen Vorhersagedaten und unter Berücksichtigung des Puffereffekts, der Absorption durch chemische Alteration und der Freigabe durch Verdampfen, modelliert.

8. Messmethode nach einem der vorangehenden Ansprüche, **dadurch gekennzeichnet, dass** das Austauschmodul die Modellierung der Stromentwicklung des Treibhausgases ab dem Holozän bei Nutzung eines Biosphärenmoduls durchführt, das die Nettowirkung des Austauschs zwischen Atmosphäre und Biosphäre unter Einschluss der Pflanzentypen der Biosphäre, des Blattflächenindexes, des Lichts, des Albedos, der C3- und C4-Photosynthese, der Addition des Brutto-Photosynthesengrenzwerts, der heterotrophischen Atmung und/oder der anthropogenen Veränderung der Pflanzendecke seit mindestens dem letzten Jahrtausend modelliert.

9. Messmethode nach vorangehendem Anspruch, **dadurch gekennzeichnet, dass** das Biosphärenmodul ein Brandmodul nutzt, das Störungen aufgrund von Bränden auf der Basis von Daten, die der Global Fire Emission Database-Datenbank (GFEDv2) entnommen wurden, modelliert.

10. Messmethode nach einem der vorangehenden Ansprüche, **dadurch gekennzeichnet, dass** das Austauschmodul die Modellierung der Stromentwicklung des Treibhausgases ab dem Holozän bei Nutzung eines Fossilmoduls durchführt, das die fossilen anthropogenen Emissionen auf globaler Ebene modelliert.

11. Messmethode nach einem der vorangehenden Ansprüche, **dadurch gekennzeichnet, dass** das Modul der aufsteigenden Inventare Emissionsinventare aus der Datenbank EDGAR 4.0 unter Einschluss einer Berechnung der temporären Variabilität der Emissionen extrahiert.

12. Messmethode nach einem der vorangehenden Ansprüche, **dadurch gekennzeichnet, dass** das Modul des atmosphärischen Transports ein Transportmodell, kombiniert mit den meteorologischen Vorhersagedaten zur Berechnung des Transports der Ströme des Treibhausgases über den Globus, nutzt.

13. Messmethode nach einem der vorangehenden Ansprüche, **dadurch gekennzeichnet, dass** das Dateninversions- und Assimilationsmodul für die Berechnung der endgültigen Ströme eine Syntheseinversion mit der Greenfunktion für große Regionen und den Kalman-Gesamtfiter nutzt.

14. Messmethode nach einem der vorangehenden Ansprüche, **dadurch gekennzeichnet, dass** das Wichtungsmoduls zur Wichtung der endgültigen Ströme eine Analyse der Produktionsaktivitäten der Länder und der Regionen der Welt, begleitet von einer Modellierung der Emissionsmärkte auf der Basis des Modells der von Privat produzierten öffentlichen Güter, nutzt.

15. Messmethode nach einem der vorangehenden Ansprüche, **dadurch gekennzeichnet, dass** das Geocodierungsmodul Korrekturkoeffizienten nutzt.

16. Messsystem, das zur Umsetzung der Methode nach einem der Ansprüche 1 bis 15 konfiguriert ist, das umfasst:

- Messmittel (801) der Konzentrationen und Ströme der Treibhausgase,
- Messmittel (801) für Satelliten-, meteorologische, maritime und Ökosystemparameter,
- mindestens eine zentralisierte Datenbank (803), die ein Beobachtungsmodul umfasst,
- automatisierte Datenextraktions- und Transfermittel (802),
- Berechnungsmittel (805), die mindestens ein Austauschmodul, mindestens ein Modul aufsteigender Inventare, mindestens ein Transportmodul, mindestens ein Dateninversions- und Assimilationsmodul, mindestens ein Wichtungsmodul umfassen,
- mindestens ein Geocodierungsmodul (804), das ein geografisches Informationssystem umfasst, das erlaubt, die von den Berechnungsmitteln bereitgestellten Ergebnisse zu geocodieren,
- eine zentralisierte Internetplattform, die erlaubt, die Treibhausgasemissionen einer Vielzahl bestimmter geografischer Gebiete zu visualisieren und zu analysieren.

17. Messsystem nach vorangehendem Anspruch, **dadurch gekennzeichnet, dass** es Schnittstellenmittel (808) mit einem Produktionsverwaltungssystem einer Anlage umfasst.

## Claims

1. Method for measuring weekly and annual emissions of a greenhouse gas generated over a determined geographical area, **characterized in that** it includes the following steps :

- perform daily concentration measurements of said greenhouse gas in a first plurality of locations distributed on the entire terrestrial globe and save said daily concentration measurements in an observation module,
- perform daily flux measurements of said greenhouse gas in a second plurality of locations distributed on the entire globe, and save the said daily flux measurements in said observation module,
- perform measurements of satellite parameters, meteorological parameters, marine parameters and ecosystem parameters in a third plurality of locations distributed on the terrestrial globe and save said parameter measurements in the said observation module,
- extract, by means of an extraction module, the weather forecast data from at least one data source,
- perform a flux evolution modeling of the said gas on the globe by means of an exchange module modeling the natural and anthropogenic sources and sinks,
- perform a weekly anthropogenic emissions modeling of said greenhouse gas by means of an ascending inventories module, said module integrating the raw data of emissions for a plurality of facilities,
- perform, using said flux evolution modeling, said weekly anthropogenic emissions modeling, and said weather forecast data, an atmospheric transport modeling of the said greenhouse gas by means of a transport module,
- calculate the final fluxes of said greenhouse gas, by means of a data inversion and assimilation module using said fluxes modeling performed by the exchange module, said weekly anthropogenic emissions modeling performed by the ascending inventories module, said atmospheric transport modeling performed by the transport module and said measurements saved in said observation module,
- weight, by means of a weighting module, the said final fluxes so as to provide final weighted fluxes,
- calculate, using said final weighted fluxes and said weekly anthropogenic emissions modeling performed by the ascending inventories module, the weekly emissions of said greenhouse gas of said geographical area, by means of a geocoding module comprising at least one geographic information system,
- extrapolate, from said weekly emissions, the annual emissions of said greenhouse gas of the said geographical area.

2. Method for measuring according to claim 1, **characterized in that** the surface of the said geographical area is between 1km2 and 10,000km2, in particular that said geographical area includes at least one given anthropogenic source.

3. Method for measuring according to one of the preceding claims, **characterized in that** said greenhouse gas is selected from the group consisting of: carbon dioxide ($CO_2$), methane ($CH_4$), nitrous oxide ($N_2O$), nitrogen oxides ($NO_x$), hydrofluorocarbons (HFC), hydrochlorofluorocarbons (HCFC), chlorofluorocarbons (CFC), perfluorocarbons (PFC), sulfur hexafluoride ($SF_6$), ozone ($O_3$), water vapor ($H_2O$), carbon monoxide (CO) and dihydrogen ($H_2$).

4. Method for measuring according to one of the preceding claims, **characterized in that** said daily concentration measurements of said greenhouse gas on the globe, said daily flux measurements of the said greenhouse gas on the globe, said measurements of satellite parameters, meteorological parameters, marine parameters and ecosystem parameters are performed by means of a plurality of satellites, aircraft, atmospheric measurement stations, marine measurement stations, ships and/or ecosystem measurement stations enabling one to perform measurements on the entire globe.

5. Method for measuring according to one of the preceding claims, **characterized in that** said exchange module performs said flux evolution modeling of the said greenhouse gas, from the Holocene, using a solar module modeling the solar radiation using the orbital parameters of the terrestrial geometry with a calculation of the eccentricity of the Earth determined proportionally to the eccentricity of Mars.

6. Method for measuring according to one of the preceding claims, **characterized in that** said exchange module performs said flux evolution modeling of said greenhouse gas, from the Holocene, using an energy module modeling the shortwave radiation, by including reflectivity, absorptivity and transmissivity of the atmosphere, absorption by the greenhouse gases and clouds, variations of planetary albedo and influence of the ozone layer hole, the said energy module modeling also the longwave radiation, using the Schwartzschild equation, the method of the emissivities and including the absorption and emission by the greenhouse gases and the clouds of longwave radiation, latent heat fluxes, sensible heat fluxes, conduction fluxes and surface temperature.

7. Method for measuring according to one of the preceding claims, **characterized in that** said exchange module performs said flux evolution modeling of said greenhouse gas, from the Holocene, using an ocean module modeling the net effect of atmosphere-ocean exchanges combined with said weather forecast data and taking into account the buffer effect, the absorption by chemical weathering and the release by evaporation.

8. Method for measuring according to one of the preceding claims, **characterized in that** said exchange module performs the flux evolution modeling of said greenhouse gas, from the Holocene, using a biosphere module modeling the net effect of atmosphere-biosphere exchanges and including the plant types of the biosphere, the leaf area index, the light, the albedo, the C3 and C4 photosynthesis, the addition of the limited gross photosynthetic rate, autotrophic respiration, heterotrophic respiration and/or anthropogenic modification of the land cover since at least the last millennium.

9. Method for measuring according to the preceding claim, **characterized in that** said biosphere module uses a fire module modeling the disturbances due to fires on the basis of the data extracted from the Global Fire Emission Database (GFEDv2).

10. Method for measuring according to one of the preceding claims, **characterized in that** said exchange module performs said flux evolution modeling of said greenhouse gas, from the Holocene, using a fossil module modeling the fossil anthropogenic emissions on a global scale.

11. Method for measuring according to one of the preceding claims, **characterized in that** said ascending inventories module extracts emission inventories from the EDGAR 4.0 database and includes a calculation of the temporal variability of emissions.

12. Method for measuring according to one of the preceding claims, **characterized in that** the said atmospheric transport module uses a transport model combined with said weather forecast data to calculate the flux atmospheric transport of said greenhouse gas on the globe.

13. Method for measuring according to one of the preceding claims, **characterized in that** said data inversion and assimilation module uses, to calculate said final fluxes, a synthesis inversion with the Green function for the large regions and the ensemble Kalman filter.

14. Method for measuring according to one of the preceding claims, **characterized in that** said weighting module uses, to weight the said final fluxes, an analysis of the production activities of countries and regions of the world together with a modeling of emission markets based on the model of privately produced public goods.

15. Method for measuring according to one of the preceding claims, **characterized in that** said geocoding module uses correcting coefficients.

16. Measuring system configured to perform the method according to one of the claims 1 to 15 comprising :

    - means for measuring (801) concentrations and fluxes of greenhouse gases,
    - means for measuring (801) satellite, meteorological, marine and ecosystem parameters,
    - at least one centralized database (803) comprising an observation module,
    - means for extracting (802) and transferring automated data,
    - means for calculating (805) comprising at least one exchange module, at least one ascending inventories module, at least one transport module, at least one data inversion and assimilation module, and at least one weighting module,
    - at least one geocoding module (804) comprising a geographic information system enabling one to geocode the results provided by the said means for calculating,
    - one centralized Internet platform enabling one to view and analyze the greenhouse gas emissions of a plurality of given geographical areas.

17. Measuring system according to the preceding claim, **characterized in that** it comprises means for interfacing (808) with a production management system of a facility.

Fig.1

| MODULE D'OBSERVATION<br>100 | Mesure des concentrations,<br>flux et paramètres |

MODULE D'ÉCHANGE
200

*Modélisation des sources et des puits de CO2*

MODULE D'INVENTAIRES ASCENDANTS
300

*Inventaires anthropiques de flux de CO2*

MODULE DE TRANSPORT
400

*Transport atmosphérique du flux de CO2*

MODULE D'INVERSION ET D'ASSIMILATION DE DONNÉES
500

*Comparaison du CO2 modelé avec celui observé par site, dimensionnement des sources et des puits et livraison des flux finaux*

MODULE DE PONDERATION
600

*Pondération des flux finaux*

MODULE DE GEOCODAGE
700

*Correction des inventaires de flux à partir des flux finaux pondérés*

PLATEFORME INTERNET CENTRALISEE
800

*Livraison des inventaires annuels et hebdomadaires par installation 0.1°x0.1° de GES et pilotage des installations*

EP 2 504 798 B1

# Fig.2

**Approche descendante basée sur les observations puis sur la modélisation de sources et de puits de CO2**

| | | | |
|---|---|---|---|
| PLANÈTE | Modélisation des sources anthropiques module fossile (bloc 200) | Observations (bloc 100), module d'inversion et d'assimilation (bloc 500) et dimensionnement des facteurs scalaires appliqués sur le module d'inventaires ascendants (bloc 300) | Flux finaux pondérés (bloc 600) |
| CONTINENTS | | | |
| RÉGIONS CONTINENTALES | | | |
| ETATS/PAYS | | | |
| RÉGIONS LOCALES | | | Inventaires de flux corrigés 0.1°x0.1° du modèle EDGAR (bloc 700) |
| INSTALLATIONS | | | |

Etape 1                Etape 2                Etape 3

EP 2 504 798 B1

**Fig.3**

| Source | Espèce | Formule | Espérance de vie (ans) | Potentiel de Rechauffement Global (100 ans) |
|---|---|---|---|---|
| IPCC SAR 1996 | Dioxide de Carbone | CO2 | 50-200 | 1 |
| IPCC AR4 2007 | Methane * | CH4 | 12 | 25 |
| IPCC AR4 2007 | Oxyde nitreux | N2O | 114 | 298 |
| IPCC TAR 2001 | Monoxide de carbone | CO | 0.08-0.25 | |
| IPCC TAR 2001 | Ozone tropospherique | O3 | 0.01-0.05 | |
| IPCC TAR 2001 | Vapeur d'eau stratosphérique | H2O | 1-6 | |
| Rhee et al, 2005 | Dihydrogène | H2 | ~2 | |
| IPCC TAR 2001 | NOx troposphérique | NO+NO2 | <0.01-0.03 | |
| IPCC AR4 2007 | CFC-11 | CCl3F | 45 | 4750 |
| IPCC AR4 2007 | CFC-12 | CCl2F2 | 100 | 10900 |
| IPCC AR4 2007 | CFC-13 | CClF3 | 640 | 14400 |
| IPCC AR4 2007 | CFC-113 | CCl2FCClF2 | 85 | 6130 |
| IPCC AR4 2007 | CFC-114 | CClF2CClF2 | 300 | 10000 |
| IPCC AR4 2007 | CFC-115 | CClF2CF3 | 1700 | 7370 |
| IPCC AR4 2007 | HCFC-22 | CHClF2 | 12 | 1810 |
| IPCC AR4 2007 | HCFC-123 | CHCl2CF3 | 1.3 | 77 |
| IPCC AR4 2007 | HCFC-124 | CHClFCF3 | 5.8 | 609 |
| IPCC AR4 2007 | HCFC-141b | CH3CCl2F | 9.3 | 725 |
| IPCC AR4 2007 | HCFC-142b | CH3CClF2 | 17.9 | 2310 |
| IPCC AR4 2007 | HCFC-225ca | CHCl2CF2CF3 | 1.9 | 122 |
| IPCC AR4 2007 | HCFC-225cb | CHClFCF2CClF2 | 5.8 | 595 |
| IPCC AR4 2007 | HFC-23 | CHF3 | 270 | 14800 |
| IPCC AR4 2007 | HFC-32 | CH2F2 | 4.9 | 675 |
| IPCC SAR 1996 | HFC-41 | CH3F | 3.7 | 150 |
| IPCC SAR 1996 | HFC-143 | C2H3F3 | 3.8 | 300 |
| IPCC AR4 2007 | HFC-125 | CHF2CF3 | 29 | 3500 |
| IPCC SAR 1996 | HFC-134 | C2H2F4 | 10.6 | 1000 |
| IPCC AR4 2007 | HFC-134a | CH2FCF3 | 14 | 1430 |
| IPCC AR4 2007 | HFC-143a | CH3CF3 | 52 | 4470 |
| IPCC AR4 2007 | HFC-152a | CH3CHF2 | 1.4 | 124 |
| IPCC AR4 2007 | HFC-227ea | CF3CHFCF3 | 34.2 | 3220 |
| IPCC AR4 2007 | HFC-236fa | CF3CH2CF3 | 240 | 9810 |
| IPCC SAR 1996 | HFC-245ca | C3H3F5 | 6.6 | 560 |
| IPCC AR4 2007 | HFC-245fa | CHF2CH2CF3 | 7.6 | 1030 |
| IPCC AR4 2007 | HFC-365mfc | CH3CF2CH2CF3 | 8.6 | 794 |
| IPCC AR4 2007 | HFC-43-10mee | CF3CHFCHFCF2CF3 | 15.9 | 1640 |
| IPCC AR4 2007 | Hexafluorure de Souffre | SF6 | 3200 | 22800 |
| IPCC AR4 2007 | PFC-14 Perfluoromethane | CF4 | 50000 | 7390 |
| IPCC AR4 2007 | PFC-116 Perfluoroethane | C2F6 | 10000 | 12200 |
| IPCC AR4 2007 | PFC-218 Perfluoropropane | C3F8 | 2600 | 8830 |
| IPCC AR4 2007 | PFC-318 Perfluorocyclobutane | c-C4F8 | 3200 | 10300 |
| IPCC AR4 2007 | PFC-3-1-10 Perfluorobutane | C4F10 | 2600 | 8860 |
| IPCC AR4 2007 | PFC-4-1-12 Perfluoropentane | C5F12 | 4100 | 9160 |
| IPCC AR4 2007 | PFC-5-1-14 Perfluorohexane | C6F14 | 3200 | 9300 |
| IPCC AR4 2007 | PFC-9-1-18 | C10F18 | >1000 | >7500 |
| IPCC AR4 2007 | Trifluorométhyle sulphure pentafluoride | SF5CF3 | 800 | 17700 |

* Méthane inclus les effets directs et indirects de la production d'O3 troposphérique et de vapeur d'eau stratosphérique. L'effet indirect dû à la production de CO2 n'est pas inclus.

EP 2 504 798 B1

Fig.4

Points d'observation de GOSAT (56,000 points en mode standard) (source JAXA)

Fig.5

| Instrument | GOSAT-TANSO-FTS | SCIAMACHY | AIRS | IASI | TES | OMI | OCO |
|---|---|---|---|---|---|---|---|
| Date de lancement | janv.09 | mars.02 | mai.02 | oct.06 | juil.04 | juil.04 | indéterminée |
| Durée de vie | 5 | 7+ | 7+ | 5 | 5+ | 5+ | 2 |
| Satellite | GOSAT | ENVISAT | EOS Aqua | METOP | EOS Aura | EOS Aura | OCO |
| Champ de vue/fauchée | FTS: 10.5/80-790 | 30 × 60/960 | 15/1,650 | 12/2,200 | 5x8/500-2800 | 13x30/2600 | 1.29 × 2.25/5.2 |
| Bande passante (longeur-d'onde µm) | 0.758-0.775, 1.56-1.72, 1.92-2.08, 5.56-14.3 | 0.24-0.44, 0.4-1.0, 1.0-1.7, 1.94-2.04, 2.265-2.38 | 3.74-4.61, 6.20-8.22, 8.80-15.4 | 3.62-5.0, 5.0-8.26, 8.26-15.5 | 3.2-15.4 | 0.27-0.31, 0.30-0.38, 0.35-0.50 | 0.757-0.772, 1.59-1.62, 2.04-2.08 |
| GES | $CO_2$, $CH_4$, $O_3$, $H_2O$ | $O_3$, $N_2O$, $NO_2$, $CH_4$, $CO$, $CO_2$, $H_2O$ | $CO_2$, $CH_4$, $O_3$, $CO$, $H_2O$, | $CO_2$, $CH_4$, $O_3$, $CO$, $H_2O$, $N_2O$ | $O_3$, $NO_2$, $CH_4$, $CO$, $CO_2$, $H_2O$ | $NO_2$, $H_2O$, $O_3$ | $CO_2$ |
| Temps de revisite (jours) | 3 | 35 | 16 | 72 | 16 | 16 | 16 |
| Modes de vues | Nadir, glint, target | Nadir, limb | Nadir | Nadir | Nadir, limb | Nadir, limb | Nadir, glint, target |
| Echantillons/jours | 18,700 | 8,600 | 2,916,000 | 1,296,000 | | | 500,000 |

EP 2 504 798 B1

# Fig.6

(Source ICOS)

EP 2 504 798 B1

Fig.7

Réseau de quantification du flux air-mer de pCO2 sur des périodes saisonnières et interannuelles avec navires de recherche, navires d'opportunité et points d'ammarages.
(Source CDIAC Ocean CO2, PICES PICNIC , IOCCP)

EP 2 504 798 B1

## Fig.8

(Source ICOS)

# Fig.9

EP 2 504 798 B1

# Fig.10

- Equinoxe de printemps (VE)
- Solstice d'été (SS)
- Equinoxe d'automne (AE)
- Solstice d'hiver (WS)
- δ est la déclinaison avec le soleil
- ε est l'angle oblique avec l'axe de la terre
- ω est la longitude du Perihelion relative à l'équinoxe de printemps
- v est la vraie anomalie de la terre à un temps donné
- λ est la vraie longitude de la terre
- O est le centre de l'ellipse avec OA (a) l'axe semi majeur avec (OA=OP) et OB (b) l'axe semi mineur
- r est la distance entre la terre et le soleil

EP 2 504 798 B1

## Fig.11

Relation entre l'angle solaire zénithal $\theta_o$ à la latitude $\Phi$
, l'angle d'inclinaison solaire $\delta$ et l'angle horaire h. P et D sont
respectivement le point d'observation et le point directement
sous le soleil

EP 2 504 798 B1

Fig.12

ONDES COURTES

ONDES LONGUES

EP 2 504 798 B1

Fig.13

| Gg CO₂-eq. per grid cell | | |
|---|---|---|
| 0 | 0.01 | |
| 0.01 | 0.1 | |
| 0.1 | 1 | |
| 1 | 10 | |
| 10 | 25 | |
| 25 | 50 | |
| 50 | 100 | |
| 100 | 200 | |
| 200 | | |

Source: EC-JRC/PBL. EDGAR version 4.0. http://edgar.jrc.ec.europe.eu/.2009

Emissions globales de GES (CO2, CH4, N2O, SF6, PFCs et HFCs) sur l'année 2005 en GgCO2-eq par maille 0.1°x0.1°. (emissions anthropiques excluant aviation et LULUCF).

EP 2 504 798 B1

Fig.14

(100)

| OBSERVATIONS SATELLITES 101 | OBSERVATIONS AERIENNES 102 | OBSERVATIONS ATMOSPHERIQUES 103 | OBSERVATIONS MARINES 104 | OBSERVATIONS ECOSYSTEMES 105 |
|---|---|---|---|---|
| ALGORITHME SPECTRAL 106 | | | INVERSION 107 | EDDY COVARIANCE 108 |

(500)

INVERSION DE SYNTHESE
501

Transport atmosphérique du flux de CO2 →

ENSEMBLE D'ASSIMILATION KALMAN
502

→ Flux Finaux

EP 2 504 798 B1

Fig.15

## Fig.16

(600)

Flux Finaux →

Flux finaux pondérés →

EP 2 504 798 B1

# Fig.17

**(700)**

COORDONNEES
GIS
(702)

COEFFICIENTS
CORRECTEURS
DES FLUX
(701)

Flux finaux
pondérés →

→ *Emission
hebdomadaires*

MODULE
D'INVENTAIRES
ASCENDANTS
(300)

# Fig.18

## (800)

EP 2 504 798 B1

MOYENS DE MESURE (801) → BASE DE DONNÉES (803) → MOYENS DE CALCUL (805) → INTERFACE GRAPHIQUE (806) → REPORTING (807)

MOYENS D'EXTRACTION (802)

GEO CODAGE (804)

INTERFACE DE PILOTAGE D'INSTALLATIONS (808)

Livraison des mesures de flux et d'inventaires annuels et hebdomadaires de GES

RÉSEAU (INTERNET)

Automatisation

Installation émettrice

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **PETERS et al.** An atmospheric perspective on North American carbon dioxide exchange: CarbonTracker. *Proceedings of the National Academy of Sciences of the United States of America,* 2007, vol. 104 (48), 18925-18930